(19) Europäisches Patentamt
European Patent Office
Office européen des brevets

(11) **EP 4 600 637 A1**

(12) **EUROPÄISCHE PATENTANMELDUNG**

(43) Veröffentlichungstag:
**13.08.2025   Patentblatt 2025/33**

(21) Anmeldenummer: **25156589.1**

(22) Anmeldetag: **07.02.2025**

(51) Internationale Patentklassifikation (IPC):
**G01N 23/2206** (2018.01)   **G03F 1/68** (2012.01)
**G03F 1/72** (2012.01)   **G03F 1/74** (2012.01)
**G03F 1/86** (2012.01)   **G06N 20/00** (2019.01)
**H01J 37/28** (2006.01)   G01B 15/04 (2006.01)
**H01L 21/66** (2006.01)

(52) Gemeinsame Patentklassifikation (CPC):
**G01N 23/2206; G03F 1/68; G03F 1/72; G03F 1/74; G03F 1/86; G06N 20/00; H01J 37/28;** G01B 15/04; G01N 2223/401; G01N 2223/418; H01L 22/12; H01L 22/34

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **08.02.2024   DE 102024103589**

(71) Anmelder: **Carl Zeiss SMT GmbH**
**73447 Oberkochen (DE)**

(72) Erfinder:
• **SCHWARZ, Daniel**
**73447 Oberkochen (DE)**
• **EMMRICH, Daniel Alexander**
**64380 Roßdorf (DE)**

(74) Vertreter: **Bardehle Pagenberg Partnerschaft mbB**
**Patentanwälte Rechtsanwälte**
**Prinzregentenplatz 7**
**81675 München (DE)**

(54) **VERFAHREN UND VORRICHTUNG ZUM BESTIMMEN EINES TOPOGRAPHIE-KONTRASTS UND/ODER EINES MATERIALKONTRASTS EINER PROBE**

(57) Vorliegende Erfindung betriff ein Verfahren (2800) und eine Vorrichtung (800, 2800) zum Bestimmen eines Topographiekontrasts (585) und/oder eines Materialkontrasts (550, 560) einer Probe (300, 890, 1000). Das Verfahren (2800) weist die Schritte auf: (a) Bereitstellen (2820) zumindest zweier, zumindest teilweise unter verschiedenen Raumwinkeln bezogen auf die Probe (300, 890, 1000) aufgenommenen Abbildungen (720, 730) der Probe (300, 890, 1000): und (b) Bestimmen (2830) des Topographiekontrasts (585) und/oder des Materialkontrasts (550, 560) der Probe (300, 890, 1000) zumindest teilweise basierend auf den zumindest zwei Abbildungen (720, 730) der Probe (300, 890, 1000).

**Fig. 7**

EP 4 600 637 A1

## Beschreibung

Die vorliegende Anmeldung beansprucht die Priorität der Deutschen Patentanmeldung DE 10 2024 103 589.7 mit dem Titel "Verfahren und Vorrichtung zum Bestimmen eines Topographiekontrasts und/oder eines Materialkontrasts einer Probe", welche am 8. Februar 2024 beim Deutschen Patent- und Markenamt eingereicht wurde. In dieser Hinsicht wird Bezug genommen auf die Anmeldung DE 10 2024 103 589.7, deren Inhalt hiermit in diese Anmeldung aufgenommen wird.

## 1. Technisches Gebiet

Die vorliegende Erfindung betrifft ein Verfahren und eine Vorrichtung zum Bestimmen eines Topographiekontrasts und/oder eines Materialkontrasts einer Abbildung einer Probe.

## 2. Stand der Technik

Als Folge der ständig steigender Integrationsdichte in der Mikroelektronik müssen lithographische Masken immer kleiner werdende Strukturelemente in eine Fotolackschicht eines Wafers abbilden. Um diesen Anforderungen gerecht zu werden, wird deren Belichtungswellenlänge zu immer kleineren Wellenlängen verschoben. Derzeit werden für Belichtungszwecke oft Argonfluorid (ArF) Excimer-Laser eingesetzt, die bei einer Wellenlänge von 193 nm strahlen. Aber auch Lichtquellen, die im extrem ultravioletten (EUV) Wellenlängenbereich (10 nm bis 15 nm) emittieren und entsprechende EUV-Masken, sind im Einsatz. Zur Erhöhung des Auflösungsvermögens von Wafer-Belichtungsprozessen wurden gleichzeitig mehrere Varianten herkömmlicher binärer lithographischer Masken weiterentwickelt. Beispiele hierfür sind Phasenmasken oder phasenschiebende Masken und Masken für Mehrfachbelichtung.

Lithographische Masken, insbesondere fotolithographische Masken, oder Masken im Allgemeinen können aufgrund der immer kleiner werdenden Abmessungen der Strukturelemente nicht immer ohne auf einem Wafer sichtbare oder druckbare Defekte hergestellt werden. Wegen der kostspieligen Herstellung von Fotomasken werden defekte Masken, wann immer möglich, repariert. Dies gilt ebenfalls für mikroskopische Proben bzw. Bauelemente, wie etwa Stempel für die Nanoprägelithographie.

Zwei wichtige Gruppen von Defekten lithographischer oder fotolithographischer Masken sind zum einen dunkle Defekte (dark defects). Dies sind Stellen, an denen Absorber- und/oder phasenschiebendes Material vorhanden ist, die jedoch frei von diesem Material sein sollten. Diese Defekte werden repariert, in dem das überschüssige Material vorzugsweise mit Hilfe eines lokalen Ätzprozesses entfernt wird.

Zum anderen gibt es sogenannte klare Defekte (clear defects). Dies sind Defekte auf der Fotomaske, an denen Absorber- und/oder phasenschiebendes Material fehlt, und die bei optischer Belichtung in einem Wafer-Stepper oder Wafer-Scanner daher z.B. eine größere Lichtdurchlässigkeit aufweisen als eine identische defektfreie Referenzposition. Bei Maskenreparaturprozessen können diese Defekte durch Abscheiden eines Materials mit geeigneten optischen Eigenschaften korrigiert werden. Idealerweise sollten die optischen Eigenschaften des zur Reparatur verwendeten Materials denen des Absorber- bzw. phasenschiebenden Materials entsprechen. Dann kann die Schichtdicke der reparierten Stelle an die Abmessungen der Schicht des umgebenden Absorber- bzw. phasenschiebenden Materials angepasst werden.

Üblicherweise sind beide Defekttypen lokale Defekte, deren Abmessungen typischerweise im Submikrometerbereich liegen. Diese Defekte werden häufig durch Teilchenstrahl-induzierte lokale chemische Prozesse repariert. Zur Reparatur lokaler Defekte einer Probe wird üblicherweise zumindest ein Prozessgas am Bearbeitungsort auf der Probe bereitgesellt, an dem ein fokussierter Teilchenstrahl eine lokale chemische Reaktion induziert. Zum lokalen Entfernen von überschüssigem Material von der Probe umfasst das Prozessgas zumindest ein Ätzgas. Im Falle des Abscheidens von fehlendem Material umfasst das Prozessgas zumindest ein Abscheidegas oder Depositionsgas.

Im Folgenden werden Masken, Stempel für die Nanoprägelithographie, Wafer sowie verschiedene Arten zu reparierender Bauelemente, wie etwa MEMS (Micro-Electro-Mechanical System), NEMS (Nano-Eletro-Mechanical System) oder PICs (Photonic Integrated Circuits) unter dem Ausdruck Probe zusammengefasst.

Im Gegensatz zu mechanischen Prozessen, etwa Sputter-Prozessen, sind chemische Prozesse häufig langsam ablaufende Prozesse. Dies bedeutet, die lokalen chemischen Reparaturprozesse einer Probe können auf einer Zeitskala im ein- oder zweistelligen Minutenbereich ablaufen. Um bei einer Probenreparatur reproduzierbare Ergebnisse zu erzielen, muss der lokale chemische Prozess zum richtigen Zeitpunkt, vorzugsweise automatisch, gestoppt werden. Ein geeigneter Zeitpunkt beim Abscheiden beispielsweise einer phasenschiebenden Schicht auf eine Fotomaske ist der Zeitpunkt, bei dem die reparierte Stelle die gleichen absorbierenden und phasenschiebenen Eigenschaften aufweist, wie ein vergleichbarer nicht defekter Bereich der Maske. Bei einem lokalen Ätzprozess ist der richtige Zeitpunkt dann erreicht, wenn eine zu entfernende Schicht geätzt ist, aber möglichst bevor der Ätzprozess beginnt, die darunterliegende Schicht der Probe zu ätzen. Somit kann eine Abbildung der Probe, die spezifische Informationen über die lokale Materialzusammensetzung der Probe liefert, zum Ermitteln des Stoppzeitpunktes eines Reparaturprozesses, der mittels einer lokalen chemischen Reaktion ausgeführt wird, eingesetzt werden.

Häufig wird zum Abbilden der zu reparierenden Probe ein Teilchenstrahl (z.B. ein Elektronenstrahl) verwendet (z.B. der Gleiche, der zum Initiieren des lokalen chemischen Reparaturprozesses eingesetzt wird). Dieser Teilchenstrahl bewirkt beispielsweise eine lokale Emission von Sekundärelektronen (SE, secondary electrons) und von der Probe rückgestreuter Elektronen (BSE, back-scattered electrons). Abhängig von der Art des zur Detektion der SE und BSE verwendeten Detektors, dessen Anordnung bezüglich der Raumwinkelverteilungen der SE und BSE und ggf. eines vorhandenen Energiefilters nimmt der Detektor verschieden große Anteile von SE und BSE auf.

Typischerweise sind die von einer Probe ausgehenden SE um ein Vielfaches häufiger als die BSE. Wichtiger ist jedoch, dass die SE hauptsächlich für den Topographiekontrast einer Probenabbildung verantwortlich sind, wohingegen die BSE, insbesondere der Teil, der die Probe in einem kleinen Raumwinkelbereich antiparallel zum primären Teilchenstrahl verlässt, zum überwiegenden Teil Informationen über die lokale Materialzusammensetzung der Probe trägt.

Damit sind die im Wesentlichen antiparallel zur Strahlrichtung des primären Teilchenstrahls emittierten BSE besonders zum Bestimmen eines Stoppsignals eines lokalen chemischen Reparaturprozesses geeignet. Ein Detektor, der beispielsweise um den primären Teilchenstrahl, etwa einen Elektronenstrahl, angeordnet ist, detektiert jedoch dennoch immer gleichzeitig SE und BSE. Eine vollständige Trennung der SE und BSE lässt diese Detektoranordnung im Allgemeinen nicht zu. Vielmehr empfängt ein solcher ringförmiger Detektor typischerweise ein BSE-Signal, das von einem SE-Signalhintergrund überlagert ist. Durch Einführen eines elektrischen Gegenfeldes können SE und BSE in einer Probenabbildung zumindest zum Teil separiert werden. Trotzdem ist die Abbildung einer Probe mit einem Detektor mit integriertem Energiefilter als Stoppsignal für einen lokalen Partikelstrahl-induzierten Reparaturprozess nur bedingt geeignet, weist diese doch immer noch Anteile von Topographiekontrast und Materialkontrast auf. Zudem ist der Einbau eines Detektors mit integriertem Energiefilter häufig mit größeren technischen Herausforderungen verbunden.

Der vorliegenden Erfindung liegt daher das Problem zu Grunde, ein Verfahren und eine Vorrichtung zum Bestimmen eines Topographiekontrasts und/oder eines Materialkontrasts einer Abbildung einer Probe anzugeben.

### 3. Zusammenfassung der Erfindung

Gemäß einem Ausführungsbeispiel wird dieses Problem durch ein Verfahren nach Anspruch 1 gelöst. In einer Ausführungsform weist das Verfahren zum Bestimmen eines Topographiekontrasts und/oder eines Materialkontrasts einer Probe auf: (a) Bereitstellen zumindest zweier, zumindest teilweise unter verschiedenen Raumwinkeln bezogen auf die Probe aufgenommenen Abbildungen der Probe: und (b) Bestimmen des Topographiekontrasts und/oder des Materialkontrasts der Probe zumindest teilweise basierend auf den zumindest zwei Abbildungen der Probe.

Die Erfinder haben erkannt, dass die von einer Probe emittierten sekundären Partikel oder Teilchen (rückgestreute oder aus der Probe herausgelöste Partikel oder Teilchen) eine inhomogene Raumwinkelverteilung aufweisen. Dadurch enthalten zwei unter verschiedenen Raumwinkeln aufgenommene Probenabbildungen, die auf der Detektion sekundärer Partikel, insbesondere sekundärer Elektronen (SE) und rückgestreuter Elektronen (BSE) beruhen, a priori unterschiedliche Informationen über deren Topographiekontrast und Materialkontrast. Zudem ändert sich die Energieverteilung der sekundären Partikel in Abhängigkeit des Raumwinkels, in den diese emittiert werden. Durch Verknüpfen der in den zumindest zwei Abbildungen enthaltenen Informationen können die in den einzelnen Abbildungen enthaltenen Topographiekontrast- und Materialkontrastanteile ermittelt werden. Ein einziger Detektor, der sekundäre Partikel (beispielsweise SE und BSE) aus den gleichen Raumwinkelbereichen aufnimmt, wie zwei oder mehr Detektoren mittelt hingegen sowohl über die Raumwinkel- als auch die Energieverteilung der sekundären zum Erzeugen der Abbildungen verwendeten Partikel. Dadurch gehen die in diesen Verteilungen der sekundären Partikel bzw. Teilchen vorhandenen Informationen verloren.

Es ist ein Vorteil des erfindungsgemäßen Verfahrens, dass keiner der zum Aufnehmen der Abbildungen eingesetzten Detektoren einen Energiefilter für die sekundären Teilchen benötigt. Dies verringert zum einen den Bauraum, der für den bzw. die Detektoren gebraucht wird. Zum anderen kann ein nicht vorhandenes Energiefilter, etwa in Form eines Abschirmgitters, einen primären geladenen Teilchenstrahl, etwa einen Elektronenstrahl, nicht stören. Falls beispielsweise ein ringförmiger, um den primären geladenen Teilchenstrahl angeordneter Detektor ein Abschirmgitter als Energiefilter aufweist, kann die Spannung des Abschirmgitters den primären Teilchenstrahl auf der Probe beeinflussen, etwa die Landeenergie der primären Teilchen, d.h. der Teilchen oder Partikel des primären Teilchenstrahls, auf der Probe.

Ferner treten an Kanten einer Probe, etwa den Kanten absorbierender Pattern-Elemente von Fotomasken, in einer energiegefilterten Abbildung bzw. in einem energiegefilterten Bild Topographieeffekte durch Abschirmungseffekte auf. Somit kann im Bereich von Kanten einer Probe kein reines Materialkontrastbild gemessen werden. Durch Verzicht auf einen Energiefilter für sekundäre Partikel umgeht ein erfindungsgemäßes Verfahren diese Einschränkung.

Beim gleichzeitigen Aufnehmen der zumindest zwei Abbildungen mit zwei Detektoren ist es günstig, wenn Raumwinkelbereiche der beiden Detektoren möglichst wenig überlappen, am besten überhaupt nicht, um die Redundanz der Informationen, die in den beiden Abbildungen vorhanden ist, zu minimieren. Dies gilt in gleicher Weise, wenn die beiden Abbildungen nacheinander mit einem einzigen, verschieden positionierten Detektor aufgenommen werden oder ein einzelner Detektor nacheinander an verschiedenen Stellen abgeblendet wird.

Das Bereitstellen von zumindest zwei unter verschiedenen Raumwinkeln bezogen auf die Probe aufgenommenen Abbildungen kann zumindest ein Element der Gruppe umfassen: Laden von zumindest zwei unter verschiedenen Raumwinkeln aufgenommenen Abbildungen aus einem Speicher, Übertragen von zumindest zwei unter verschiedenen Raumwinkeln aufgenommenen Abbildungen über eine Datenverbindung, oder Aufnehmen zumindest zweier Abbildungen einer Probe unter verschiedenen Raumwinkeln.

Abbildungen oder Bilder einer Probe können durch Rastern eines die Probe anregenden fokussierten primären Elektronenstrahls über die Probe bzw. einen Teilbereich der Probe und gleichzeitiges Detektieren von der Probe ausgehenden sekundären (SE) und rückgestreuten Elektronen (BSE) aufgenommen werden.

Der fokussierte primäre Teilchenstrahl kann einen geladenen Teilchenstrahl umfassen. Der geladene Teilchenstrahl kann einen Elektronenstrahl und/oder einen Ionenstrahl umfassen. Günstig ist ein primärer Teilchenstrahl in Form eines Elektronenstrahls.

Das Detektieren der sekundären Teilchen kann mit einem oder mehreren Detektoren erfolgen. Der zumindest eine Detektor kann verschiedene Detektionsprinzipien verwenden, wie etwa einen Szintillationszähler, z.B. in Form eines Szintillator-Photomultiplier-Detektors, einen Halbleiter-Detektor, z.B. eine Diodenstruktur mit einem oder mehreren Segmenten oder einen Yttrium-Aluminium-Granat- (YAG) Detektor.

Der zumindest eine Detektor kann verschiedene Geometrien aufweisen. Ein in der Nähe der Probe angeordneter Detektor, beispielsweise ein Everhart-Thornley-Detektor, deckt einen Raumwinkelbereich ab, der sowohl hinsichtlich des Polarwinkels (der Winkel bezogen auf die Strahlachse des primären Teilchenstrahls) als auch des Azimuthwinkels (bezogen auf eine Gerade in der Probenebene) asymmetrisch ist. Sogenannte in-lens-Detektoren, beispielsweise ein Robinson-Detektor, werden rotationssymmetrisch um die Strahlachse des primären Teilchenstrahls angeordnet und weisen eine Öffnung zum Durchtritt des primären Teilchenstrahls auf. Aufgrund ihrer Geometrie und Anordnung weisen in-lens-Detektoren somit keine Polarwinkelabhängigkeit auf. Bei der Anordnung von in-lens-Detektoren in der Nähe der Probe nehmen diese sekundären Teilchen der Probe aus einem großen Raumwinkelbereich auf. Dadurch wird in vorteilhafter Weise, das Signal-Rausch-Verhältnis des Detektorsignals verbessert. Andererseits mittelt ein in-lens-Detektor über große Bereiche der Energie- und Raumwinkelverteilungen der sekundären Teilchen.

Die Anzahl der pro Teilchen des Primärstrahls, bzw. Elektronenstrahls, die Probe verlassenden sekundären Teilchen, d.h. die Ausbeute, hängt von der kinetischen Energie oder der Landeenergie der primären Teilchen, bzw. Elektronen, ab. Häufig ist die Ausbeute der sekundären Teilchen für sehr kleine Landeenergien < 1, in einem mittleren Energiebereich > 1 und die Ausbeute fällt für große Landeenergien wieder in den Bereich < 1 ab.

Als SE-Anteil der sekundären Teilchen werden von der Probe ausgehende Elektronen mit einer kinetischen Energie bis etwa 50 eV bezeichnet, der Großteil der SE weist kinetische Energien im Bereich einiger eV (Elektronenvolt) auf. Falls der primäre Teilchenstrahl einen Elektronenstrahl umfasst, sind die von einer Probe rückgestreuten Elektronen (BSE) energiereicher als die SE und haben typischerweise kinetische Energien im Bereich einiger keV (Kilo-Elektronenvolt). Die Intensität eines BSE-Signals ist in erster Linie von der Kernladungszahl, bzw. von der mittleren Kernladungszahl abhängig, falls die Probe eine Materialzusammensetzung in Form einer Verbindung aufweist. Die Intensität eines BSE-Signals steigt mit der (mittleren) Kernladungszahl an. Dies bedeutet, schwere Elemente führen zu einer starken Rückstreuung und durch das starke BSE-Signal erscheinen Bereiche der Probe mit schweren Elementen hell. Die Abhängigkeit der Stärke eines BSE-Signals von der lokalen Materialzusammensetzung kann daher in der vorliegenden Anmeldung zum Detektieren einer Änderung der lokalen Materialzusammensetzung einer Probe in z-Richtung, d.h. senkrecht zur Probenoberfläche, ausgenutzt werden.

Das Bestimmen des Topographiekontrasts und/oder des Materialkontrasts kann ein Anwenden eines Entkopplungsmodells auf die zumindest zwei Abbildungen umfassen. Insbesondere kann das Bestimmen das Anwenden eines parametrisierten bzw. trainierten Entkopplungsmodells auf die zumindest zwei Abbildungen umfassen. Ein Entkopplungsmodell umfasst ein mathematisches Modell, das auf zumindest zwei unter verschiedenen Raumwinkeln aufgenommenen Abbildungen angewendet wird, um deren Topographiekontrast und/oder Materialkontrast zu bestimmen.

Zum Kontrollieren, beispielsweise eines Maskenreparaturprozesses, ist das Vorhandensein eines Signals wichtig, das die lokale Materialzusammensetzung der Maske angibt. Dieses Signal sollte möglichst unabhängig von der lokalen Topographie der Maske, allgemein der Probe, sein und gleichzeitig möglichst sensitiv auf eine lokale Änderung der Materialzusammensetzung der Maske ansprechen. Eine lokale Topographie berücksichtigt die Topographie der Maske in deren unmittelbaren Umgebung. Beispielsweise wird das Bestimmen eines Materialkontrasts am Fuße einer Kante durch Abschattungseffekte der Kante erschwert.

Für eine Probe, beispielsweise in Form einer binären Fotomaske, muss lediglich zwischen dem Material der absorbierenden Pattern-Elemente und dem Material des Maskensubstrats unterschieden werden. Hierfür werden zumindest zwei, vorzugsweise mehrere Detektorsignale von einem Punkt der Probe bzw. Maske aufgenommen. Die zumindest zwei Signale eines Punktes, aufgenommen unter verschiedenen Raumwinkeln, werden zu einer Funktion verarbeitet, um ein Materialsignal zu erzeugen. In einfachster Form kann eine Linearkombination der verschiedenen Detektorsignale von einem Punkt der Maske bestimmt werden. Es ist aber auch möglich, beliebige andere Funktionen der Detektorsignale zu ermitteln. Die Koeffizienten der Funktion können beispielsweise so kalibriert werden, dass die Funktion den Wert 0 für die Materialzusammensetzung der Pattern-Elemente und den Wert 1 für die Materialzusammensetzung des Maskensubstrats annimmt oder umgekehrt. Dadurch wird es möglich, eine Abbildung der Probe zu ermitteln, die im Wesentlichen ausschließlich Information über deren lokale Materialzusammensetzung (engl.: compositional contrast) aufweist.

Diese Abbildung kann zum automatischen Stoppen eines Partikelstrahl-induzierten lokalen chemischen Reparaturprozesses einer Probe eingesetzt werden. Mit Hilfe eines erfindungsgemäßen Verfahrens können Probendefekte reproduzierbar repariert werden. Gleichzeitig kann eine Probenbeschädigung durch unerwünschtes Abscheiden von Material auf die Probe oder ungewolltes Entfernen von Material von der Probe während eines Reparaturprozesses zuverlässig vermieden werden.

Die zumindest zwei Abbildungen können Raumwinkelbereiche der Probe erfassen, deren Winkel klein sind bezogen auf den primären Teilchenstrahl (die Abbildungen können z.B. von Detektoren stammen, die um den primären Teilchen- oder Elektronenstrahl herum angeordnet sein können, sogenannte in-lens-Detektoren). Falls beispielsweise die detektierten, sekundären Partikel sekundäre (SE) und rückgestreute Elektronen (BSE) umfassen, wird durch diese Detektoranordnung ein großer Anteil hochenergetischer BSE erfasst, die zum ganz überwiegenden Teil Informationen über die lokale Materialzusammensetzung der Probe liefern.

Selbstredend kann das erfindungsgemäße Verfahren auf Konfigurationen angewendet werden, die drei oder mehr Detektoren aufweisen, die drei oder mehr Abbildungen unter teilweise verschiedenen Raumwinkeln aufnehmen. Durch den Einsatz von zwei oder mehre Detektoren, die sekundäre Partikel bzw. Teilchen, bzw. SE und BSE, aus verschiedenen Raumwinkelbereichen empfangen, kann die Verteilung der sekundären Partikel aufgelöst und deren Inhomogenität kann ermittelt werden, und zum Bestimmen des Topographiekontrasts und/oder des Materialkontrasts eingesetzt werden. Ein einziger Detektor, der sekundäre Partikel aus den verschiedenen Raumwinkelbereichen der zwei oder mehr Detektoren empfängt, integriert oder mittelt hingegen über die inhomogene Raumwinkelverteilung der sekundären Partikel. Deshalb wächst die Präzision der Bestimmung der lokalen Materialzusammensetzung der Probe mit der Anzahl der unter verschiedenen Raumwinkeln aufgenommenen Abbildungen, die einem erfindungsgemäßen Verfahren als Eingabedaten zur Verfügung stehen.

Falls eine ebene Probenoberfläche abgebildet wird und der fokussierte Teilchen- bzw. Elektronenstrahl senkrecht auf die Probenoberfläche auftritt, umfassen verschiedene Raumwinkel verschiedene Winkel zum primären fokussierten Teilchen- bzw. Elektronenstrahl bzw. verschiedene Polarwinkel.

Bei einer Konfiguration mit zwei in-lens-Detektoren, wobei der erste Detektor näher an der Probe platziert ist als der zweite Detektor, kann eine erste von dem ersten Detektor aufgenommene Abbildung der zumindest zwei Abbildungen für SE einen Raumwinkel im Bereich von 0,6 sr bis 1,0 sr, bevorzugt 0,26 sr bis 1,2 sr, und am meisten bevorzugt 0,15 sr bis 0,4 sr und für BSE einen Raumwinkel im Bereich von 0,3 sr bis 1,3 sr, bevorzugt 0,5 sr bis 1,6 sr, und am meisten bevorzugt 0,8 sr bis 2,0 sr umfassen. Eine zweite vom zweiten Detektor aufgenommen Abbildung der zumindest zwei Abbildungen kann für SE einen Raumwinkel im Bereich von 0,2 sr bis 0,6 sr, bevorzugt 0,15 bis 1,3 sr, und am meisten bevorzugt 0,05 sr bis 0,15 sr und für BSE einen Raumwinkel im Bereich von 0,15 sr bis 0,6 sr, bevorzugt 0,1 sr bis 0,26 sr, und am meisten bevorzugt 0,05 sr bis 0,15 sr umfassen. Die Abkürzung "sr" steht für Steradiant.

Im Beispiel einer in-lens-Anordnung eines oder mehrerer Detektoren in einer Säule eines Rasterelektronenmikroskops (SEM) hängt der Raumwinkelbereich, aus dem SE und BSE auf den bzw. die Detektoren auftreffen, von deren kinetischer Energie ab. Die sekundären Partikel werden von der Objektivlinse des SEM in deren hinteren Brennebene fokussiert. Je geringer die kinetische Energie der sekundären Partikel, d.h. SE und BSE, desto näher befindet sich dieser Brennpunkt an der Probe. Bei einer bestmöglichen Anordnung ist der erste Detektor in der Brennebene der BSE positioniert, so dass ein möglichst großer Anteil der BSE auf den zweiten Detektor gelangen kann und der erste Detektor gleichzeitig einen größtmöglichen Teil der SE vom zweiten Detektor fernhält. Die primäre Aufgabe der Objektivlinse ist die Fokussierung des primären geladenen Teilchenstrahls auf die Probe, d.h. die vorder- und rückseitige Brennebene der Objektivlinse hängen von den gewählten Einstellungen des primären Elektronenstrahls bzw. vom Abstand der Probe von der Objektivlinse ab.

Die zumindest zwei Abbildungen können von zwei Detektoren, die aus zwei teilweise verschiedenen Richtungen auf die Probe blicken, gleichzeitig aufgenommen werden. Dabei kann einer der Detektoren den Raumwinkelbereich, den der zweite Detektor sieht, teilweise verdecken oder abschatten.

Es ist aber auch möglich, mit einem Detektor die beiden Abbildungen nacheinander aufzunehmen. Dabei ist der Detektor zwischen der ersten und der zweiten Abbildung oder Bildaufnahme von der ersten in die zweite Abbildungsposition zu bringen. Abschattungseffekte der simultanen Abbildung mit zwei Detektoren können bei einer sukzessiven Bildaufnahme mit einem Detektor beim Bestimmen der Topographiekontrast- und Materialkontrastanteile der zumindest zwei Abbildungen ebenfalls berücksichtigt werden. Ferner ist es möglich, einen ersten Teil eines einzelnen Detektors während einer ersten Abbildung und einen zweiten Teil des einzelnen Detektors während einer zweiten Abbildung abzudecken. Dabei ist es günstig, wenn der einzelne Detektor eine möglichst große Detektionsfläche aufweist.

Ein Detektor sammelt sekundäre Partikel, die ein primärer Partikel- bzw. Elektronenstrahl von einem Punkt der Probe auslöst, und die die Eingangsöffnung des Detektors erreichen. Durch ein zweidimensionales Rastern des primären Elektronenstrahls über die Probe wird simultan auf einem Monitor eine zweidimensionale Intensitätsverteilung der sekundären Partikel, d.h. eine Abbildung der Probe, erzeugt.

Im Folgenden wird eine Probe durch Abtasten mit einem primären fokussierten Partikelstrahl abgebildet. Das Abtasten der Probe mit dem primären Partikelstrahl, vorzugsweise einem Elektronenstrahl, bewirkt, dass an der Stelle des Auftreffens der primären Partikel (Elektronen) sekundäre Partikel (Elektronen) die Probe verlassen, die von einem Detektor oder mehreren Detektoren aufgenommen werden, der bzw. diese erzeugen dadurch ein zweidimensionales Intensitätsmuster der Probe. Die Anzahl der sekundären von der Probe ausgelösten Partikel pro auftreffendes primäres Partikel hängt neben dem Material der Probe auch von deren Oberflächentopographie ab. Von lokalen Probenerhöhungen, wie etwa entlang von Kanten von Erhebungen, beispielsweise entlang der Kanten von Pattern-Elementen, ist der lokale Winkelbereich der Probenoberfläche größer 180° oder größer $\pi$, in den sekundäre Partikel emittiert werden können. Deshalb erzeugen lokale Erhebungen und/oder Kanten mehr sekundäre Partikel als eine ebene Probenfläche. Dadurch erscheinen diese heller im Vergleich zu einer ebenen Probenoberfläche. Im Bereich lokaler Vertiefungen ist hingegen der Winkelbereich, in den die Probe sekundäre Partikel emittieren kann, kleiner als 180° und diese erscheinen in einer Abbildung der Probe deshalb dunkler, wiederum im Vergleich mit ebenen Flächenbereichen der Probe.

Bei einer ebenen Probenfläche und vorgegebener Landeenergie der primären Partikel hängt die Anzahl und die Winkelverteilung der sekundären Partikel im Wesentlichen von dem Material oder der Materialzusammensetzung der Probe ab. Falls die sekundären Partikel Elektronen sind, skaliert für Landeenergien > 600 eV die Anzahl der erzeugten rückgestreuten Elektronen (BSE) in etwa proportional mit der Massenzahl des Probenmaterials. Dies bedeutet, die lokale Intensität der Probenabbildung ist bei vorgegebenem Partikelstrom umso größer, je größer die Massenzahl des lokalen Probenmaterials ist.

Typischerweise überlagern sich die Beiträge, die von der lokalen Materialzusammensetzung und der lokalen Oberflächenkontur bzw. Oberflächentopographie herrühren, in einer Intensitätsverteilung mit entsprechenden Beiträgen. Es ist eine wesentliche Zielsetzung der vorliegenden Anmeldung diese Beiträge zu separieren.

Wie unten ausgeführt wird, weist eine vorgegebene Probenabbildung in der Regel sowohl einen ihr eigenen Topographiekontrastanteil als auch einen Materialkontrastanteil auf. In einem Koordinatensystem, das durch einen reinen Topographiekontrastanteil (T-Achse) und einen reinen Materialkontrastanteil (M-Achse) aufgespannt wird, liegen Probenabbildungen daher in der Regel nicht auf einer dieser Achsen. Ein parametrisiertes empirisches Modell kann zum einen eine Rotation einer Probenabbildung ausführen, so dass diese auf der M- oder T-Achse des Koordinatensystems zu liegen kommt (und damit ausschließlich deren Materialkontrasteinteil oder deren Topographiekontrastanteil aufweist). Der jeweilige Drehwinkel gibt die Größe des Topographiekontrastanteils bzw. des Materialkontrastanteils der analysierten Probenabbildung an.

Das parametrisierte empirische Modell kann allgemeiner eine Lageveränderung einer Abbildung der Probe in einer Ebene ausführen, die von ihrem Topographiekontrastanteil und ihrem Materialkontrastanteil aufgespannt wird.

Zum Beispiel kann das parametrisierte empirische Modell die zu untersuchende Probenabbildung in deren Materialkontrast- und Topographiekontrastanteile separieren, d.h. als eine Linearkombination (z.B. zweier Einheitsvektoren der M-Achse und der T-Achse) darstellen. Dies ist äquivalent zur Projektion der zu analysierenden oder zu bestimmenden Probenabbildung auf die T-Achse und die M-Achse des M/T-Koordinatensystems. Es ist z.B. auch möglich, die Materialkontrastanteile beider Abbildungen dann zu einem Gesamtbild zu addieren.

In beiden Fällen kann der Materialkontrast der Probe ermittelt werden. Eine Änderung der ausschließlich Materialkontrast aufweisenden Abbildung der Probe enthüllt eindeutig und zuverlässig eine Änderung der lokalen Materialzusammensetzung der Probe. Eine solche tritt beispielsweise auf, wenn ein Ätzprozess eine Schichtgrenze erreicht. Die aus einer Probenabbildung separierte Änderung des Materialkontrastanteils kann zur Steuerung eines Partikelstrahl-induzierten lokalen chemischen Reparaturprozesses eingesetzt werden.

Der Materialkontrast einer Probe kann durch Lösen eines Optimierungsproblems ermittelt werden. Dabei ist es vorteilhaft, alle verfügbaren Daten einer Probe zum Lösen des Optimierungsproblems zu nutzen. Beispielsweise schränken Proben in Form lithographischer Masken die Materialzusammensetzung der Komponenten der Maske - im einfachsten Fall binärer Masken sind dies das Maskensubstrat und die absorbierenden Pattern-Elemente - stark ein. So können aus den Design-Daten der Maske die reinen M- und T-Anteile einer Maskenabbildung bestimmt werden. Zudem können die Design-Daten zum Erstellen eines empirischen Modells für einen bestimmten Maskentyp eingesetzt werden. Beim Erstellen des empirischen Modells kann die zum Aufnehmen der zumindest zwei Abbildungen eingesetzte Detektorkonfiguration, d.h. der Abstände der einzelnen Detektoren von der Probe und zueinander, berücksichtigt werden. Ferner kann das empirische Modell einen oder mehrere Parameter umfassen, die den Arbeitspunkt des SEMs festlegen. Der Arbeitspunkt weist zumindest die Parameter auf: eine kinetische Energie der Teilchen des primären geladenen Teilchenstrahls, ein Abstand zwischen der Probe und der Objektivlinse, und ein Öffnungswinkel des primären Teilchenstrahls.

Das Entkopplungsmodell kann zumindest ein Element aus der Gruppe umfassen: ein empirisches Modell oder ein Transformationsmodell.

Ein Entkopplungsmodell kann verschiedene Ansätze zum Analysieren einer Abbildung hinsichtlich der enthaltenen Topographiekontrast- und Materialkontrastanteile verfolgen. Ein empirisches Modell kann eine analytische Verbindung zwischen zwei oder mehr Abbildungen und deren verschiedenen Topographiekontrast- und Materialkontrastbestandteilen herstellen. Ein Transformationsmodell kann hingegen auf das Aufstellen eines funktionalen Zusammenhangs zwischen den in zwei oder mehr Abbildungen enthaltenen Raumwinkelverteilungen der detektierten sekundären Partikel und der lokalen Topographie und Materialzusammensetzung der Probe verzichten. Diese Verbindung kann vielmehr implizit durch das Trainieren des Transformationsmodells hergestellt bzw. erlernt werden.

Das Entkopplungsmodell kann ausgebildet sein, die zumindest zwei Abbildungen miteinander zu verknüpfen. Elektronenoptische Simulationen können durchgeführt werden, um die Raumwinkelverteilung(en) oder die Akzeptanzfunktion(en) des einen oder der mehreren Detektoren zu bestimmen. In Kombination mit simulierten Winkelverteilungen der SE und der BSE kann ein Entkopplungsmodell für die M- und T-Anteile der zumindest zwei Abbildungen aufgestellt werden.

Das Verknüpfen der zumindest zwei Abbildungen kann umfassen: lineares Modifizieren der zumindest zwei Abbildungen und Kombinieren der zumindest zwei modifizierten Abbildungen. Das Kombinieren der zumindest zwei modifizierten Abbildungen kann zumindest ein Element aus der Gruppe umfassen: Addieren der zumindest zwei modifizierten Abbildungen, Subtrahieren der zumindest zwei modifizierten Abbildungen, Multiplizieren der zumindest zwei modifizierten Abbildungen, oder Dividieren der zumindest zwei modifizierten Abbildungen. Ferner kann das Verknüpfen der zumindest zwei Abbildungen umfassen: Bestimmen eines Materialkontrastanteils zumindest einer der zumindest zwei Abbildungen aus den zumindest zwei verknüpften Abbildungen.

Wie oben ausgeführt, beinhaltet eine Probenabbildung, die durch Abtasten der Probe mit Hilfe eines primären Partikelstrahls generiert wird, sowohl Intensitätsanteile, die von der Oberflächentopographie als auch der Materialzusammensetzung der Probe herrühren. Bei Betrachtung einer einzigen Probenabbildung können diese Anteile nicht ohne Weiteres getrennt werden. Neben der Landeenergie der primären Partikel variieren diese Anteile jedoch auch als Funktion des Raumwinkels, unter dem die Probe oder ein Teil der Probe bzw. ein Probenbereich betrachtet wird.

Ein empirisches Modell kann zumindest zwei Abbildungen, die sekundäre Teilchen erzeugen, die die Probe zumindest teilweise unter verschiedenen Raumwinkeln verlassen, verknüpfen. Die Raumwinkelbereiche, aus denen die sekundären Partikel der beiden Abbildungen stammen, sind durch die Anordnung des bzw. der Detektoren bekannt. Dadurch wird es möglich, aus den zumindest zwei Abbildungen der Probe deren Topographiekontrastanteile und Materialkontrastanteile zu ermitteln.

Ein erfindungsgemäßes Verfahren kann ferner den Schritt aufweisen: Anpassen des empirischen Modells an die Probe. Die Komplexität eines empirischen Modells kann an die Komplexität der abzubildenden Probe angepasst werden. Die Komplexität einer Probe hängt von deren Kontur oder Struktur(en) und dem Material bzw. der Materialzusammensetzung der Probe ab. Beispielsweise ist für Proben, deren Strukturen nur geringe Unterschiede in den Atommassen aufweisen, die Entkopplung schwieriger, verglichen mit Proben deren Strukturen große Atommassenunterschiede aufweisen. Proben, deren Strukturen geringe Atommassenunterschiede aufweisen, erfordern komplexe Entkopplungsmodelle.

Das Anpassen des empirischen Modells kann das Anpassen der Parameter des empirischen Modells an die Anzahl der verschiedenen Materialzusammensetzungen der Probe umfassen. Eine Probe in Form einer binären Fotomaske ist durch zwei Komponenten mit verschiedenen Materialzusammensetzungen charakterisiert. Eine phasenschiebende Maske weist hingegen zumindest drei Komponenten mit verschiedenen Materialzusammensetzungen auf. Zum Ermitteln einer Materialkontrast- und/oder einer Topographiekontrast-Abbildung einer binären Maske ist ein empirisches Modell mit zwei Parametern ausreichend. Ein empirisches Modell für eine phasenschiebende Maske benötigt hingegen zumindest drei Parameter.

Ein erfindungsgemäßes Verfahren kann ferner aufweisen: Bestimmen der Parameter des empirischen Modells.

Das Bestimmen der Parameter des empirischen Modells kann zumindest ein Element aus der Gruppe umfassen: Aufnehmen von zumindest zwei Abbildungen zumindest einer kalibrierten Teststruktur unter zumindest zwei verschiedenen Raumwinkeln, Simulieren von zumindest zwei Abbildungen der zumindest einen kalibrierten Teststruktur unter verschiedenen Raumwinkeln, oder Aufnehmen von zumindest zwei Abbildungen der zumindest einen kalibrierten Teststruktur unter verschiedenen Raumwinkeln, wobei zumindest ein Detektor ein aktiviertes Abschirmgitter aufweist.

Das Aufnehmen der zumindest zwei Abbildungen kann an zumindest einer ersten und zumindest einer zweiten Position der kalibrierten Teststruktur erfolgen, wobei die zumindest eine erste und die zumindest eine zweite Position verschiedene Materialzusammensetzungen aufweisen. Dies bedeutet, bei einer kalibrierten Teststruktur für eine binäre Maske werden zumindest zwei Abbildungen unter verschiedenen Raumwinkeln des Maskensubstrats und zumindest zwei Abbildungen unter verschiedenen Raumwinkeln eines absorbierenden Pattern-Elements aufgenommen. Für eine phasenschiebende Maske werden zumindest zwei Abbildungen unterschiedenen Raumwinkeln des Maskensubstrats, zumindest zwei Abbildungen des phasenschiebenden Materials und zumindest zwei Abbildungen des absorbierenden Materials eines Pattern-Elements aufgenommen. Die Materialkontrastanteile und die Topographiekontrastanteile einer kalibrierten Teststruktur sind aufgrund der vorgenommenen Kalibrierung bekannt.

Das Simulieren der zumindest zwei Abbildungen kann das Ausführen von Monte Carlo Simulationen der Wechselwirkung des primären Teilchenstrahls mit der Probe und eine elektronenoptische Simulation des Pfades der sekundären Teilchen von der Probe zu den zumindest zwei Detektoren umfassen.

Das Bestimmen der Parameter des empirischen Modells kann umfassen: Variieren der Parameter des empirischen Modells zum Minimieren eines Unterschieds einer gemessenen Abbildung der Probe mit einer gemessenen oder simulierten Abbildung der kalibrierten Teststruktur.

Zum Bestimmen eines lokalen Materialsignals oder einer punktförmigen Abbildung, die ausschließlich Signalanteile aufweist, die vom Materialkontrast herrühren, können eine lokale bzw. punktförmige Probenabbildung mit einem oder mehreren Detektoren an einem Punkt einer Probe aufgenommen werden (pixelweises Bestimmen) und in einer Funktion verarbeitet werden, um ein Materialsignal des Punktes der Probenoberfläche zu bestimmen. In einfachster Form kann eine Linearkombination der zwei oder mehreren Detektorsignale hierfür genommen werden. Selbstredend sind die Detektorsignale in anderen Funktionen kombinierbar. Die Koeffizienten der Funktion können durch Vergleichen mit einer kalibrierten Teststruktur, deren Materialsignal (d.h. deren Materialkontrastanteil einer Abbildung) bekannt ist, bestimmt werden.

Für eine Probe, die sich aus zwei Komponenten zusammensetzt, etwa einer binären Fotomaske können die Koeffizienten der Funktion so kalibriert werden, dass diese den Wert 1 für die erste Komponente, etwa das Maskensubstrat, sowie den Wert 0 für die zweite Komponente, etwa die absorbierenden Pattern-Elemente annehmen.

Die zuletzt beschriebene Ausführungsform zum Bestimmen der Parameter eines empirischen Modells benötigt kein Rastern des primären Teilchenstrahls über die Probe, da ausschließlich Signale der Probe verarbeitet werden, die von einem Punkt der Probenoberfläche ausgehen. Je größer die Anzahl der Signale verschiedener Detektoren, die verarbeitet werden können, desto höher die Genauigkeit, mit der das lokale Materialsignal der Probe ermittelt werden kann. Dies bedeutet, einen Vorteil gegenüber einem einzelnen energiegefilterten Signal, das derzeit häufig zum Bestimmen eines Materialkontrastanteils verwendet wird. Durch den Einsatz von zwei oder mehr Detektoren können mehr lokal von der Probe ausgehende sekundäre Partikel oder Teilchen detektiert und dadurch nutzbar gemacht werden. Dadurch kann ein besseres Signal-Rausch-Verhältnis erreicht werden und/oder die Datenaufnahme kann schneller erfolgen.

Da die gemessenen Topographiedaten der Probe nicht perfekt lokal und zudem detektorabhängig sind, können diese bei einem lokalen Bestimmen der Parameter des o.g. empirischen Modells nicht vollständig kompensiert werden. Der Kompensationsanteil wächst jedoch mit der Zahl der eingesetzten Detektoren. Darüber hinaus müssen für jeden Arbeitspunkt (Landeenergie der primären Teilchen bzw. Elektronen, Abstand zwischen der Maske und der Objektivlinse, Einstellungen der Objektivlinse, usw.) sowie für jeden Probentyp bzw. Maskentyp die Parameter des empirischen Modells optimiert werden.

Das Bestimmen einer Abbildung, die lediglich Materialkontrastbeiträge aufweist, basierend auf einem empirischen Modell kann das Rastern eines primären Partikelstrahls über eine Probe und Aufnehmen zumindest zweier Detektorsignale an den Rasterpunkten des primären Partikel- bzw. Elektronenstrahls umfassen.

Bei dem oben diskutierten pixelweisen Bestimmen der Parameter des empirischen Modells bleiben nichtlokale Effekte aufgrund der Proben-Topographie ohne Berücksichtigung. Indem der primäre Partikelstrahl über einen Teil der Probe gerastert oder gescannt wird, können die nichtlokalen Signalanteile der zumindest zwei Detektorsignale beim Bestimmen der Parameter des empirischen Modells berücksichtigt werden.

Anstelle der Aufnahme eines Signals an nur einem Punkt werden mehrere Bildsignale für jeden der zumindest zwei Detektoren mit einem Scan des Primärstrahls über einen Teil der Probe aufgenommen. Durch Ausführen einer Faltung mit einem oder mehreren Faltungskernen können aus den Bildern der einzelnen Detektoren neue Signale generiert werden. Über eine Anpassung der gefalteten Messdaten an die Messung einer kalibrierten Teststruktur können die Parameter des empirischen Modells bestimmt werden.

Als Faltungskern kann zumindest ein Bildfilter aus der Gruppe eingesetzt werden: ein Sobel-Filter, ein Prewitt-Filter, ein Laplace-Filter, ein Marr-Hildreth-Filter, ein Gauss-Filter, oder ein Sharpen-Filter. Die Größe des Faltungskerns kann an die Größe des Scanbereichs angepasst werden. Der Rasterbereich des primären Partikelstrahls sollte größer als der Bildbereich des Faltungskern gewählt werden. Um die Genauigkeit der Faltungsoperation hochzuhalten, ist es zudem günstig, den Scanbereich so groß zu wählen, dass das Vorgehen am Randbereich (beispielsweise das Erweitern, Umfalten bzw. Abschneiden) unterhalb einer vorgegebenen Fehlerschwelle bleibt. Der Rasterbereich kann in einer Dimension eine Abmessung im Bereich von 2 nm bis 50 nm, bevorzugt 5 nm bis 20 nm umfassen.

Durch das Bestimmen der Parameter des empirischen Modells aus einem Scanbereich anstelle eines pixelweisen Bestimmens können die verbleibenden Topographieeffekte in einer Materialkontrastabbildung einer Probe bzw. eines Probenausschnitts deutlich verringert werden. Dem Vorteil einer signifikanten Qualitätsverbesserung steht der Nachteil eines deutlich höheren Aufwands gegenüber. Das Rastern über einen Probenbereich dauert länger als das Aufnehmen von Bildern bzw. Abbildungen eines einzelnen Probenpunktes. Die Größe eines Faltungskerns kann durch Ausführen von Monte Carlo Simulationen ermittelt werden. Der Optimierungsprozess zum Bestimmen der Parameter des empirischen Modells ist für jeden Probentyp und jeden Arbeitspunkt auszuführen.

Nach dem Festlegen der Parameter eines empirischen Modells kann dieses mindestens zwei Abbildungen einer Probe, die unterschiedliche Topographiekontrast- und Materialkontrastanteile aufweisen, so miteinander verrechnen, dass aus den zumindest zwei vorgelegten Probenabbildungen deren Topographiekontrast- und Materialkontrastanteil extrahiert werden kann.

Das Transformationsmodell kann zumindest ein Transformationsmodell mit zumindest zwei Transformationsblöcken umfassen, die zumindest jeweils eine generisch lernbare Funktion umfassen, vorzugsweise ein Modell maschinellen Lernens, und/oder ein generatives Modell.

Ein trainiertes Transformationsmodell kann eine Abbildung aus zumindest zwei unter zumindest teilweise verschiedenen Raumwinkeln gemessenen Abbildungen in eine Abbildung transformieren, die einen vorgegebenen Anteil an Topographiekontrast und/oder Materialkontrast aufweist. Insbesondere kann ein Transformationsmodell darauf trainiert werden, eine gemessene Abbildung so zu transformieren, dass die transformierte Abbildung ausschließlich den Materialkontrastanteil der vorgelegten zu analysierenden Abbildung anzeigt. Alternativ und/oder zusätzlich ist es auch möglich, ein Transformationsmodell so zu trainieren, dass es den Topographiekontrastanteil und/oder den Materialkontrastanteil einer der beiden gemessenen Abbildungen als Zahlenwert ausgibt. Eine Änderung des Materialkontrastanteils, die einen vorgegebenen Schwellenwert übersteigt, kann zum Detektieren der Änderung einer lokalen Materialzusammensetzung benutzt werden.

Ein Transformationsmodell kann jedoch auch so trainiert werden, dass es beide bzw. alle der zumindest zwei gemessenen Abbildungen in Abbildungen transformiert, die jeweils ein vorgegebenes Verhältnis an Topographiekontrast und Materialkontrast aufweisen. Ferner ist es möglich, ein Transformationsmodell so zu trainieren, dass die erste transformierte Abbildung ausschließlich Topographiekontrast zeigt und die zweite transformierte Abbildung ausschließlich Materialkontrast darstellt.

Ein Transformationsmodell muss nicht eine Abfolge Encoder, Feature-Projektion und Decoder umfassen. Stattdessen kann in jeder der N-Schichten (z.B. eines neuronalen Netzes) eine generische, lernbare Funktion vorgesehen sein, welche Eingaben in Ausgaben überführt, ohne den Anspruch zu haben, eine geeignete und damit transferierbare Repräsentation (Features) der Eingaben in einem der Zwischenschritte zu generieren.

Eine generisch lernbare Funktion eines Transformationsblocks eines Transformationsmodells erhält als Eingabedaten die Ausgabedaten des vorhergehenden Transformationsblocks. Allgemein erhält ein N-ter Transformationsblock die Ausgabedaten des (N-1)-ten Transformationsblocks ($O_{N-1}$). Die Ausgabedaten des (N-1)-ten Transformationsblocks sind die Eingabedaten des N-ten Transformationsblocks ($I_N$): $O_{N-1} = I_N$. Die Ausgabedaten des (N-1)-ten Transformationsblocks $O_{N-1}$ können die ursprünglichen Eingabedaten $I_1$ des ersten Transformationsblocks in unveränderter Form umfassen. Ferner können die Ausgabedaten des (N-1)-ten Transformationsblocks die Eingabedaten aller vorhergehenden Transformationsblöcke ($I_1, ..., I_{N-1}$) in unveränderter Form umfassen. Darüber hinaus können die Eingabedaten des N-ten Transformationsblocks $I_N$ die von den vorhergehenden Transformationsblöcken transformierten Eingabedaten $T_{N-1}(O_{N-2}), P_{N-1}) = T_{N-1}(I_{N-1}, P_{N-1})$ umfassen. Dabei bezeichnet $T_{N-1}$ die im (N-1)-ten Transformationsblock an den Eingangs- oder Eingabedaten $I_{N-1}$ ausgeführte Transformation. $P_N$ bezeichnet die Modellparameter des Transformationsmodells im N-ten Transformationsblock.

Falls in dem N-ten Transformationsblock die Transformation $T_N$ einen Faltungsoperator beschreibt, werden in diesem Transformationsblock als Eingabegrößen oder Eingabedaten $I_N$ nur die transformierten Daten der vorhergehenden Schicht $T_{N-1}(I_{N-1}, P_{N-1})$ berücksichtigt und die Eingabedaten der früheren Transformationsblöcke $I1, ..., I_{N-1}$ ignoriert. Die Modellparameter $P_N$ dieses Transformationsblocks entsprechen Faltungsgewichten und der N-te Transformationsblock führt die Funktion einer Faltungsschicht oder eines Faltungsblocks aus.

Eine generisch lernbare Funktion eines Transformationsblocks kann zumindest ein Element aus der Gruppe umfassen: einen Faltungsblock (Convolution block), einen Entfaltungsblock (deconvolution block), einen Bündelungsblock (pooling block), einen Entbündelungsblock (de-pooling block), einen DenseBlock, einen ResBlock, einen InceptionBlock, einen Encoder oder einen Decoder.

Ein Transformationsmodell kann angelernt oder trainiert werden, dass es zumindest eine Abbildung eines Tupels gemessener Abbildungen in eine transformierte Abbildung transformiert, die aussieht, wie eine Abbildung, die ein vorgegebenes Verhältnis von Topographiekontrast und Materialkontrast aufweist. Ein Transformationsmodell kann aber auch trainiert werden, zumindest eine simulierte Abbildung eines Tupels simulierter Abbildungen in eine transformierte Abbildung umzuwandeln, die ein vorgegebenes Topographiekontrastverhältnis und/oder Materialkontrastverhältnis aufweist.

Ein Modell maschinellen Lernens kann eine Encoder-Decoder-Struktur umfassen. In Encoder-Decoder-Architekturen werden auf der Encoder-Seite Eingabedaten durch eine Reihe von lernbaren Funktionen auf informationstragende Merkmale, Merkmale oder Features abgebildet (engl.: encoded). Aus diesen Features werden dann auf der Decoder-Seite mittels ebenfalls lernbarer Funktionen die Zieldaten, im vorliegenden Fall zumindest eine transformierte Abbildung mit vorgegebenem Topographie- und/oder Materialkontrastanteil extrahiert (engl.: decoded). Die einzelnen Funktionen sowohl auf der Encoder- als auch der Decoder-Seite werden üblicherweise als Schichten (engl. "layer") bezeichnet. In einer Encoder-Decoder-Architektur stehen einer Schicht typischerweise die Ausgaben der vorhergehenden Schicht als Eingaben zur Verfügung. Es ist aber auch möglich, entsprechende Schichten der Encoder- und Decoder-Seite miteinander zu verbinden.

Ein Modell maschinellen Lernens kann zumindest ein Element aus der Gruppe umfassen: eine parametrische Abbildung, ein neuronales Netz (NN, Neural Network), ein künstliches neuronales Netz (ANN, Artifical Neural Network), ein tiefes neuronales Netz (DNN, Deep Neural Network), ein zeitverzögertes neuronales Netz, ein faltendes neuronales Netz (CNN, Convolutional Neural Network), ein rekurrentes neuronales Netz (RNN, Recurrent Neural Network) oder ein Long Short-Term Memory (LSTM)-Netz.

Ein Teilchenstrahl-induzierter Reparaturprozess einer Probe kann als eine zeitliche Abfolge von lokalen Abbildungen der Probe betrachtet werden und kann damit als eine Videoaufnahme interpretiert werden. Durch diese Betrachtungsweise und die Wahl einer entsprechenden Netzwerkarchitektur kann die Genauigkeit der durchzuführenden Transformation deutlich gesteigert werden.

Das Modell maschinellen Lernens (ML-Modell) kann ein subsymbolisches System umfassen. Bei einem symbolischen System ist das Wissen, d.h. die Trainingsdaten und die induzierten Regeln, explizit dargestellt. Bei einem subsymbolischen System wird dem Modell ein berechenbares Verhalten angelernt, ohne jedoch einen detaillierten Einblick in die gelernten Lösungswege zu haben.

Ferner kann ein Modell maschinellen Lernens (ML-Modell) zumindest ein Element aus der Gruppe umfassen: einen Kerndichteschätzer, ein statistisches Modell, einen Entscheidungsbaum, ein lineares Modell, ein zeitvariantes Modell, eine nächste-Nachbar-Klassifikation, und ein k-nächste-Nachbar-Algorithmus (engl.: k-nearest-neighbor algorithm) sowie deren nichtlineare Erweiterungen mit nichtlinearen Merkmalstransformationen.

Ein Kerndichteschätzer (englisch: kernel density estimation, KDE) ermöglicht eine stetige Schätzung einer unbekannten Wahrscheinlichkeitsverteilung auf der Basis von Stichproben. Kerndichteschätzer können beispielsweise einen Gauß-Kern, einen Cauchy-Kern, einen Picard-Kern oder einen Epanechnikov-Kern umfassen, wobei die enthaltenen Kernel-Parameter des ML-Modells, wie etwa die Bandbreite für alle Eingabeparameter, gemeinsam oder individuell belegt oder geschätzt werden können.

Das statistische Modell kann zumindest eine Mischverteilung umfassen. Eine Mischverteilung kann ein Element aus der Gruppe umfassen: eine Gaußsche Mischverteilung (GMM, Gaussian Mixture Model), eine multivariante Normalverteilung und eine kategorische Mischverteilung. Die geeignete Anzahl der Mischverteilungen hängt von den vorliegenden Daten ab und kann mit Hilfe eines Validierungsdatensatzes optimiert werden.

Der Entscheidungsbaum (englisch: DT, Decision Tree) kann zumindest ein Element aus der Gruppe umfassen: einen herkömmlichen Entscheidungsbaum (DT), einen randomisierten Entscheidungsbaum (RDT) oder einen Entscheidungswald (englisch: DF, Decision Forrest) sowie dessen randomisierte Variante (RDF). Bei RDTs und RDFs können das Ausmaß oder das "Level" der Randomisierung variieren. Es können je Knoten alle oder nur eine zufällige Auswahl an möglichen Entscheidungen im Training vorliegen. Es können je Blatt eines Entscheidungsbaumes alle oder nur eine Teilmenge der bis dorthin vorliegenden Trainingsbeispiele genutzt werden.

Das lineare Modell kann zumindest ein Element aus der Gruppe umfassen: eine latente Dirichlet-Allokation (englisch: LDA, latent Dirichlet allocation), eine Support Vector Machine (SVM), eine logistische Regression, eine Methode der kleinsten Quadrate (least square estimation), eine Lasso-Regression, eine Ridge-Regression, oder ein Perzeptron. Ein vorteilhaftes Anwenden eines linearen Modells erfordert eine Normierung der Eingabedaten und der Trainingsdaten.

Das ML-Modell kann eine nichtlineare Erweiterung einer SVM in Form einer Kernel Support Vector Machine umfassen. Ferner kann das ML-Modell eine nichtlineare Erweiterung der Gaußschen Mischverteilung in Form einer Gaußschen Prozessregression umfassen.

Das zeitvariante Modell kann zumindest ein Element aus der Gruppe umfassen: ein rekurrentes neuronales Netz oder ein Hidden Markov Modell. Ein zeitvariantes Modell kann durch ein zeitinvariantes Modell nachgebildet werden, indem die Parameter einer früheren Messung dem zeitinvarianten Modell als Eingabedaten zur Verfügung gestellt werden.

Ferner kann das ML-Modell zwei oder mehr verschiedene Modelltypen maschinellen Lernens der oben angegebenen Gruppe umfassen. Ein Modell maschinellen Lernens, das ein Ensemble oder eine Gruppe mehrerer verschiedener Modelltypen oder mehrerer Lernalgorithmen nutzt, kann in der Regel bessere Ergebnisse erreichen als ein ML-Modell, das auf einem einzigen Modelltyp oder Lernalgorithmus beruht. Die Berechnung der Ergebnisse der Anzahl der verschiedenen Modelltypen dauert typischerweise länger als die Auswertung eines einzelnen Typs eines ML-Modells. Dafür kann jedoch bereits mit einer geringeren Rechentiefe ein Ergebnis erreicht werden, das einem ML-Modell mit einem ML-Modelltyp oder einem Lernalgorithmus entspricht.

Die Vorhersagen der verschiedenen Bestandteile der Kombination können gleich gewichtet zur Vorhersage des Modells maschinellen Lernens beitragen. Die Vorhersagen der verschiedenen ML-Modelltypen können gewichtet zur Vorhersage des Modells maschinellen Lernens beitragen.

Ein Modell maschinellen Lernens, das eine Gruppe verschiedener ML-Modelltypen umfasst, kann in der Trainingsphase inkrementell aufgebaut werden, indem jedem neu der Gruppe hinzugefügten Modelltyp insbesondere die Trainingsdaten vorgelegt werden, die die bisherigen Modelltypen der Gruppe nicht oder nur schlecht vorhersagen konnten.

Die Auswahl der zwei oder mehr verschiedenen ML-Modelltypen eines Modells maschinellen Lernens kann mit Hilfe von automatisiertem maschinellem Lernen (Automated Machine Learning oder AutoML) erfolgen.

Das Transformationsmodell kann ein Modell maschinellen Lernens, insbesondere ein Deep Learning Modell, umfassen. Das Modell maschinellen Lernens kann ein künstliches neuronales Netzwerk einsetzen. Das Deep Learning Modell kann ein tiefes neuronales Netzwerk einsetzen. Ein tiefes neuronales Netzwerk weist mehrere bzw. eine Vielzahl von Zwischenschichten (englisch: hidden layers) auf. Eine Deep Learning Architektur kann neben einer Klassifikation der vorgelegten Daten auch eine Feature Extraktion der vorgelegten Daten ausführen.

Das tiefe neuronale Netzwerk (DNN) kann eine U-Net Architektur oder eine ResNet Architektur aufweisen.

Eine U-Net Architektur weist eine Symmetrie zwischen dem Encoder- und Decoder-Zweig auf, was in einer U-förmigen Struktur der Architektur resultiert. Die U-Net Architektur kann neben der Datenweitergabe zwischen den verschiedenen Schichten des Encoders und des Decoders zusätzliche Verbindungen zwischen entsprechenden Schichten des Encoders und Decoders aufweisen, über die Ausgabedaten von einer Schicht des Encoders direkt als zusätzliche Eingabedaten an die entsprechende Schicht des Decoders übertragen werden.

Eine Residual Network (ResNet) Architektur ist ebenfalls eine Encoder-Decoder-Struktur, bei der Daten ebenfalls nicht nur zwischen benachbarten Schichten des Encoder- und Decoder-Zweigs weitergegeben werden. Ein ResNet weist zusätzliche Verbindungen auf, über die Ausgabedaten über mehrere Schichten hinweg als Eingabedaten in übernächste und/oder über mehrere Schichten übertragen werden. Diese zusätzlichen Datenübertragungen finden typischerweise sowohl auf der Encoder- als auch der Decoder-Seite der Architektur statt.

Das Modell maschinellen Lernens kann zumindest einen zusätzlichen Parameter umfassen, der dem Modell maschinellen Lernens (ML-Modell) an dessen Eingang bereitgestellt wird.

Als Alternative zum soeben beschriebenen Vorgehen werden einem ML-Modell neben den gemessenen Abbildungs-Tupeln ein oder mehrere zusätzliche Parameter übergeben. Der eine oder die mehreren zusätzlichen Parameter stehen dem Transformationsmodell oder dem ML-Modell sowohl während der Trainingsphase als auch zum Bestimmen des Topographiekontrastanteils und/oder des Materialkontrastanteils eines gemessenen Abbildungs-Tupels als Eingabe zur Verfügung. Dadurch kann eine Art verallgemeinertes Modell für verschiedene Maskentypen für verschiedene Parametereinstellungen der Reparaturvorrichtung für Vorhersagezwecke eingesetzt werden. Es muss nur ein verallgemeinertes Transformationsmodell bzw. ML-Modell trainiert werden und dieses kann anschließend für verschiedene Maskentypen und verschiedene Einstellungen der Systemparameter der Reparaturvorrichtung eingesetzt werden.

Der zumindest eine zusätzliche Parameter kann einen Systemparameter einer Reparaturvorrichtung umfassen.

Der zumindest eine zusätzliche Parameter kann zumindest einen Parameter der lithographischen Maske und/oder zumindest einen Systemparameter der Reparaturvorrichtung bzw. dessen Abbildungssystems umfassen. Der zumindest eine Parameter der Maske kann einen Maskentyp, Abmessungen und Materialzusammensetzungen des Maskensubstrats und/oder der Pattern-Elemente umfassen und/oder der zumindest eine Systemparameter kann eine Landeenergie des primären Teilchenstrahls, einen Auftreffwinkel des primären Teilchenstrahls auf die Probe, die Belichtungseinstellung der Objektivlinse, einen Öffnungswinkel des primären Teilchenstrahls, eine Rastergeschwindigkeit des primären Teilchenstrahls, eine Integrationszeit des primären Teilchenstrahls (dwell time), eine Raster-Strategie (z.B. Zeile für Zeile, verschachtelt (interlace) oder diagonaler Scan), eine asymmetrische Anordnung zumindest eines Detektors bezüglich der Strahlachse des primären Teilchenstrahls, eine Potentialeinstellung eines Energiefilter, und/oder eine Potentialeinstellung eines Abschirmgitters am partikeloptischen Säulenausgang umfassen.

Das ML-Modell kann zumindest einen Hyperparameter umfassen, der die Probe charakterisiert. Das Deep Learning Modell kann zumindest einen Hyperparameter umfassen, der die Probe charakterisiert. Die Probe kann eine Fotomaske umfassen und der Hyperparameter kann den Maskentyp festlegen. Hyperparameter von Modellen maschinellen Lernens und/oder von Deep Learning Modellen sind Modellparameter, die vor Beginn der Trainingsphase für das ML-Modell bzw. das Deep Learning (DL.) Modell festgelegt werden.

Ein Transformationsmodell, ein ML-Modell bzw. ein Deep Learning Modell kann einen gemeinsamen Encoder-Zweig für die Eingabedaten und den zumindest einen zusätzlichen Parameter aufweisen und für jeden der zusätzlichen Parameter einen eigenen Decoder-Zweig haben. So kann beispielsweise durch einen Hyperparameter eine generische Fotomaske in eine binäre Maske umgewandelt werden. Dies geschieht durch Freischalten des gewählten Decoder-Zweigs, während die übrigen Decoder-Zweige deaktiviert werden, d.h. beispielsweise mit Null multipliziert werden. Im Gegensatz zu Hyperparametern werden die Modellparameter eines Transformationsmodells, eines ML-Modells oder eines DL-Modells während eines Lern- oder Trainingsprozesses bestimmt.

Der zumindest eine zusätzliche Parameter vergrößert den Trainingsaufwand des Transformationsmodells bzw. des Deep Learning Modells nur sublinear, da auch bei Berücksichtigung des zumindest einen zusätzlichen Parameters die für das Transformationsmodell, das ML-Modell oder das Deep Learning Modell zu lösende Probleme ähnlich sind, so dass das Transformationsmodell Teile der bereits bestimmten Modellparameter "wiederverwenden" kann.

Ein erfindungsgemäßes Verfahren kann ferner den Schritt aufweisen: Trainieren des Transformationsmodells mit einem Trainingsdatensatz.

Entscheidend für die Prädiktion des Materialkontrastanteils und/oder des Topographiekontrastanteils eines Tupels gemessener Abbildungen ist das Trainieren des ML- bzw. DL-Modells, allgemein eines Transformationsmodells, mit einer hinreichend großen Menge an Trainingsdaten. Insbesondere für Deep Learning Architekturen, die aufgrund ihrer Vielzahl verborgener Schichten eine große Anzahl an Parametern aufweisen, kommt der Qualität und der Quantität der Trainingsdaten oder des Trainingsdatensatzes eine Schlüsselrolle zu.

Der Trainingsdatensatz des Transformationsmodells kann zumindest ein Element aus der Gruppe umfassen: eine Vielzahl von Tupeln zumindest zweier aufgenommener Abbildungen zumindest einer zum Training verwendeten Probe, eine Vielzahl von Tupeln zumindest zweier aufgenommener Abbildungen zumindest einer zum Training verwendeten Teststruktur, eine Vielzahl von Tupeln zumindest zweier simulierter Abbildungen zumindest einer zum Training verwendeten Probe, oder eine Vielzahl von Tupeln zumindest zweier simulierter Abbildungen zumindest einer zum Training verwendeten Teststruktur, wobei die Tupel zumindest zweier Abbildungen unter zumindest teilweise verschiedenen Raumwinkeln bezogen auf die zum Training verwendete zumindest eine Probe und/oder Teststruktur aufgenommen bzw. simuliert wurden.

Die Simulation der Trainingsdaten kann das Ausführen einer Monte Carlo Simulation der Wechselwirkung des primären Teilchenstrahls, z.B. Elektronenstrahls, mit der Probe und eine elektronenoptische Simulation des Pfades der sekundären Teilchen, z.B. der SE und BSE, von der Probe zu jedem der zumindest zwei Detektoren umfassen. Zur Verbreiterung der durch Simulation erzeugten Trainingsdaten kann die Probe einer zufälligen Rotation und/oder einer Skalierung unterworfen werden. Den Eingangsdaten der Simulation kann ein Rauschbeitrag hinzugefügt werden. Den Eingangsdaten der Simulation können in definierter Weise verschiedene Defekte der Probe überlagert werden. Ferner können die gemessenen Proben Defekte aller bekannten Arten aufweisen. Eine Teststruktur kann definierte Defekte vorgegebener Größe und/oder Form aufweisen. Von einer kalibrierten Teststruktur können die Daten des Materialkontrasts und/oder des Topographiekontrasts bekannt sein.

Die Anzahl der Tupel gemessener und simulierter Abbildungen des Trainingsdatensatzes kann einen Bereich von $10^2$ bis $10^6$, bevorzugt $5 \cdot 10^2$ bis $3 \cdot 10^5$, mehr bevorzugt $10^3$ bis $10^5$, und am meisten bevorzugt $3 \cdot 10^3$ bis $3 \cdot 10^4$ umfassen.

Einem trainierten Transformationsmodell werden Tupel gemessener bzw. aufgenommener und/oder simulierter Abbildungen einer Probe als Eingabe in einen ersten Transformationsblock bereitgestellt. Die Abbildungen eines Tupels enthalten unterschiedliche Anteile an Topographiekontrast und Materialkontrast. Der zweite Transformationsblock des trainierten Transformationsmodells gibt eine transformierte Abbildung der Probe aus, die ein vorgegebenes Verhältnis von Topographiekontrast und Materialkontrast aufweist. Insbesondere kann die von dem trainierten Transformationsmodell ausgegebene transformierte Abbildung ausschließlich Topographiekontrast oder Materialkontrast aufweisen. Ferner kann das trainierte Transformationsmodell aus einem Tupel vorgelegter Probenabbildungen zwei transformierte Probenabbildungen generieren, wobei eine erste transformierte Abbildung ausschließlich Materialkontrastanteile und eine zweite transformierte Abbildung ausschließlich Topographiekontrastanteile aufweist.

Das Transformationsmodell bzw. das Deep Learning Modell kann so trainiert werden, dass es ein Tupel von transformierten Abbildungen ausgibt. Das Tupel der transformierten Abbildungen kann dem Tupel der dem Transformationsmodell bereitgestellten gemessenen Abbildungen entsprechen oder kleiner sein.

Wie oben angegeben, kann ein Trainingsdatensatz zum Trainieren des Modells maschinellen Lernens bzw. des Deep Learning Modells eine Vielzahl von Tupeln zumindest zweier gemessener Abbildungen von zum Training verwendeten Proben und eine Vielzahl von Tupeln zumindest zweier simulierter Abbildungen von zum Training verwendeter Proben umfassen, wobei die Tupel gemessener und simulierter Abbildungen unter zumindest teilweise verschiedenen Raumwinkeln bezogen auf die zum Training verwendeten Proben aufgenommen werden. Ein Tupel des Trainingsdatensatzes kann zwei Abbildungen umfassen, die einen Probenbereich einer zum Training verwendeter Probe aus zwei verschiedenen Raumwinkeln betrachtet, darstellen. Die Größe eines Tupels des Trainingsdatensatzes kann der Anzahl der Detektoren entsprechen, die zum gleichzeitigen Aufnehmen von Abbildungen einer Probe eingesetzt werden.

Ein erfindungsgemäßes Verfahren kann ferner den Schritt aufweisen: Aufnehmen des Trainingsdatensatzes für das Transformationsmodell.

Ein Paradigma des Maschinellen Lernens (ML) ist die Notwendigkeit, eine ausreichende Anzahl repräsentativer Lerndaten für Trainingszwecke des Transformationsmodells zur Verfügung zu haben. Dies bedeutet, Verfahren des ML bzw. des DL (Deep Learning) können die Abbildung von Eingaben auf Ausgaben typischerweise nur für die Eingabedaten verlässlich ausführen, für die ähnliche Lerndaten vorliegen, anhand derer das Transformationsmodell trainiert wurde.

Dadurch können nur die Abbildungen von Proben simuliert werden, die in den Trainingsdaten enthalten sind. Falls die Probe beispielsweise eine Fotomaske ist, kann diese ausschließlich durch Abbildungen von Fotomasken trainiert werden. Für ein allgemein gültiges Transformationsmodell einer Fotomaske sind daher möglichst viele unterschiedliche Fotomasken in den Trainingsdaten vorzusehen, deren Struktur- oder Pattern-Elemente der tatsächlichen Anwendung entsprechen. Dazu gehören beispielsweise Fotomasken mit unterschiedlicher Oberflächenbeschaffenheit, etwa verschiedener Rauigkeit, sowie Masken, deren Materialzusammensetzung(en) aufgrund von Kontamination(en) variieren.

Da das trainierte Transformationsmodell im Rahmen eines Maskenreparaturprozesses eingesetzt werden soll, ist es notwendig, dass dessen Trainingsdaten alle in der Praxis vorkommende Defekte von Fotomasken beinhalten. Zudem ist es günstig, wenn die Trainingsdaten verschiedene Zwischenzustände der Defektreparatur enthalten. Fotomasken mit definierten Defekten können für Trainingszwecke auf Basis von Simulationen generiert werden. Dies kann mitunter zu langen Trainingszeiträumen führen.

Es kann deshalb vorteilhaft sein, einzelne Klassen von Fotomasken (etwa binäre Masken, phasenschiebende Masken, Masken für Mehrfachbelichtung) durch separate Transformationsmodelle zu beschreiben und zu trainieren. Dies bedeutet, das korrekte Trainieren eines ML-Modells, insbesondere eines DNN (Deep Neural Network) erfordert typischerweise konsistente Trainingsdaten, die eine eineindeutige Abbildung der Eingabedaten auf die Ausgabedaten darstellen. Für den Bereich der Fotomasken bedeutet dies, dass für jeden einzelnen Maskentyp (z.B. OMOG (Opaque MoSi On Glass), COG (Chrome On Glass), PSM (Phase Shift Mask), APSM (Alternating Phase Shift Mask) usw.) ein eigenes ML-Modell notwendig ist. Dadurch können zum einen die einzelnen Trainingsphasen kürzer ausfallen und zum anderen kann die erzielbare Genauigkeit bei der transformierten Abbildung (en) verbessert werden. Alternativ kann ein ML- bzw. DL-Modell für eine Maske vortrainiert werden und die einzelnen Maskentypen durch einen oder mehrere Hyperparameter spezifiziert werden.

Ein Teil der benötigten Trainingsdaten kann während der Inbetriebnahme einer Reparaturvorrichtung aufgenommen werden. Hierfür können die in der Kalibrierungsphase der Reparaturvorrichtung anfallenden Abbildungen der Maske herangezogen werden. Auch das Training des ML-Modells kann zum Teil während der Kalibrierungsphase der Reparaturvorrichtung ausgeführt werden. Damit die Inbetriebnahme nicht zu lange dauert, können die Parameter des ML-Modells im Reparaturbetrieb ständig optimiert werden. Dieses Vorgehen führt zu einem inkrementellen Lernen des ML- bzw. DL-Modells. Hierbei kann es günstig sein, die ursprünglichen Trainingsdaten für das inkrementelle Lernen weiterhin vorrätig zu haben, um ein Überanpassen des ML- bzw. DL-Modells an die neuen Daten zu vermeiden.

Die Topographie- und/oder Materialkontrastanteile gemessener Abbildungs-Tupel können hinreichend genau zumindest ex-situ ermittelt werden. Hierfür kann z.B. energiedispersive Röntgenspektroskopie (EDX) und/oder ein EsB- (Energy selective Back-scattered) Detektor eingesetzt werden. Für programmierte Defekte kann auf Design-Daten zurückgegriffen werden.

Ein Teil der Trainingsdaten kann mit Hilfe von Tupeln simulierter Abbildungen der zum Training verwendeten Proben, etwa Fotomasken, ausgeführt werden. Anders als gemessene Abbildungen ist der Topographiekontrastanteil und der Materialkontrastanteil simulierter Abbildungen bekannt. Dadurch eignen sich diese besonders gut als Trainingsdaten, da in einfacher Weise festgestellt werden kann, ob das trainierende Transformationsmodell die vorgelegten Abbildungen wirklichkeitsnah transformieren kann. Ferner können Abbildungen weniger häufig verwendeter Fotomasken (etwa Dreiton-Phasenmasken) für Trainingszwecke reproduzierbar simuliert werden. Überdies können mittels Simulationen Abbildungen für alle Defektarten in jeder Stufe des Reparaturprozesses realitätsnah generiert werden. Dadurch kann das Messen von tausenden Abbildungs-Tupeln vermieden werden. Das Trainieren des ML- bzw. DL-Modells benötigt jedoch eine entsprechende Menge an Trainingsdaten, was das Ausführen einer großen Anzahl zeitaufwändiger Simulationen bedeuten kann. Diese Simulationen können jedoch an einer zentralen Stelle mit speziell für diesen Zweck optimierten Computersystemen kostengünstig ausgeführt werden.

Ein Transformationsmodell, ein ML- bzw. ein DL-Modell erzeugt Wissen aus Erfahrung. Es lernt aus Beispielen, die dem Modell in Form von Trainings- oder Lerndaten in einer Lern- oder Trainingsphase zur Verfügung gestellt werden. Damit können interne Variablen des Modells, beispielsweise Parameter einer parametrischen Abbildung, mit geeigneten Werten belegt werden, um Zusammenhänge in den Trainingsdaten beschreiben zu können. Infolgedessen lernt das Transformationsmodell bzw. das ML-Modell in der Trainingsphase in der Regel nicht einfach die Trainingsdaten auswendig, sondern identifiziert Muster und/oder Gesetzmäßigkeiten in den Trainingsdaten. Die Qualität der gelernten Zusammenhänge wird typischerweise auf der Basis von Validierungsdaten bewertet, um die Generalisierbarkeit des angelernten Modells auf neue, d.h. während des Trainings unbekannte Daten zu bewerten. Ein trainiertes ML-/DL-Modell kann auf ein Abbildungs-Tupel angewendet werden, um die Anteile von Topographiekontrast und/oder Materialkontrast in einem dem ML-/DL-Modell unbekannten Abbildungs-Tupel zu bestimmen. Ein erfolgreich trainiertes oder angelerntes ML-/DL-Modell, d.h. ein trainiertes ML-/DL-Modell mit guter Generalisierbarkeit, ist daher nach Abschluss der Trainingsphase in der Lage ihm unbekannte Daten, d.h. unbekannte Abbildungs-Tupel einer Probe, hinsichtlich Topographiekontrast und Materialkontrast beurteilen zu können.

Das Transformationsmodell kann ein generatives Modell umfassen. Das generative Modell kann ein tiefes generatives Modell umfassen. Im Folgenden wird als ein tiefes generatives Modell ein Modell verstanden, dessen Encoder und/oder Decoder mehr als zwei sequenzielle Schichten aufweisen. Typischerweise weist ein tiefes generatives Modell drei bis fünfundzwanzig hintereinander angeordnete Schichten des Encoders und/oder des Decoders auf. Es ist jedoch auch möglich, dass ein Encoder und/oder ein Decoder eines generativen Modells mehr als 100 sequenzielle Schichten aufweist.

Diskriminative Modelle können aus Eingangsdaten Ausgangsdaten erzeugen, generative Modelle können aus Eingangsdaten Ausgangsdaten erzeugen und können zusätzlich die Eingangsdaten am Modellausgang reproduzieren.

Das generative Modell kann ein neuronales Faltungs- und Entfaltungsnetzwerk umfassen. Ein neuronales Faltungs- und Entfaltungsnetzwerk wird im englischen Sprachgebrauch als CNN (Convolutional Neural Network) bezeichnet. Falls die Eingabedaten in ein generatives Modell Abbildungen bzw. Abbildungs-Tupel sind, die über eine räumliche Struktur verfügen, ist eine sinnvolle Operation für einzelne Schichten einer Encoder-Decoder-Architektur die Faltung. Lernbare Parameter sind in diesem Fall beispielsweise die Einträge (engl.: weights) der Filtermasken der einzelnen Faltungsschichten. Zur Erhöhung der Modellkomplexität werden die Faltungsergebnisse einer Schicht üblicherweise nichtlinear transformiert. Dazu wird der mittels diskreter Faltung ermittelte Input eines jeden Neurons in einer Faltungsschicht mit Hilfe einer Aktivierungsfunktion, d.h. etwa durch die Anwendung einer Sigmoid-Funktion (sig(t) =0.5·(1+tanh(t/2)) oder einer Rectified Linear Unit (ReLU, f(x) = max(o, x)) in den Output verwandelt. Die Verkettung von mehreren Faltungsschichten, die jeweils eine Aktivierungsfunktion umfassen, erlaubt das Erlernen komplexer Muster aus den bereitgestellten Daten für Erkennungsaufgaben (engl.: perception).

Die zumindest zwei Schichten des Encoders können zwei oder mehr Faltungsschichten (engl.: "convolutional layers") und Bündelungsschichten umfassen, und/oder die zumindest zwei Schichten des Decoders können zwei oder mehr Entfaltungsschichten (engl.: "deconvolutional layers") und Entbündelungsschichten umfassen. Bündelungsschichten werden im englischen Sprachgebrauch "pooling layers" oder "sub-sampling layers" genannt. Entbündelungsschichten werden in der englischsprachigen Literatur "de-pooling layers" oder "up-sampling layers" bezeichnet. Durch den Pooling-Effekt wird die Anzahl der Pixel zur Darstellung eines Objekts als Merkmal in einer Schicht verringert, gleichzeitig wird die Merkmalstiefe oder die Dimension in dem Encoder vergrößert. Die Merkmalstiefe wird auch als die Anzahl der Merkmale pro Schicht oder pro Kanal bezeichnet. Durch das Entbündeln oder durch das Erhöhen der Abtastrate (up- sampling) beim Durchgang von Daten eines Objekts durch den Decoder wird die Anzahl der Pixel zur Darstellung des Objekts als Merkmal in einer Schicht erhöht.

Die zumindest zwei Schichten des Encoders können die informationstragenden Merkmale durch eine Verringerung einer Pixel-Anzahl zur Darstellung einer Probenabbildung bestimmen. Die zumindest zwei Schichten des Encoders können die informationstragenden Merkmale durch eine Verringerung der räumlichen Dimension der Probenabbildungen bestimmen.

Die Probenabbildungen können Abbildungen von Fotomasken sein. Die Abbildungen von Fotomasken können gemessene und/oder simulierte Maskenabbildungen umfassen. Die gemessenen und/oder die simulierten Abbildungen können beispielsweise in Form einer zweidimensionalen Pixel-Matrix mit Grauwerten dargestellt werden.

Zum Erzeugen von simulierten Abbildungen der Probe wird letztere mit primären Partikeln beschossen und deren Wechselwirkung mit dem Material der Probe wird auf statistischer Basis berechnet (Monte Carlo Simulation). Für das Beispiel einer Fotomaske und eines Elektronenstrahls als primärer Teilchenstrahl werden dadurch die Anzahl und die Winkelverteilung der die Probe verlassenden SE und BSE auf probabilistischer Basis bestimmt. Die Wechselwirkung der primären Partikel als Funktion von deren Landeenergie ist modellmäßig gut verstanden, wodurch die Intensität und die Winkelverteilung der die Probe verlassenden sekundären Partikel, beispielsweise der SE und BSE, reproduzierbar berechnet werden kann.

Input- oder Eingabedaten in die Eingabeschicht eines DL-Modells, bzw. allgemein in ein Transformationsmodell, sind Bilder oder Abbildungen von zumindest zwei bzw. von jedem der vorhandenen Detektoren. In Analogie zu einem normalen Farbbild kann jeder Detektor als ein Farbkanal betrachtet werden. Die Größe des zweidimensionalen Pixelmatrix bestimmt zum einen den Aufwand zum Aufnehmen der Probenabbildungen bzw. zum Erzeugen der Trainingsdaten und zum Transformieren der zumindest zwei Abbildungen. Die Größen der Abbildungen oder Bilder sollte mindestens so groß gewählt werden, dass die oben beschriebenen nichtlokalen Topographieeffekte von dem DL- Modell erkannt und korrigiert werden können. Die nichtlokalen Effekte weisen Abmessungen im Bereich von 5 nm bis 20 nm auf. Als günstig haben sich Abbildungen erwiesen, die auf Scanbereichen von 200 nm x 200 nm basieren und einen Pixelabstand im Bereich von 1 nm bis 10 nm aufweisen. Das heißt, die Abbildungen der Proben weisen typischerweise Matrixgrößen im Bereich von 200 x 200 bis 20 x 20 Pixeln auf.

Der zumindest eine zusätzliche Parameter kann Abbildungs-Tupel umfassen, die unter verschiedenen Abbildungsbedingungen aufgenommen werden.

Die Anteile von Topographiekontrast und Materialkontrast variieren in Abhängigkeit der Bedingungen, die zum Abbilden der Probe eingesetzt werden. Zudem können die Abbildungsbedingungen an die zu analysierende Probe angepasst werden.

Die Abbildungsbedingungen können zumindest einen Parameter aus der Gruppe umfassen: eine Landeenergie der primären Partikel auf der Probe, einen Auftreffwinkel des primären Teilchenstrahls auf die Probe, einen Partikelstrom der primären Partikel auf der Probe, einen Arbeitspunkt des zumindest einen Detektors zum Detektieren der von der Probe ausgehenden sekundären Partikel, eine Objektiveinstellung eines Partikelrastermikroskops (etwa eines Rasterelektronenmikroskops), ein Potential eines Strahlführungsrohres (engl. liner tube), einen Druck, dem die zumindest zwei Detektoren ausgesetzt sind, oder einer Temperatur, der die zumindest zwei Detektoren ausgesetzt sind. Zudem können die Abbildungsbedingungen einen oder mehrere der oben angegebenen Systemparameter umfassen. Typischerweise trifft der primäre Teilchenstrahl senkrecht auf die Probe. Es ist aber auch möglich, einen anderen Auftreffwinkel zu wählen, etwa angepasst an die Topographie der Probe, z.B. entlang der Kanten von Pattern-Elementen von Fotomasken.

Die Landeenergie der primären Partikel kann einen Energiebereich von 2 eV bis 50 keV, bevorzugt 5 eV bis 10 keV, mehr bevorzugt 10 eV bis 3 keV, und am meisten bevorzugt 20 eV bis 1 keV umfassen. Der primäre Partikelstrom kann einen Bereich 1 pA bis 10 nA, bevorzugt 5 pA bis 2 nA, mehr bevorzugt 10 pA bis 500 pA, und am meisten bevorzugt 20 pA bis 100 pA umfassen. Die zumindest zwei Detektoren können in einer Hochvakuum-Umgebung angeordnet sein, die einen Druck $< 10^{-3}$ mbar, bevorzugt $< 3 \cdot 10^{-5}$ mbar, und am meisten bevorzugt $< 10^{-7}$ mbar aufweist. Aufgrund der für eine lokale chemischen Reparatur benötigten Prozessgase kann der Druck in der Hochvakuumkammer eines Rasterelektronenmikroskops (SEM) temporär ansteigen. Dadurch kann die Wahl der einsetzbaren Detektortypen eingeschränkt werden.

Zumindest einer der zumindest zwei Detektoren kann einen Energiefilter umfassen. Das Energiefilter kann das Anlegen eines elektrischen Feldes vor dem Eingang des zumindest einen Detektors ermöglichen. Dadurch können geladene Partikel in Richtung des Detektors beschleunigt oder abgebremst werden.

Die zumindest eine erste Abbildung kann eine von zumindest einem ersten Detektor unter einem ersten Raumwinkel aufgenommene Abbildung eines Probenbereichs umfassen und die zumindest eine zweite Abbildung der Probe kann zumindest eine zweite von zumindest einem zweiten Detektor unter einem zweiten Raumwinkel aufgenommene Abbildung des Probenbereichs umfassen, wobei der erste Raumwinkel vom zweiten Raumwinkel zumindest zum Teil verschieden ist.

Ein Probenbereich umfasst den Bereich einer Probenoberfläche, der von einem primären Partikelstrahl gescannt oder gerastert wird.

Die zumindest zwei Abbildungen können von zumindest zwei zumindest teilweise verschiedene Raumwinkel erfassende Detektoren gleichzeitig aufgenommen werden.

Die zumindest zwei Detektoren können in einer partikeloptischen Säule eines Partikelstrahlmikroskops angeordnet sein. Das Partikelstrahlmikroskop kann ein Rasterelektronenmikroskop (SEM) und die partikeloptische Säule kann eine elektronenoptische Säule umfassen. Zumindest ein erster Detektor kann am Ausgang der elektronenoptischen Säule angeordnet sein und zumindest ein zweiter Detektor kann in der elektronenoptischen Säule, d.h. als in-lens-Detektor, angeordnet sein.

Die zumindest zwei aufgenommenen Abbildungen der Probe können unter Verwendung zumindest eines ersten Detektors und zumindest eines zweiten Detektors aufgenommen werden, die sekundäre (SE) und rückgestreute Elektronen (BSE) detektieren und ein SE/BSE Verhältnis des zumindest einen ersten Detektors und das SE/BSE Verhältnis des zumindest einen zweiten Detektors können verschieden sein.

Der zumindest eine erste Detektor und der zumindest eine zweite Detektor können verschiedene BSE-Verteilungen bzw. verschiedene Anteile der BSE-Verteilung detektieren. Die BSE-Anteile des zumindest einen ersten und des zumindest einen zweiten Detektors unterscheiden sich in zumindest einem Parameter aus der Gruppe: Energieverteilung der BSE und Raumwinkelverteilung der BSE. Aus den zumindest zwei verschiedenen BSE-Verteilungen kann die lokale Materialzusammensetzung der Probe ermittelt werden. Mit Hilfe eines erfindungsgemäßen Verfahrens können relative Änderungen oder Unterschiede der Materialzusammensetzung einer Probe senkrecht zur Probenoberfläche, d.h. in z-Richtung und/oder bei einem Rastern des primären Teilchenstrahls über die Probe ermittelt werden, wenn diese geätzt wird. Ein erfindungsgemäßes Verfahren ist somit auf das Bestimmen der Materialzusammensetzung bzw. einer lokalen Änderung der Materialzusammensetzung eines gerasterten Probenbereichs gerichtet. Das beschriebene Verfahren ist jedoch nicht elementspezifisch, d.h. liefert nicht das bzw. die Elemente des gerasterten Probenbereichs.

Der primäre Partikelstrahl kann zumindest eine Partikelart aus der Gruppe umfassen: Elektronen, Ionen, Röntgen-Quanten, Gamma-Quanten oder Photonen aus dem extrem ultravioletten Wellenlängenbereich.

Die von der Probe ausgehenden Partikel können zumindest ein Element aus der Gruppe umfassen: Elektronen, Ionen, Röntgenquanten, und Photonen aus dem ultravioletten Wellenlängenbereich, Photonen aus dem tief ultravioletten Wellenlängenbereich, oder Photonen aus dem extrem ultravioletten Wellenlängenbereich.

Die Probe kann ein Element aus der Gruppe umfassen: eine Fotomaske, einen Stempel für die Nanoprägelithographie, einen Wafer, ein MEMS (Micro-Electro-Magnetic System), ein NEMS (Nano-Electro-Mechanical System), oder ein PIC (Photonic Integrated Circuit).

Das Aufnehmen der zumindest zwei Abbildungen der Probe kann umfassen: Bestrahlen eines Probenbereichs mit einem primären fokussierten Partikelstrahl zum Auslösen von sekundären Partikeln, die die Probe unter verschiedenen Raumwinkeln verlassen. Vorzugsweise kann das Aufnehmen der zumindest zwei Abbildungen der Probe umfassen: Bestrahlen eines Probenbereichs mit einem primären fokussierten Elektronenstrahl zum Auslösen von SE und BSE, die die Proben unter verschiedenen Raumwinkeln verlassen.

Während des Aufnehmens oder vor und nach dem Aufnehmen der zumindest zwei Abbildungen durch Bestrahlen der Probe mit dem primären fokussierten Partikelstrahl kann zumindest ein Präkursor-Gas in dem Probenbereich bereitgestellt werden, den der primäre fokussierte Partikelstrahl abtastet. Das zumindest eine Präkursor-Gas kann zumindest ein Element der Gruppe umfassen: ein Ätzgas, ein Abscheidegas, oder ein additives Gas.

Das erfindungsgemäße Verfahren kann ferner den Schritt aufweisen: Reparieren zumindest eines Defekts der Probe mittels einer lokalen chemischen Reaktion, die von dem primären fokussierten Partikelstrahl induziert wird. Im Falle eines fokussierten Elektronenstrahls als fokussierter Partikelstrahl induziert dieser in Abhängigkeit des eingesetzten Präkursor-Gases ein EBIE (electron beam induced etching) oder ein EBID (electron beam induced deposition).

Das Bestimmen des Topographiekontrasts und/oder des Materialkontrasts einer Abbildung kann umfassen: Bestimmen einer Abbildung, die im Wesentlichen keinen Topographiekontrastanteil aufweist.

Eine Probenabbildung, die keinen Topographiekontrastanteil aufweist, sondern vielmehr lediglich einen Materialkontrastanteil beinhaltet, ist maximal empfindlich zum Detektieren einer Änderung der lokalen Materialzusammensetzung der Probe. Eine Probenabbildung, die ausschließlich Materialkontrastinformation beinhaltet, ist somit bestmöglich als Stoppsignal eines lokalen chemischen Reparaturprozesses geeignet.

Der Ausdruck "im Wesentlichen" bedeutet hier - wie an anderen Stellen dieser Anmeldung - eine Angabe einer gemessenen Größe innerhalb der üblichen Fehlergrenzen, wobei zum Messen der Größe Messtechnik nach dem Stand der Technik eingesetzt wird.

Ein Computerprogramm kann Anweisungen zum Durchführen der Verfahrensschritte eines der oben angegebenen Aspekte aufweisen.

Nach einem weiteren Ausführungsbeispiel wird das der Erfindung zugrundeliegende Problem durch eine Vorrichtung nach Anspruch 17 gelöst. In einer Ausführungsform umfasst die Vorrichtung zum Bestimmen eines Topographiekontrasts und/oder eines Materialkontrasts einer Probe: (a) Mittel zum Bereitstellen zumindest zweier, zumindest teilweise unter verschiedenen Raumwinkeln bezogen auf die Probe aufgenommenen Abbildungen der Probe; und (b) Mittel zum Bestimmen des Topographiekontrasts und/oder des Materialkontrasts der Probe basierend auf den zumindest zwei Abbildungen.

Das Mittel zum Bestimmen kann eingerichtet sein zum Anwenden eines Entkopplungsmodells auf die zumindest zwei Abbildungen zum Bestimmen des Topographiekontrasts und/oder des Materialkontrasts der Probe.

Die Vorrichtung kann ferner zumindest einen ersten Detektor und zumindest einen zweiten Detektor zum Bereitstellen der zumindest zwei Abbildungen aufweisen, wobei der zumindest eine erste und der zumindest eine zweite Detektor jeweils sekundäre (SE) und rückgestreute Elektronen (BSE) detektieren, und wobei ein SE/BSE Verhältnis des zumindest einen ersten Detektors und das SE/BSE Verhältnis des zumindest einen zweiten Detektors voneinander verschieden sind. Die Bahnen oder Pfade der SE und/oder BSE können durch die den primären Teilchenstrahl fokussierende Objektivlinse beeinflusst werden. Falls dies der Fall ist, sind die Bahnen der SE und/oder der BSE stark von der kinetischen Energie der sekundären Teilchen abhängig.

Der erste Detektor kann in einer elektronenoptischen Säule der Vorrichtung angeordnet sein, und/oder der zweite Detektor kann in der elektronenoptischen Säule der Vorrichtung angeordnet sein. Der erste Detektor kann näher an der Probe angeordnet sein als der zweite Detektor. Dies bedeutet, beide Detektoren können als in-lens-Detektoren ausgeführt sein.

Die Raumwinkel der zumindest zwei Detektoren, die die zwei Abbildungen aufnehmen, können sich zum Teil überlappen bzw. überschneiden. Ein Detektor kann deshalb den anderen Detektor teilweise abschatten. Zudem ist es möglich, dass Komponenten einer Reparaturvorrichtung den Blickwinkel oder Raumwinkel eines oder beider Detektoren auf die Probe begrenzen. Ein teilweises Abschatten kann insbesondere für Detektoren auftreten, die in einer partikeloptischen Säule einer Reparaturvorrichtung eingebaut sind. Zudem können die Raumwinkel die die einzelnen Detektoren "sehen" bzw. abbilden, von den Systemeinstellungen der Reparaturvorrichtung abhängen, beispielsweise der Größe des elektrischen und magnetischen Felds, das die Objektivlinse der Reparaturvorrichtung erzeugt. Zudem ist es möglich, zwei oder mehr Abbildungen mit einem Detektor aufzunehmen, wobei für jede Abbildung ein anderer Teil der Detektionsfläche des Detektors abgedeckt wird.

Der zweite Detektor kann einen Energiefilter aufweisen. Das Energiefilter erzeugt vor dem Eingang des Detektors ein einstellbares elektrisches Feld. Damit können geladene sekundäre Partikel in Richtung des Detektors in definierter Weise beschleunigt oder abgebremst werden. Das Energiefilter des zweiten Detektors ermöglicht SE und BSE weitgehend zu separieren.

Das Energiefilter kann ausgebildet sein, ein Potential in einem Bereich von $\pm 0{,}05$ kV, bevorzugt $\pm 0{,}2$ kV, mehr bevorzugt $\pm 0{,}5$ kV, und am meisten bevorzugt $\pm 2{,}0$ kV zu erzeugen. Das Energiefilter kann eine Filterbreite < 400 eV, bevorzugt < 200 eV, und am meisten bevorzugt von < 100 eV bei einer Passenergie von 50 eV, bevorzugt 200 eV, mehr bevorzugt 500 eV, und am meisten bevorzugt 2000 eV aufweisen.

Die Vorrichtung kann eingerichtet sein, die Verfahrensschritte nach einem der oben angegebenen Aspekte auszuführen.

Das Mittel zum Anwenden eines Entkopplungsmodells kann eine dedizierte Hardware-Komponente zum Analysieren der zumindest zwei Abbildungen der Probe umfassen. Die dedizierte Hardware-Komponente kann zumindest ein Element aus der Gruppe umfassen: eine applikationsspezifische integrierte Schaltung (ASIC, application specific integrated circuit), eine im Feld programmierbare Gatteranordnung (FPGA, field programmable gate array), eine programmierbare logische Schaltung (PLD, programmable logic device), und eine Grafikprozessoreinheit (GPU, Graphics Processor Unit).

Viele Verfahren des maschinellen Lernens können für die Verwendung spezieller Recheneinheiten optimiert werden, um ihre Ausführung erheblich zu beschleunigen. Für DNN haben sich dabei besonders graphische Prozessoreinheiten (GPUs) als vorteilhaft erwiesen. Die berechenbare Abbildungsgröße ist typischerweise durch den verfügbaren Arbeitsspeicher der GPU begrenzt. Die in den Abbildungen von Fotomasken üblichen Bildbereiche (FOV, Field Of View) sind jedoch mitunter deutlich größer als eine für DNN mit aktuellen GPUs handhabbare Größe. Diese Problematik kann durch das Aufteilen des zu berechnenden Abbildungsbereichs in Teilbereiche gelöst werden. Dabei werden die Teilbereiche einer Abbildung einzeln berechnet. Dies gilt sowohl für das Training als auch für die Anwendung des Transformationsmodells auf eine zu analysierende bzw. zu bestimmende Abbildung. Die berechneten Teilabbildungen werden anschließend zu einem Gesamtbild bzw. einer Gesamtabbildung zusammengesetzt.

Die Vorrichtung kann ferner aufweisen: Mittel zum Trainieren eines Transformationsmodells mit einem Trainingsdatensatz.

Die Vorrichtung kann überdies ein Strahlführungsrohr (englisch: liner tube) umfassen, über welches das Potential der Elektronen innerhalb der Säule um einen vorgegebenen Wert geändert werden kann.

Schließlich kann die Vorrichtung ein Gasführungssystem und zumindest drei Gasspeicherbehälter umfassen. In den Gasspeicherbehältern kann zumindest ein Ätzgas, zumindest ein Abscheidegas und zumindest ein additives Gas gespeichert sein. Das Gasführungssystem ist ausgebildet, die in den Gasspeicherbehältern gespeicherten Präkursor-Gase in einem Probenbereich in einer einstellbaren Menge bereitzustellen, den der primäre Partikelstrahl abtastet.

## 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei

Fig. 1 ein schematisches Energiespektrum der Elektronen darstellt, die ein auf eine Probe auftreffender Elektronenstrahl erzeugt;

Fig. 2 die Raumwinkelverteilungen rückgestreuter Elektronen (BSE) für fünf verschiedene Elemente mit unterschiedlicher Kernladungszahl für zwei kinetische Energien des primären Elektronenstrahls wiedergibt;

Fig. 3 eine schematische Abbildung eines Maskenausschnitts zeigt, die einen hohen Anteil an Topographiekontrast und einen geringen Anteil an Materialkontrast aufweist;

Fig. 4 den Maskenausschnitt der Fig. 3 in einer Abbildung wiedergibt, die durch einen geringen Anteil an Topographiekontrast und einen hohen Anteil an Materialkontrast gekennzeichnet ist;

Fig. 5 ein Koordinatensystem wiedergibt, das von den Beiträgen Topographiekontrast und Materialkontrast einer Abbildung aufgespannt wird;

Fig. 6 das Koordinatensystem der Fig. 5 darstellt, in dem die Abbildungen der Figuren 3 und 4 eingetragen sind;

Fig. 7 schematisch das Rekonstruieren eines Materialkontrastanteils und eines Topographiekontrastanteils aus zumindest zwei Probenabbildungen mit Hilfe eines Entkopplungsmodells präsentiert;

Fig. 8 einen schematischen Schnitt durch eine Säule eines Rasterelektronenmikroskops zeigt, in der zwei Detektoren in unterschiedlichem Abstand zur Probe angeordnet sind;

Fig. 9 schematisch einen Schnitt durch die Raumwinkelverteilungen der von einer Probe ausgehenden und die beiden Detektoren der Fig. 8 erreichenden sekundären Teilchen illustriert;

Fig. 10 im oberen Teilbild einen schematischen Schnitt durch eine Maske mit einem Ruthenium-Substrat und einem Tantal-Pattern-Element präsentiert und im unteren Teilbild Signale der beiden Detektoren der Fig. 8 für simulierte Linien-Scans entlang der Kante des Pattern-Elements darstellt, sowie ein aus den Signalen der beiden Detektoren rekonstruiertes Signal wiedergibt, das im Wesentlichen nur Materialsignal-Informationen enthält;

Fig. 11     das aus den Signalen der beiden Detektoren der Fig. 8 rekonstruierte Signal der Fig. 10 als Vektoraddition der beiden Signale wiedergibt;

Fig. 12     ein Ablaufdiagramm einer pixelweisen Rekonstruktion der Materialkontrast- und/oder Topographiekontrast-Signalanteile aus zumindest zwei bestimmten Intensitäten der Detektoren der Fig. 8 präsentiert;

Fig. 13     ein Flussdiagramm zum Optimieren der Parameter eines empirischen Modells mit Hilfe einer kalibrierten Testprobe darstellt;

Fig. 14     schematisch ein generisches Deep Learning Modell in Form einer U-Net Architektur zeigt;

Fig. 15     die U-Net Architektur der Fig. 14 mit Eingabedaten zum Lösen des Problems der vorliegenden Anmeldung und Ausgabedaten illustriert, die in Form eines Materialkontrastbildes und eines Topographiekontrastbildes vorliegen;

Fig. 16     schematisch ein GAN (Generative Adversarial Network) zum Erzeugen von SEM-Bildern für Trainingszwecke veranschaulicht;

Fig. 17     schematisch ein GAN zum Anpassen der Parameter eines Simulations-Tools zum Ausführen von Monte Carlo Simulationen zum Erzeugen von SEM-Bildern für Trainingszwecke für ein generatives Deep Learning Modell illustriert;

Fig. 18     Teststrukturen für eine Fotomaske mit definierten Defekten zum Erzeugen von Trainingsdaten wiedergibt;

Fig. 19     LS- (Lines and Spaces) Strukturen mit definierten Defekten zum Erzeugen von Trainingsdaten präsentiert;

Fig. 20     Kontaktlochstrukturen zum Erzeugen von Trainingsdaten darstellt;

Fig. 21     die Kontaktlochstrukturen der Fig. 20 mit definierten Defekten zeigt;

Fig. 22     eine Tabelle angibt, in der die Variationsbereiche der definierten Defekte der Figuren 18 bis 21 zusammengefasst sind;

Fig. 23     schematisch den Betrieb einer ersten Ausführungsform eines Modells maschinellen Lernens veranschaulicht;

Fig. 24     schematisch den Betrieb eines zweiten Ausführungsbeispiels eines Modells maschinellen Lernens (ML-Modell) illustriert;

Fig. 25     schematische den Betrieb eines dritten Ausführungsbeispiels eines ML-Modells veranschaulicht;

Fig. 26     schematisch das Trainieren des ML-Modells der Fig. 23 darstellt;

Fig. 27     einen schematischen Schnitt durch eine Vorrichtung darstellt, die ein erfindungsgemäßes Verfahren und einen lokalen chemischen Probenreparaturprozess ausführen kann; und

Fig. 28     ein Flussdiagramm eines Verfahrens zum Bestimmen eines Topographiekontrastanteils und/oder eines Materialkontrastanteils einer Abbildung einer Probe angibt.

## 5. Detaillierte Beschreibung bevorzugter Ausführungsbeispiele

Im Folgenden werden derzeit bevorzugte Ausführungsformen eines erfindungsgemäßen Verfahrens und einer erfindungsgemäßen Vorrichtung zum Bestimmen eines Topographiekontrastanteils und/oder eines Materialkontrastanteils einer Abbildung einer Probe genauer erläutert. Das erfindungsgemäße Verfahren ist jedoch nicht auf die nachfolgend diskutierten Fotomasken als Probenbeispiele beschränkt. Vielmehr kann das erfindungsgemäße Verfahren und die erfindungsgemäße Vorrichtung zum Bestimmen des Topographiekontrast- und Materialkontrastanteils beliebiger mikrostrukturierter Proben eingesetzt werden. Im Folgenden wird eine erfindungsgemäße Vorrichtung am Beispiel eines modifizierten Rasterelektronenmikroskops diskutiert. Eine erfindungsgemäße Vorrichtung ist jedoch nicht auf das erläuterte Ausführungsbeispiel beschränkt. Neben Elektronen können auch andere geladene Teilchen und/oder hochenergetische Photonen zum Bestimmen des Topographiekontrastanteils und Materialkontrastanteils einer Probe eingesetzt werden. Ferner wird nachfolgend das erfindungsgemäße Verfahren am Beispiel zweier Detektoren erläutert, die sekundäre Teilchen aus unterschiedlichen Raumwinkeln detektieren. Das erläuterte Verfahren ist jedoch nicht auf den Einsatz von zwei Detektoren beschränkt. Vielmehr kann dieses mit einem und vorteilhaft für drei oder mehr Detektoren eingesetzt werden. Zudem kann ein erfindungsgemäßes Verfahren neben dem Signal, das von mehreren Detektoren herrührt, auch den detektierten Stromfluss ausnutzen, der bei elektrisch leitfähigen Proben über diese abfließt oder die momentan auf einer Probe vorhandene elektrische Ladung so miteinander zu verarbeiten, um mehr bzw. präzisere Informationen über die Probeneigenschaften zu erhalten.

Nachfolgend wird die Wechselwirkung von Partikelstrahlung mit einer Probe am Beispiel der Einwirkung eines Elektronenstrahls auf die Probe veranschaulicht. Im Detail wird das Auftreffen eines fokussierten Elektronenstrahls, der einen Bereich der Probe rastert, beschrieben. Dieser Probenbereich wird Gesichtsfeld bzw. im englischen field of view (FOV) genannt. Bei der Bestrahlung einer Probe mit den Elektronen eines Elektronenstrahls wechselwirken die Elektronen mit der Probe. Der Wechselwirkungsprozess des einfallenden Elektronenstrahls mit den Atomen der Probe generiert freie Elektronen in der Probe. Ein Teil der in dem Wechselwirkungsprozess erzeugten Elektronen kann die Probenoberfläche verlassen und kann mit einem oder mehreren Detektoren nachgewiesen werden und zum Erzeugen eines SEM-Bildes (scanning electron microscope) der Probenoberfläche benutzt werden.

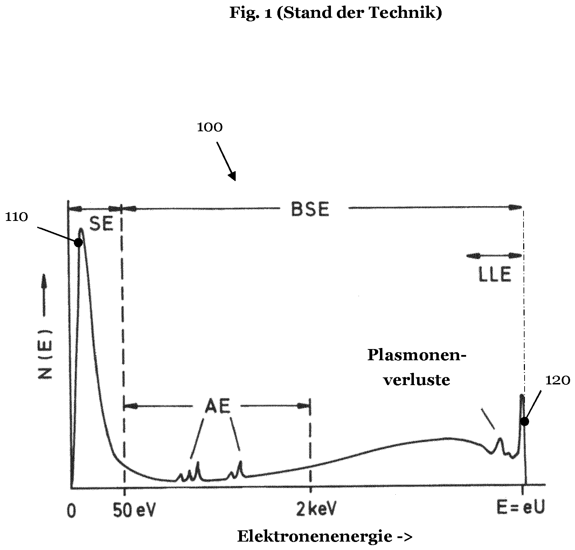

Das Diagramm 100 der Fig. 1 zeigt schematisch das Energiespektrum der von einem Elektronenstrahl in einer Probe erzeugten Elektronen. Diese Figur ist dem Buch "Scanning Electron Microscopy" des Autors L. Reimer entnommen. Das Energiespektrum der von einer Probe emittierten Elektronen wird in zwei Hauptgruppen eingeteilt. Niederenergetische Elektronen mit einer kinetischen Energie bis zu 50 eV (Elektronenvolt) werden Sekundärelektronen (SE) genannt. Alle anderen generierten Elektronen, deren spektrale Energieverteilung von 50 eV im Wesentlichen bis zur kinetischen Energie der Elektronen des einfallenden Elektronenstrahls reicht ($E = e \cdot U$, E ist die Landeenergie der Elektronen, e steht für die Elementarladung und U für die Potentialdifferenz, die Elektronen des Elektronenstrahls zu deren Beschleunigung durchlaufen), werden als rückgestreute Elektronen (BSE) bezeichnet.

Falls die Oberfläche einer Probe keine Oberflächenladungen aufweist, zeigt das Energiespektrum der Sekundärelektronen einen ausgeprägten Material- und/oder Topographie-spezifischen Peak 110 (SE-Peak 110) im Bereich einiger Volt. Im Energiebereich von ungefähr 50 eV bis ungefähr 2 keV können ebenfalls Material-spezifische Peaks in dem Spektrum rückgestreuter Elektronen auftreten, die durch Auger-Elektronen (AE) verursacht werden. Am oberen Ende des Energiespektrums rückgestreuter Elektronen zeigt sich ein elastischer Peak 120, der von Elektronen hervorgerufen wird, die im Wesentlichen mit der kinetischen Energie der einfallenden Elektronen, d.h. deren Landeenergie, von der Probenoberfläche reflektiert werden (BSE-Peak 120). Unterhalb dieses Peaks 120 schließt sich der sogenannte LLE-(Low Loss Electron) Bereich an, in den rückgestreute Elektronen fallen, deren Energie typischerweise 10 eV bis 100 eV geringer als die kinetische Energie der einfallenden Elektronen ist. Der LLE-Bereich umfasst auch den Bereich der Plasma-Anregung (plasmon losses), so dass in diesem Spektralbereich relativ wenig rückgestreute Elektronen die Probenoberfläche verlassen.

Dem Diagramm 100 ist zu entnehmen, dass ein Detektor ohne Energiefilter immer sowohl SE als auch BSE detektiert. Aus der Fig. 1 ist ferner zu erkennen, dass die niederenergetischen SE weitaus zahlreicher sind als die mit größerer kinetischer Energie ausgestatteten BSE. Die SE werden vorwiegend an lokalen Probenerhöhungen, etwa entlang von Kanten emittiert. Deshalb erscheinen diese in einer Probenabbildung heller als eine Probenoberfläche. Die SE tragen deshalb hauptsächlich zum Topographiekontrast einer mit einem fokussierten Elektronenstrahl aufgenommenen Probenabbildung bei.

Die SE können durch Erzeugen eines elektrischen Feldes entsprechender Polarität so weit abgebremst werden, dass diese einen Detektor nicht mehr erreichen können. Die Intensität eines derart gefilterten SEM-Bildes wird dadurch drastisch kleiner, tragen doch die zahlreichen SE nicht mehr zur Bildentstehung bei. Die resultierende Abbildung beinhaltet jedoch noch immer das breite Spektrum der BSE und den Peak 120 von im Wesentlichen elastischer Streuung.

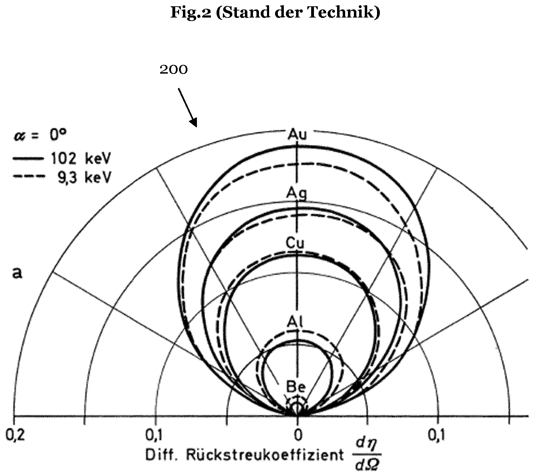

Das Diagramm 200 der Fig. 2 zeigt den differenziellen Rückstreukoeffizienten der von verschiedenen Elementen erzeugten BSE für zwei verschiedene kinetische Energien der Elektronen des auftreffenden Elektronenstrahls. Die einfallenden Primärelektronen (PE) werden im Feld der Atomkerne elastisch gestreut. Die Ablenkung der primären Elektronen am Atomkern ist umso stärker, desto höher deren positive Ladung ist. Die Fig. 2 gibt die Verteilungen für die Elemente Beryllium (Be), Aluminium (Al), Kupfer (Cu), Silber (Ag) und Gold (Au) für zwei Primärenergien wieder. Der Anteil im Wesentlichen elastisch rückgestreuter Elektronen, d.h. die Höhe des BSE-Peaks 120, hängt vom Material der Probe ab, das der primäre fokussierte Elektronenstahl bestrahlt.

Wie in Fig. 2 illustriert, folgt die Winkelverteilung der Strahlstärke der BSE näherungsweise einer Kosinus-Verteilung. Diese Gesetzmäßigkeit macht sich die vorliegende Anmeldung zunutze, um Abbildungen von Proben zu erzeugen, die ein vorgegebenes Verhältnis von Topographiekontrast und Materialkontrast aufweisen. Insbesondere wird diese Gesetzmäßigkeit ausgenutzt, um Abbildungen von Proben zu generieren, die im Wesentlichen ausschließlich Materialkontrast aufweisen. Die Winkelverteilung der BSE ändert sich kaum als Funktion der kinetischen Energie der PE.

Nachfolgend wird ein empirisches Modell als ein erstes Ausführungsbeispiel zum Bestimmen eines Topographiekontrastbeitrags und eines Materialkontrastbeitrags einer Probenabbildung beschrieben.

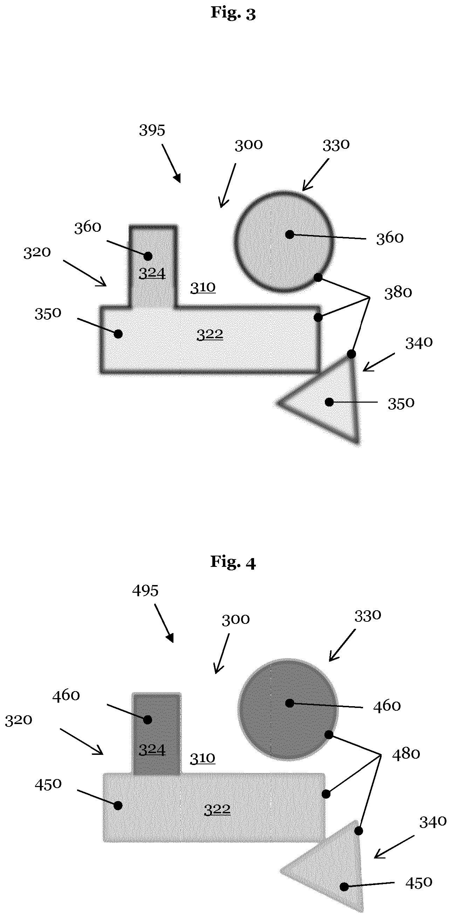

Die Abbildung 395 der Fig. 3 zeigt schematisch einen Ausschnitt einer Probe 300. Die Probe 300 kann eine fotolithographische Maske 300 sein. Auf dem Maskensubstrat 310 der beispielhaften Maske 300 sind drei Pattern-Elemente 320, 330 und 340 angeordnet. Das Pattern-Element 320 umfasst zwei miteinander verbundene rechteckige Strukturen 322 und 324, die an einer Seite miteinander verbunden sind. Das zweite Pattern-Element 330 weist eine kreisförmige Oberfläche auf und das dritte Pattern-Element 340 weist eine dreieckförmige Struktur auf. Der Teil 322 des ersten Pattern-Elements 320 und des dreieckförmigen Pattern-Elements 340 weisen ein erstes Material 350 auf. Ferner weisen das runde Pattern-Element 330 und der Teil 324 des ersten Pattern-Elements 320 eine zweite Materialzusammensetzung 360 auf. In dem in der Fig. 3 angegebenen Beispiel führt das erste Material 350 zu einer geringeren Intensität in der Abbildung 395, dargestellt durch den helleren Grauton, verglichen mit dem zweiten Material 360, das sich durch einen etwas dunkleren Grauton in der Abbildung der Maske 300 abzeichnet. Daraus kann geschlossen werden, dass das Material 360 eine größere Kernladungszahl aufweist als das Material 350 der Maske 300. Der erste Teil 322 des ersten Pattern-Elements 320 und das zweite Pattern-Elements 330 können mit Hilfe eines Partikelstrahl-induzierten Abscheideprozesses auf das Maskensubstrat 310 deponiert werden, beispielsweise um ein fehlendes 330 und/oder ein teilweise fehlendes Pattern-Element 324 zu erzeugen.

Durch den breiten dunklen Rand 380 der Pattern-Elemente 320, 330, 340 der Maske 300 wird in der Abbildung 395 veranschaulicht, dass diese neben dem Materialkontrast 350, 360 einen großen Topographiekontrastbeitrag 380 aufweist. Ein verhältnismäßig großer Topographiekontrastbeitrag 380 der Abbildung 395 zeigt an, dass der Detektor, der die SE und BSE detektiert hat, auf deren Basis die Abbildung 395 generiert wurde, einen größeren Winkel bezüglich der Strahlachse des primären Elektronenstrahls aufweisen soll.

In der Fig. 3, wie in den nachfolgenden Figuren 4 bis 6 ist zu beachten, dass die Abbildungen keine Messdaten von Fotomasken wiedergeben, sondern vielmehr lediglich dazu dienen, die Prinzipien der vorliegenden Anmeldung zu erläutern. Ferner sei darauf hingewiesen, dass in den illustrativen Figuren 3 bis 6 hell und dunkel jeweils dunkel und hell in den nachfolgenden Figuren entsprechen. Diese Vertauschung wird hier lediglich aus Gründen leichterer Darstellung auf weißem Hintergrund vorgenommen.

Die Abbildung 495 der Fig. 4 wiederholt die Abbildung 395 der Fig. 3 jedoch mit einem anderen Materialkontrast 450, 460 und Topographiekontrast 480 sowie deren Verhältnis. Der Rand 480 bzw. die Kanten 480 sind in der Abbildung 495 deutlich weniger präsent als in der Abbildung 395 der Fig. 3. Umgekehrt ist der Unterschied in den Graustufen 450, 460 deutlich ausgeprägter, wiederum verglichen mit der Abbildung 395 der Fig. 3. Die SE/BSE Verhältnisse der Abbildungen 395 und 495 sind deutlich verschieden. Dies bedeutet, beim Aufnehmen der Abbildung 495 ist ein verhältnismäßig kleinerer Winkel des Detektors zur Strahlachse des primären Elektronenstrahls angenommen als beim Detektieren der Abbildung 395.

Indem die beiden Abbildungen 395 und 495, die unter verschiedenen Winkeln bzw. Raumwinkeln bezogen auf die Strahlachse des primären Partikelstrahls aufgenommen werden, in Kombination betrachtet werden, d.h. in geeigneter Weise miteinander verknüpft werden, kann der Rand 380, 480 der Pattern-Elemente 320, 330, 340 der Maske 300, d.h. der Topographiekontrastbeitrag in den Abbildungen 395, 495 eliminiert werden. Dadurch kann eine Abbildung generiert werden, die im Wesentlichen nur Materialkontrast aufweist.

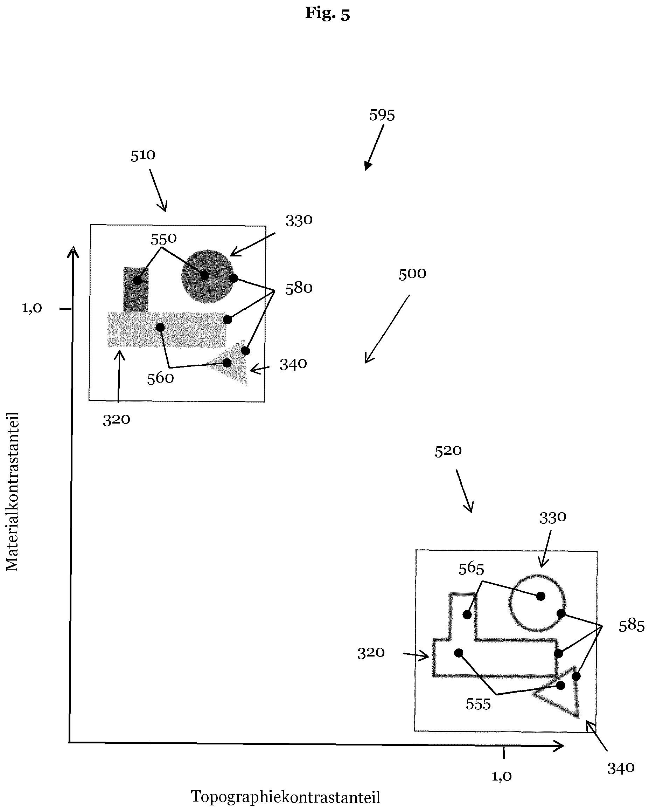

Das Diagramm 595 der Fig. 5 präsentiert ein Koordinatensystem 500, das durch eine Topographiekontrastkomponente und eine Materialkontrastkomponente einer Probenabbildung aufgespannt werden. Dies bedeutet, die Achsen des Koordinatensystems 500 separieren den Topographiekontrast-Inhalt bzw. die Topographiekontrast-Intensität und den Materialkontrast-Inhalt oder die Materialkontrast-Intensität gänzlich. In dem beispielhaften Koordinatensystem 500 der Fig. 5 ist der Topographiekontrast auf der Abszisse und der Materialkontrast auf der Ordinate aufgetragen. Das Teilbild 520 veranschaulicht den Ausschnitt der Maske 300, wenn ausschließlich die Topographiekontrast-Intensität 585 der Pattern-Elemente 320, 330, 340 der Maske 300 zur Abbildungsgenerierung beiträgt. Der Beitrag, der von den verschiedenen Materialzusammensetzungen 350, 360 der Pattern-Elemente 320, 330, 340 der Maske 300 herrührt, der in der Abbildung 395 der Fig. 3 durch verschiedene Graustufen illustriert ist, ist verschwunden.

Es wird an dieser Stelle nochmals auf den schematischen Charakter der Abbildungen 395, 495, 510 und 520 hingewiesen. In einer realen Abbildung der auf dem Maskensubstrat 310 vorhandenen Pattern-Elemente 320, 330, 340 würden deren Kanten heller erscheinen, verglichen mit der Oberfläche des Maskensubstrats 310 und den Oberflächen der Pattern-Elemente 320, 330, 340.

Das Teilbild 510 veranschaulicht den Ausschnitt der Maske 300, wenn ausschließlich die Materialkontrast-Intensität 550, 560 der Maske 300 zur Erzeugung der Abbildung beiträgt. Die Kanten 580 der Pattern-Elemente 320, 330, 340 sind nicht länger durch eine Intensitätsänderung im Teilbild 510 hervorgehoben. Ein Anteil, den die Topographie der Maske 300 zur Intensitätsverteilung der Abbildung des Teilbildes 510 beiträgt, ist in dem Teilbild nicht länger sichtbar. Dies bedeutet, das Teilbild 510 weist keinen Topographiekontrastbeitrag auf. Umgekehrt werden die unterschiedlichen Materialzusammensetzungen 550, 560 der Pattern-Elemente 320, 330, 340 der Maske 300 im Teilbild 510 bestmöglich sichtbar.

Die Teilbilder 510 und 520 zeigen den Ausschnitt der Maske 300, wenn zu deren Abbildung lediglich die Topographie der Maske 300 (Teilbild 520) bzw. deren Materialkomposition (Teilbild 510) beiträgt. Das Messen der Teilbilder 510 und 520 ist schwierig. Die Selektion der von der Maske 300 ausgehenden SE, die vorwiegend Topographie-Information tragen, ist nicht möglich, da der Beitrag der hochenergetischen BSE zur Bildgenerierung nicht eliminiert werden kann. In dem Teilbild 520 des Diagramms 595 ist die Topographie der Probe, d.h. der Maske 300 als Abbildung des Randes 380 und damit der Kanten der Pattern-Elemente 320, 330, 340 angegeben. Der Rand 380 der Pattern-Elemente 320, 330, 340 ist jedoch identisch zum Höhenprofil der Maske 300, so dass das Teilbild 520 die Topographie oder das Höhenprofil bzw. das Profil der Höhenänderung der Maske 300 wiedergibt.

Der Materialkontrastanteil 450, 460, 550, 560 bei der Entstehung einer Abbildung der Maske 300 bzw. allgemeiner einer Probe 300 kann durch das Anordnen des Detektors, der die sekundären Partikel detektiert, um den primären Partikelstrahl herum erhöht werden. Zudem kann durch Erzeugen eines elektrischen Felds, das eine Potentialdifferenz von 50 eV entsprechender Polarität aufweist, vor dem Detektor verhindert werden, dass SE, die eine kinetische Energie kleiner 50 eV aufweisen, in den Detektor gelangen. Überdies kann durch ein stärkeres elektrisches Feld ein Teil der niederenergetischen BSE vom Eintritt in den Detektor abgehalten werden. Es ist jedoch technisch nicht möglich, das Spektrum der sekundären Partikel so aufzuteilen, dass ausschließlich die BSE des Peaks 120 den Detektor erreichen. Ein breiter Hintergrund teilweise inelastisch gestreuter BSE verhindert das Aufnehmen einer Probenabbildung die lediglich Materialkontrast-Intensität wiedergibt. Zudem unterliegen BSE mit kleiner werdendem Polarwinkel zunehmend größeren Abschattungseffekten, die einen Topographiekontrastbeitrag in der entsprechenden Abbildung erzeugen.

Es ist jedoch möglich, die Teilbilder 510 und 520, die reinen Topographiekontrast und reinen Materialkontrast darstellen, durch Ausführen entsprechender Simulationen zu generieren. In Monte Carlo Simulationen wird auf statistischer Basis die Wechselwirkung der primären Partikel (PE) mit dem Material des Maskensubstrats 310 und der Materialzusammensetzung sowie der Topographie der Pattern-Elemente 320, 330, 340 simuliert. Aus den Resultaten dieser Simulationen können Bilder generiert werden, zu deren Intensitätsverteilung lediglich die SE beitragen, die Topographiekontrast-Information tragen. Ferner können aus den Simulationsdaten Abbildungen generiert werden, zu deren Erzeugung lediglich BSE des Peaks 120 beitragen. In der Simulation kann die Winkelverteilung der BSE, der zur Bildentstehung beitragen soll, in einfacher Weise gewählt werden. Diese aufwändigen Simulationen können von einer speziell für diesen Zweck ausgelegten Recheneinheit ausgeführt werden.

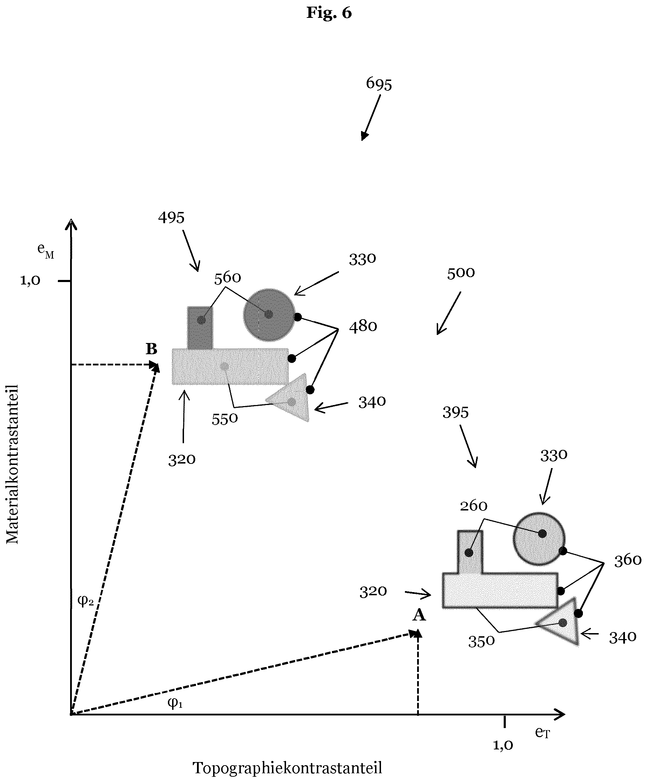

Das Diagramm 695 der Fig. 6 gibt nochmals das Koordinatensystem 500 der Fig. 5 wieder. In diesem Koordinatensystem 500 werden nun die Abbildungen 395 und 495 des Ausschnitts der Maske 300 eingetragen. Wie im Kontext der Figuren 3 und 4 erläutert, weist die Abbildung 395 einen großen Beitrag der Maskentopographie 380 zu der Intensitätsverteilung der Abbildung 395 auf. Die Abbildung 395 liegt deshalb in der Nähe der Achse, die den Beitrag der Topographie zur Intensitätsverteilung der Abbildung 395 beschreibt. Hingegen trägt in der Abbildung 495 der Materialkontrast 450, 460 überwiegend zur Intensitätsverteilung der Abbildung 495 bei. Folglich liegt die Abbildung 495 in der Nähe der Achse des Koordinatensystems 500, die den Materialkontrastbeitrag zur Bildgenerierung beschreibt.

Aus zwei Abbildungen, die eine Probe 300, etwa die Fotomaske 300, die diese unter verschiedenen Raumwinkeln aufgenommen darstellen, können die Beiträge der Probentopographie und des Probenmaterials extrahiert werden. Eine Fotomaske 300 weist Pattern-Elemente 320 und 350 und somit eine nicht plane Oberfläche auf. Bei einer Probe, die eine ebene Oberfläche aufweist, müssen die verschiedenen Raumwinkel verschiedene Winkel bezüglich des Primärstrahls aufweisen.

In dem Koordinatensystem 500 können die Abbildungen A, 395, und B, 495 durch eine Linearkombination von Vektoren $e_T$ der Topographiekontrastanteilsachse (T-Achse) und $e_M$ der Materialkontrastanteilsachse (M-Achse) dargestellt werden:

$$A = a_1 \cdot e_T + a_2 \cdot e_M$$

und

$$B = b_1 \cdot e_T + b_2 \cdot e_M \, ,$$

bzw. in Matrixschreibweise

$$\begin{pmatrix} A \\ B \end{pmatrix} = \begin{pmatrix} a_1 & a_2 \\ b_1 & b_2 \end{pmatrix} \cdot \begin{pmatrix} e_T \\ e_M \end{pmatrix} = T \cdot \begin{pmatrix} e_T \\ e_M \end{pmatrix}$$

Nach Bestimmen der Parameter bzw. Koeffizienten $a_1$, $a_2$, $b_1$ und $b_2$ können die Topographiekontrast- und Materialkontrastbeiträge der Abbildungen A bzw. 395 und B bzw. 495 ermittelt werden. Die beiden Abbildungen A bzw. 395 und B bzw. 495 liefern vier Größen $A_T$, $A_M$, $B_T$ und $B_M$, die ein Festlegen der vier Parameter bzw. Koeffizienten $a_1$, $a_2$,

$b_1$ und $b_2$ der Transfermatrix T ermöglichen.

Alternativ können die Abbildungen A bzw. 395 und B bzw. 495 durch eine Drehung des Koordinatensystems um einen Winkel $\varphi 1$ und $\varphi 2$ auf dessen T-Achse bzw. M-Achse abgebildet werden. Die Drehmatrix ist gegeben durch:

$$T = \begin{pmatrix} \cos \varphi_1 & \sin \varphi_1 \\ \cos \varphi_2 & \sin \varphi_2 \end{pmatrix}$$

Nach Ermitteln der Drehwinkel $\varphi 1$ und $\varphi 2$ können die Beiträge der Topographie 380, 480 und des Materials 350, 360, 450, 460 der Probe 300 ermittelt werden.

Wie oben ausgeführt, ist es eine der Zielsetzungen der vorliegenden Anmeldung, eine Änderung des Materialkontrastbeitrags einer Probenabbildung 395, 495 zum Ableiten eines Stoppsignals für einen lokalen chemischen Reparaturprozess eines Probendefekts zu verwenden. Hierfür ist es günstig, die Abbildung 495, die den größeren Materialkontrastbeitrag aufweist, zu verwenden. Die Signaländerung beim Detektieren eines Übergangs des primären Partikelstrahls von einer ersten Probenschicht zu einer zweiten Probenschicht mit einer verschiedenen Materialzusammensetzung ist größer als für die zweite Abbildung 395. Dies ermöglicht es, den Stoppzeitpunkt der lokalen chemischen Reaktion mit größerer Präzision zu ermitteln. Die Abbildung 495, die diese Voraussetzung erfüllt, ist die Abbildung, die mit einem Detektor aufgenommen wurde, der einen großen Anteil im Wesentlichen antiparallel zum primären Partikelstrahl reflzierter BSE aufweist. Reicht der Unterschied im Materialkontrastanteil der Abbildung 495 hierfür nicht aus, ermöglichen die in der vorliegenden Anmeldung beschriebenen Verfahren das Erzeugen von Probenabbildungen, die im Wesentlichen ausschließlich den Materialkontrastanteil wiedergeben.

Die oben skizzierte Darstellung der Entkopplung in Materialkontrast- und Topographiekontrastanteile mittels linearer Algebra ist idealisiert. Vorzugsweise werden hierfür komplexere empirische Modelle oder ein Transformationsmodell eingesetzt.

Im Folgenden werden die theoretischen Grundlagen der vorliegenden Anmeldung kurz umrissen. Deren Grundannahme ist, dass eine Abbildung einer Probe bzw. deren Bildsignal für eine nicht aufgeladene Probe auf jedem Detektor durch eine Kombination von (a) Topographiekontrast (englisch: z-map bzw. "Höhenkarte") und (b) Materialkontrast (Element- bzw. Materialzusammensetzung, Kristallstruktur, etc.) zusammengesetzt ist.

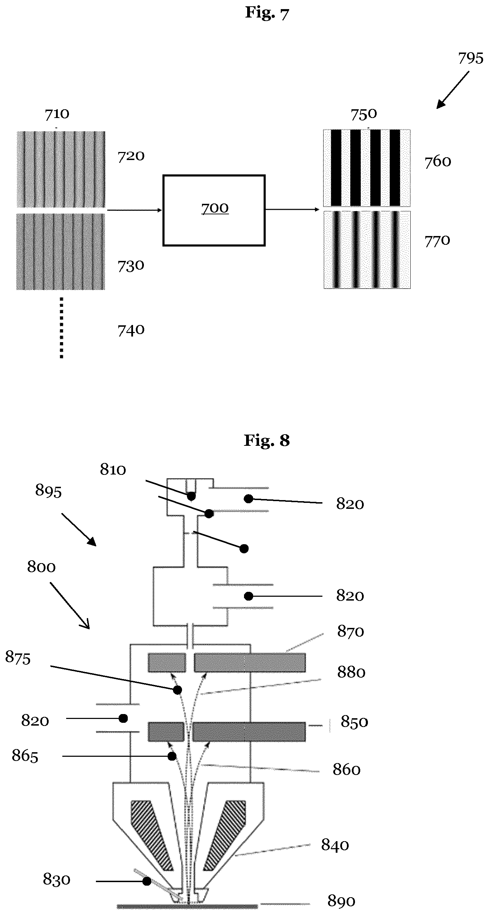

Das Diagramm 795 der Fig. 7 illustriert den Prozess des Trennens von Materialkontrast- und Topographiekontrastanteilen in Abbildungen mit Hilfe eines Entkopplungsmodells 700. Das Entkopplungsmodell 700 kann ein empirisches Modell und/oder ein Transformationsmodell umfassen. Dem Entkopplungsmodell 700 werden als Eingabedaten 710 Bilder 720, 730, ggf. 740 bereitgestellt und das Entkopplungsmodell 700 transformiert diese Bilder in ein Materialkontrastbild 760 und ein Topographiekontrastbild oder Höhenprofilbild 770 und stellt diese an seinem Ausgang 750 bereit.

Zum Aufnehmen der Bilder 720, 730, 740 kann ein primärer Elektronenstrahl über eine Probe gescannt werden und mit zwei oder mehr Detektoren können die von der Probe ausgehenden sekundären Partikel aufgenommen werden. Wird ein fokussierter Elektronenstrahl, als Beispiel eines geladenen fokussierten Teilchenstrahls, über die Probe gerastert, werden an jedem Rasterpunkt mit gewisser Wahrscheinlichkeit Elektronen, als Beispiel sekundärer Teilchen oder Partikel, mit unterschiedlichen Energie- und Winkelverteilungen generiert. Diese Verteilungen $\Psi$ oder Emissions-verteilungen $\Psi$ hängen von der lokalen Topographie und der Materialzusammensetzung der Probe ab und sind energie-abhängig:

$$\Psi(E, \phi)$$

Das Diagramm 895 der Fig. 8 zeigt schematisch einen Schnitt durch eine Säule eines Rasterelektronenmikroskops (SEM) 800. Das SEM 800 weist eine Elektronenquelle 810 und Anschlüsse 820 zum Erzeugen eines Unterdrucks bzw. Vakuums in der Säule des SEMs 800 auf. Ferner weist das SEM 800 ein Gasbereitstellungssystem 830 zum Bereitstellen eines Präkursor-Gases auf einer Probe 890 bzw. einer Fotomaske 890 auf. Das Objektiv 840 oder die Objektivlinse 840 fokussiert den Elektronenstrahl bzw. den primären Elektronenstrahl, der in der Fig. 8 nicht wiedergegeben ist, auf die Probe 890. Ein Teil der von der Probe 890 generierten sekundären Partikel werden von dem ersten Detektor 850 und dem zweiten Detektor 870 aufgenommen. Über die Trajektorie 865 erreichen vorwiegend sekundäre Elektronen (SE) 860 den ersten Detektor 850. Über den Pfad 875 treffen hauptsächlich rückgestreute Elektronen (BSE) 880 auf den zweiten Detektor 870.

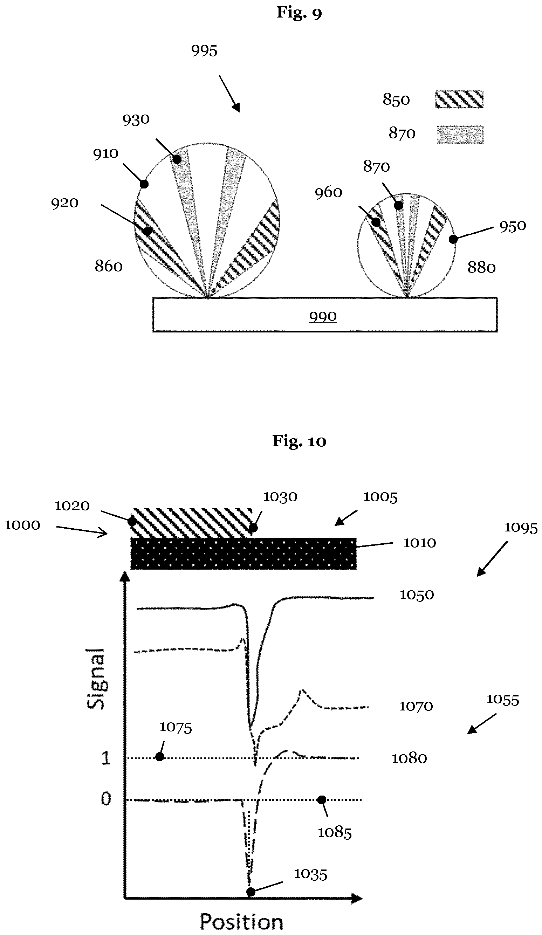

Wie in den Figuren 8 und 9 veranschaulicht, detektiert jeder Detektor 850, 870 sekundäre Partikel, d.h. SE 860 und BSE 880 aus einem unterschiedlichen Ausschnitt dieser Verteilungen mit den Akzeptanzfunktionen $D_{1,2}(E, \phi)$, d.h. einen eigenen Winkelbereich in Abhängigkeit der kinetischen Energie der sekundären Teilchen. Dabei nimmt $D_{1,2}(E, \phi)$ nur die Werte 0 oder 1 an, nämlich den Wert 0, wenn das sekundäre Partikel den entsprechenden Detektor 850, 870 nicht trifft und 1, falls das sekundäre Partikel den Detektor 850 bzw. 870 trifft. Die Signale $I_{1,2}$ der beiden Detektoren 850, 870 sind dann das Integral aus der Akzeptanzfunktion $D_{1,2}(E, \phi)$ multipliziert mit der Emissionsverteilung $\Psi(E, \phi)$:

$$I_{1,2} = \int_0^{e \cdot U} \int_{-\frac{\pi}{2}}^{+\frac{\pi}{2}} D_{1,2}(E, \phi) \Psi(E, \phi)\, dE d\phi,$$

dabei wird zum einen über einen Halbkreis über der Probenoberfläche und die kinetische Energie der sekundären Teilchen, die von 0 bis zu $E_{max} = e \cdot U$ reicht, integriert. Die Emissionswinkelverteilung hängt hauptsächlich von der Landeenergie der Elektronen des primären Elektronenstrahls, sowieso nebensächlich von der Spotgröße bzw. der Fleckgröße und des Konvergenzwinkels des primären Elektronenstrahls ab. In dem in der Fig. 8 dargestellten Beispiel sind die Detektoren 850 und 870 rotationssymmetrisch um den Elektronenstrahl angeordnet.

Das Diagramm 995 der Fig. 9 präsentiert die Detektorakzeptanzbereiche für SE 860 und BSE 880 der Anordnung der beiden Detektoren 850 und 870 der Fig. 8. Der Kreis 910 entspricht der Winkelverteilung der SE 860 und die hervorgehobenen Bereiche 920 und 930 geben die Winkelakzeptanzbereiche der Detektoren 850 sowie 870 an. Der Kreis 950 illustriert die Winkelverteilung der BSE 880 und der Ausschnitt 960 (970) veranschaulicht den Akzeptanzwinkelbereich des Detektors 850 (870). Die Detektorakzeptanzfunktionen $D_{1,2}(E, \phi)$, d.h. die Ausschnitte 920, 930, 960 und 970 hängen von der Landenergie der primären Elektronen auf der Probe, dem Arbeitsabstand (d.h. dem Abstand der Probe 890 von dem Objektiv 840), dem Konvergenzwinkel des primären Elektronenstrahls sowie natürlich den Positionen der Detektoren 850 und 870 innerhalb der Säule des SEM 800 ab. Der erste Detektor 850, dessen Abstand zur Probe 890 geringer ist als der Abstand des zweiten Detektors 870, "sieht" sekundäre Teilchen, die von der Probe 890 unter einem größeren Polarwinkel emittiert werden, verglichen dem zweiten Detektor 870. Die Detektorakzeptanzfunktionen $D_{1,2}(E, \phi)$ können mit Hilfe elektronenoptischer Simulationen bestimmt werden.

Der Fig. 9 ist zu entnehmen, dass die Detektoren 850, 870 unterschiedliche Anteile von BSE 880 und SE 860 sowie unterschiedliche Polarwinkelbereiche 920, 930, 960, 970 aufnehmen. Daher ist es mit zwei oder mehr Detektoren 850, 870 möglich, die lokale Emissionsverteilung $\Psi(E, \phi)$ anzunähern, und dadurch Informationen über die Topographie und Materialzusammensetzung der Probe 890 zu erlangen.

In den nachfolgend beschriebenen Beispielen wird nicht die Emissionsverteilung bestimmt, sondern entweder ein empirisches Modell an die zu analysierende Probe angepasst und anschließend parametrisiert oder ein trainiertes Transformationsmodell wird eingesetzt, um Materialkontrast- und Topographiekontrastanteile einer oder mehrerer Abbildungen zu trennen.

Zunächst wird das Bestimmen eines lokalen Materialsignals, d.h. einer lokalen Abbildung der Probe 890 beschrieben, die im Wesentlichen Materialkontrastanteile aufweist. In einer binären Probe 890, wie etwa einer binären Fotomaske, muss nur zwischen dem Material der absorbierenden Pattern-Elemente und dem Maskensubstrat unterschieden werden.

In einer ersten Ausführungsform werden zum Ermitteln eines lokalen Materialsignals mit Hilfe der Detektoren 850 und 870 an einem Punkt, die von der Probe 890, bzw. der Maske 890 im in Rede stehenden Beispiel, emittierten sekundären Partikel aufgenommen, d.h. es werden pixelweise Detektorsignale zum Bestimmen eines lokalen Materialsignals der Maske 890 aufgenommen. Die Signale von zwei Detektoren 850, 870, im allgemeinen Fall Signale von k Detektoren ($k \geq 2$), aufgenommen an einem Punkt $(i,j)$ der Probe 890, werden mittels einer Funktion verarbeitet, um ein Materialsignal $S(i, j)$ der Probe 890 an der Stelle $(i,j)$ zu erzeugen. In einfachster Form kann eine Linearkombination der verschiedenen Detektorsignale $I_k$ verwendet werden. Es ist aber auch möglich, andere Funktionen aus den Signalen $I_k$ der $k$ Detektoren zu verwenden. Z.B. könnten neue Signalfeatures der k Detektoren als Produkte einzelner Detektorsignale generiert werden.

Falls das empirische Modell eine Linearkombination der Signale $I_k$ der Detektoren 850 und 870 aufweist, weist das Materialsignal, das Materialkontrastsignal oder die Materialkontrast-Signalfunktion $S(i, j)$ der Probe 890 an der Stelle $(i,j)$ die Form auf (k=2):

$$S(i, j) = \sum_k a_k\, I_k(i, j) + a_0,$$

wobei $a_o$ eine Normierungskonstante ist.

Die Koeffizienten der Funktion bzw. die Parameter des empirischen Modells können so kalibriert werden, daß die Funktion bzw. das empirische Modell den Wert 0 für das absorbierende Material der Pattern-Elemente und den Wert 1 für Material des Maskensubstrats annimmt oder umgekehrt.

Ein empirisches Modell für eine spezifische Materialkombination der Probe 890 und einen spezifischen Arbeitspunkt kann über folgende Prozedur gefunden werden:

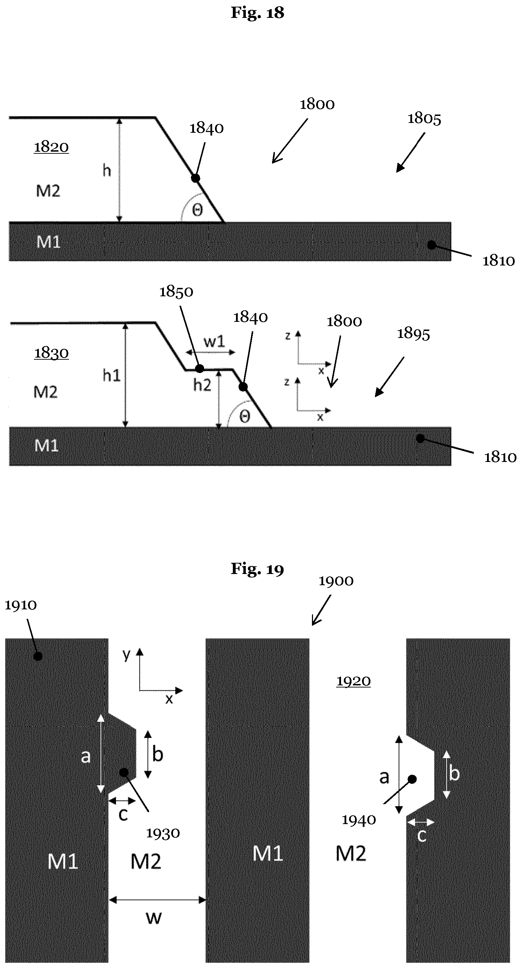

Im ersten Schritt werden mit jedem der k Detektoren an verschiedenen Stellen einer kalibrierten Testprobe, die zumindest eine kalibrierte Teststruktur, mit absorbierenden Teststrukturen $T_A$ und Maskensubstratmaterial $T_S$ aufweist, aufgenommen. Die Teststrukturen $T_A$ der kalibrierten Testprobe können Pattern-Elemente mit unterschiedlichen Abmessungen aufweisen. Zusätzlich können die Teststrukturen $T_A$ z.B. Linienstrukturen mit varrierendem Abstand, Löcher bzw. Kontaktlöcher und Inseln unterschiedlicher Größe, sowie programmierte Defekte beinhalten. Beispiele hierfür sind in den Figuren 18 bis 22 angegeben.

Für die kalibrierte Testprobe mit zumindest einer kalibrierten Tesstruktur $T_A$ ist die Materialinformation $M(i, j)$ aufgrund des durchgeführten Kalibrierungsprozesses bekannt. Dies beutet, $M(i, j)$ weist in Bereichen des Materials der Teststrukturen $T_A$ den Wert 0 auf und in Regionen des Materials des Maskensubstrats $T_S$ den Wert 1 auf.

Es ist aber auch möglich, die Abbildungen einer kalibrierten Testruktur durch Ausführen von Simulationen auf Basis der kalibrierten Teststruktur zu erzeugen. Wie bereits oben ausgeführt, beinhalten die Simulationen zum einen das Ausführen von Monte Carlo Simulationen der Interaktion des Primärstrahls mit der zumindest einen Teststruktur $T_A$ der kalibrierten Testprobe und zum anderen das Ausführen einer elektronenoptischen Simulation der Trajektorien der sekundären Partikel zu jedem der zwei Detektoren 850, 870 des SEM 800 im allgemeinen Fall der $k$ Detektoren der Detektorkonfiguration.

Das Diagrmm 1095 der Fig. 10 zeigt im oberen Teilbild 1005 einen schematischen Schnitt durch eine Probe 1000. Die Probe 1000 weist ein Ruthenium- (Ru)-Substrat 1010 und ein Tantal (Ta) beinhaltendes Pattern-Element 1020 auf. In der Simulation, wiedergegeben im unteren Teilbild 1055, wird ein Linien-Scan auf dem Ru-Substrat 1010 entlang der Ta-Kante 1030 mit einer Landeenergie der primären Elektronen von 400 eV ausgeführt. Das Signal bzw. die Intensität des ersten (zweiten) Detektors 850 (870) ist in der Fig. 10 als durchgezogene Linie 1050 bzw. als gestrichelte Linie 1070 wiedergegeben. Die Kurve 1080 stellt das aus den Signalen des ersten 850 und des zweiten Detektors 870 rekonstruierte Materialkontrastsignal 1080 dar. Das rekonstruierte Materialkontrastsignal 1080 folgt der Materialänderung Tantal -> Ruthenium mit reduziertem Einfluss der Topographie der Probe 1000. Die punktierten horizontalen Linien 1075 und 1085 sind Normierungen für den Materialkontrast des Ru-Substrats 1010 und des Ta-Pattern-Elements 1020. Wie durch die vertikale punktierte Linie 1035 illustriert, kann aus dem rekonstruierten Signal 1080, welche einer Topographieänderung entspricht, aber im Beispiel der Fig. 10 mit der Stelle der Änderung der Materialzusammensetzung Ta -> Ru übereinstimmt, mit großer Genauigkeit bestimmt werden.

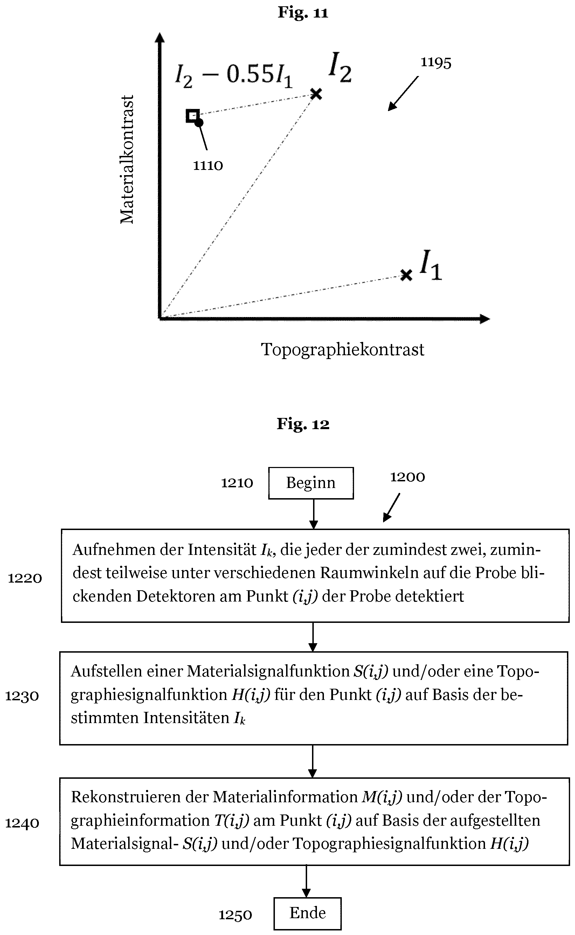

Das Diagramm 1195 der Fig. 11 stellt das Rekonstruieren des Materialkontrastsignals 1080 der Fig. 10 als Vektoraddition in einem Koordinatensystem dar, das von dem Topographiekontrast und dem Materialkontrast der Signale $I_k$ der Detektoren 850 und 870 aufgespannt wird. In dem in den Figuren 10 und 11 wiedergegebenen Beispiel ergibt sich das rekonstruierte Materialkontrastsignal 1080 aus dem Signal des zweiten Detektors 870 von dem 55% des Signals des ersten Detektors 850 subtrahiert werden. Dies ist in dem Diagramm 1195 durch den Punkt 1110 symbolisiert.

Alternativ kann einer der k Detektoren zum Aufnehmen von Testbildern mit einem Abschirmgitter ausgestattet sein. Idealerweise ist dies der Detektor, der den größten Abstand zur Probe 890 hat. In dem in der Fig. 8 dargestellten Beispiel ist dies der zweite Detektor 870. Dadurch ist es möglich, an jedem Punkt zusätzlich ein EsB-(Energy selective Back-scattered) Bild mit aktiviertem Abschirmgitter aufzunehmen. Letzteres kann kann als gute Näherung des Materialsignals $M(i, j)$ genommen werden. Nach dem Festlegen der Parameter des empirischen Modells ist der Einsatz eines Abschirmgitters jedoch nicht länger notwendig. Die durch die hohe notwendige Spannung des Abchirmgitters möglicherweise hervorgerufenen Instabilitäten des primären Elektronenstrahls können dadurch vermieden werden.

Im zweiten Schritt wird der Absolutbetrag der Differenz zwischen dem Materialsignal der Probe 890 $S(i, j)$ und dem Materialkonstrastsignal bzw. der Materialinformation der kalibrierten Teststruktur $M(i, j)$ durch Variieren der Parameter des Materiakontrastsignals bzw. der Materialsignalfunktion $S(i, j)$ des empirischen Modells minimiert. Ein Fachmann kann dies in einfach gelagerten Fällen durch Ausprobieren erreichen. In jedem bzw. im allgemeinen Fall können die Parameter des empirischen Modells durch den Einsatz bekannter Optimierungsmethoden bestimmt werden:

$$\min |S(i,j) - M(i,j)|$$

Indem der Absolutbetrag der Differenz zwischen dem Topographiesignal der Probe 890 $H(i, j)$ und der Topographieinformation der Teststruktur $T(i, j)$ minimiert wird

$$\min |H(i,j) - T(i,j)|,$$

kann das Höhenprofil der Probe 890, 1000 oder eine Höhenprofilkarte im Wesentlichen ohne den Einfluss des Materialkontrasts bestimmt werden.

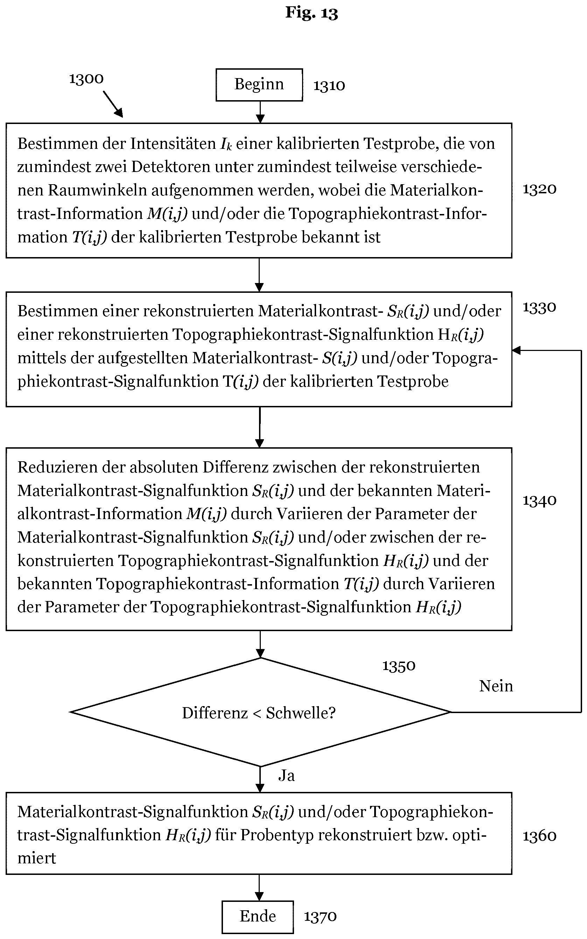

Fig. 12 präsentiert ein Flussdiagramm 1200, das ein pixelweises Rekonstruieren von Topographie- und Materialkontrastbeiträgen aus zumindest zwei Abbildungen zusammenfasst. Das Verfahren beginnt bei 1210. Im ersten Schritt 1220 werden die Intensitäten $I_k$ von jedem von wenigstens zwei unter zumindest teilweise verschiedenen Raumwinkeln auf die Probe blickenden Detektoren an einem Punkt $(i,j)$ der Probe 890, 1000 bestimmt. Das Bestimmen kann durch Messen und/oder Simulieren erfolgen. Sodann werden bei Schritt 1230 auf Basis der bestimmten Intensitäten $I_k$ eine Materialsignalfunktion $S(i,j)$ und/oder eine Topographiesignalfunktion $H(i,j)$ für den Punkt $(i,j)$ aufgestellt. Anschließend werden bei Schritt 1240 anhand der aufgestellten Materialsignalfunktion $S(i,j)$ und/oder Topographiesignalfunktion $H(i,j)$ der lokale Materialkontrastanteil $M(i,j)$ bzw. die lokale Materialinformation und/oder der lokale Topographiekontrastanteil $T(i,j)$ an dem Punkt $(i,j)$ der Probe 890, 1000 rekonstruiert. Zum Rekonstruieren kann das Entkopplungsmodell 700 der Fig. 7 in Form eines empirischen Modells eingesetzt werden. Das Festlegen der Parameter des empirischen Modells bzw. der Materialsignalfunktion $S(i,j)$ und/oder der Topographiesignalfunktion $H(i,j)$ ist in der nachfolgenden Fig. 13 erläutert. Das Verfahren endet bei 1250.

Das Flussdiagramm 1300 der Fig. 13 präsentiert ein Verfahren zum Bestimmen der Parameter eines Entkopplungsmodells 700 in Form eines empirischen Modells. Das Verfahren beginnt bei 1310. In Schritt 1320 werden die Intensitäten $I_k$ zumindest einer Teststruktur einer kalibrierten Testprobe mit zumindest zwei Detektoren 850, 870 aufgenommen, die zumindest unter teilweise verschiedenen Raumwinkeln auf die Teststruktur der kalibrierte Testprobe blicken. Die kalibrierte Testprobe zeichnet sich dadurch aus, dass für die kalibrierte Testprobe deren Materialkontrast-$M(i,j)$ und/oder Topographiekontrast-Information $T(i,j)$ bzw. Materialkontrast- und/oder Topographiekontrast-Verteilung bekannt sind.

In Schritt 1330 werden auf Basis der aufgestellten Materialkontrast-Signalfunktion $S(i,j)$ und/oder der aufgestellten Topographiekontrast-Signalfunktion $H(i,j)$ und der bekannten Materialkontrast-Information $M(i,j)$ und/oder Topographiekontrast-Information $T(i,j)$ der kalibrierten Testprobe eine rekonstruierte Materialkontrast-Signalfunktion $S_R(i,j)$ und/oder eine rekonstruierte Topographiekontrast-Signalfunktion $H_R(i,j)$ bestimmt bzw. berechnet. Sodann wird bei Schritt 1340 der Absolutwert der Differenz zwischen der rekonstruierten Materialkontrast-Signalfunktion $S_R(i,j)$ und der bekannten Materialkontrast-Information $M(i,j)$ und/oder der rekonstruierten Topographiekontrast-Signalfunktion $H_R(i,j)$ und der bekannten Topographiekontrast-Information $T(i,j)$ minimiert, indem die Parameter des empirischen Modells, d.h. der rekonstruierten Materialkontrast-Signalfunktion $S_R(i,j)$ und/oder der rekonstruierten Topographiekontrast-Signalfunktion $H_R(i,j)$ variiert werden.

Bei Entscheidungsblock 1350 wird geprüft, ob der verbleibende Unterschied kleiner als ein vorgegebener Schwellenwert ist. Falls der verbleibende Unterschied größer als ein vorgegebener Schwellenwert ist, springt das Verfahren zu Block 1330 zurück und es werden mit den aktuellen Parametern der rekonstruierten Materialkontrast-Signalfunktion $S_R(i,j)$ und/oder der rekonstruierten Topographiekontrast-Signalfunktion $H_R(i,j)$ eine neue rekonstruierte Materialkontrast-Signalfunktion $S_R(i,j)$ und/oder eine neue Topographiekontrast-Signalfunktion $H_R(i,j)$ berechnet. Das Verfahren wird dann mit Block 1340 fortgesetzt. Falls die Bedingung des Entscheidungsblocks 1350 erfüllt ist, schreitet das Verfahren 1300 zu Block 1360 fort und die temporären Parameter des empirischen Modells werden als bestmögliche Parameter zum Analysieren der Probe 890, 1000, d.h. als rekonstruierte Materialkontrast-Signalfunktion $S_R(i,j)$ und/oder als rekonstruierte Topographie-Kontrastfunktion $H_R(i,j)$ gespeichert. Das Verfahren endet bei Block 1370.

Bei dem bisher beschriebenen Ermitteln der Parameter eines empirischen Modells basierend auf einem pixelweisen Bestimmen der Signale $I_k$ von zwei oder mehr Detektoren 850, 870 können nichtlokale Effekte in den Signalen nicht berücksichtigt werden. Dadurch können die Topographieanteile $H(i,j)$ nicht vollständig von den Materialkontrastanteilen $S(i,j)$ der Signale $I_k$ der Detektoren 850, 870 separiert werden. Um diese Trennung präziser ausführen zu können, muss am Punkt $(i,j)$ der Probe 890, 1000, das Signal der Detektoren an den Punkten $I_k(i-dx,j-dy)$ mit betrachtet werden. Der maximale Bereich $(dx,dy)$, der dabei betrachtet werden muss, hängt von der Interaktionsfläche der Elektronen des primären Elektronenstrahls mit der Probe 890, 1000, der Topographie der Probe 890, 1000 und der Elektronenoptik der Detektionspfade (über die Akzeptanzfunktionen $D_k(E, \phi)$) ab. Typischerweise weist die zu betrachtende Probenfläche, innerhalb der nichtlokale Effekte wirken, lineare Abmessungen im Bereich von 5 nm bis 20 nm auf.

Dies bedeutet, es ist häufig nicht ausreichend, nur Signale $I_k$ an einzelnen Punkten der Probe 890, 1090 aufzunehmen. Vielmehr müssen mehrere Bildsignale $I_k$ der Detektoren 850, 870 mit einem Scan des primären Elektronenstrahls über eine Fläche um die einzelnen Punkte $(i,j)$ aufgenommen werden. Für jeden der zumindest zwei Detektoren 850, 870, im allgemeinen Fall $k$ Detektoren, wird ein Bild $I_k$ aufgenommen. Dieser Zusammenhang gilt auch für die Aufnahme von Trainingsdaten zum Trainieren eines Transformationsmodells bzw. eines ML- oder DL-Modells.

Durch Ausführen einer Faltungsoperation mit einem oder mehreren geeigneten Faltungskernen $w_l$ mit den aufgenommenen Bilddaten $I_k$ werden neue Signale $G_{k,l}(i, j)$ generiert:

$$G_{k,l}(i,j) = w_l * I_k = \sum_{dx=-a}^{a} \sum_{dy=-b}^{b} w_l(dx, dy) I_k(i - dx, j - dy)$$

Als Faltungskerne $w_l$ können bekannte Bildfilter, wie etwa Sobel-Filter, Prewitt-Filter, Laplace-Filter, Marr-Hildreth-Filter, Gauss-Filter und Sharpen-Filter, eingesetzt werden. Der Einsatz weiterer Filtertypen ist ebenfalls möglich.

Damit die Faltungsoperation die entsprechende Wirkung entfalten kann, d.h. nichtlokale Effekte bei der Separation der Materialkontrast- und Topographiekontrastanteile bzw. Materialkontrastsignale und Topographiekontrastsignale zu trennen, ist es notwendig, den Scan-Bereich um die einzelnen Punkte hinreichend groß zu wählen. Hierfür sollte der Scan-Bereich größer als der gewählte Faltungskern sein. Ferner ist es für die erreichbare Genauigkeit günstig, wenn der Scan-Bereich so groß ist, dass das Vorgehen im Randbereich des Scan-Bereichs, wie etwa ein Erweitern, Umfalten oder Abschneiden, im Wesentlichen keinen Einfluss auf das Ergebnis der Faltungsoperation hat. Bei der Wahl der Größe des Faltungskerns sollten diese Überlegungen berücksichtigt werden.

Das weitere Vorgehen erfolgt dann wie oben beschrieben. Das Materialsignal bzw. die Materialkontrast-Signalfunktion am Punkt *(i,j)* der Probe 890, 1000 ist gegeben durch:

$$S(i, j) = \sum_k \sum_l b_{k,l} G_{k,l}(i, j) + a_k I_k(i, j) + a_0$$

Der Absolutbetrag der Differenz zwischen dem Materialsignal $S(i, j)$ und der Materialinformation $M(i, j)$ wird durch Variieren der Parameter $a_k$, $b_{k,l}$ minimiert. Dadurch wird eine rekonstruierte Materialkontrast-Signalfunktion $S_R(i,j)$ erzeugt. Durch eine Datenaufnahme innerhalb flächiger Bereiche der Probe 890, 1000 anstelle einzelner Punkte (ij) kann der Einfluss von Topographieeffekten in einem lokalen Materialsignal der Probe 890, 1090 minimiert werden. Der erläuterte Optimierungsprozess ist für jeden Probentyp, beispielsweise jeden Maskentyp, sowie jeden Arbeitspunkt des SEM 800 der Fig. 8 vorzunehmen.

Wie oben beschrieben, kann selbstredend auch ein Topographiekontrastbild, bzw ein Höhenprofil oder eine Höhenprofilkarte der Probe 890, 1000 ermittelt werden.

Im Folgenden werden das Trennen der Materialkontrast- und der Topographiekontrastanteile einer Probenabbildung oder eines Probenbildes mit Hilfe eines Transformationsmodells erläutert. Im nachfolgend ausgeführten Beispiel umfasst das Transformationsmodell ein Modell maschinellen Lernens (ML-Modell), präziser ein Deep Learning Modell (DL-Modell). Ein DL-Modell kann als ein Netzwerk mehrerer Filter betrachtet werden, deren Filterparameter durch den Einsatz von Deep Learning Verfahren festgelegt bzw. optimiert werden.

Die Datenaufnahme erfolgt, wie oben beschrieben, durch Rastern des primären Elektronenstrahls um einzelne Punkte *(i,j)* der Probe 890, 1000 herum. Die Anforderungen an die Größe der einzelnen Scan-Bereiche der Probe 890, 1000 sowie die Anzahl der darin enthaltenen Rasterpunkte sind bereits oben diskutiert.

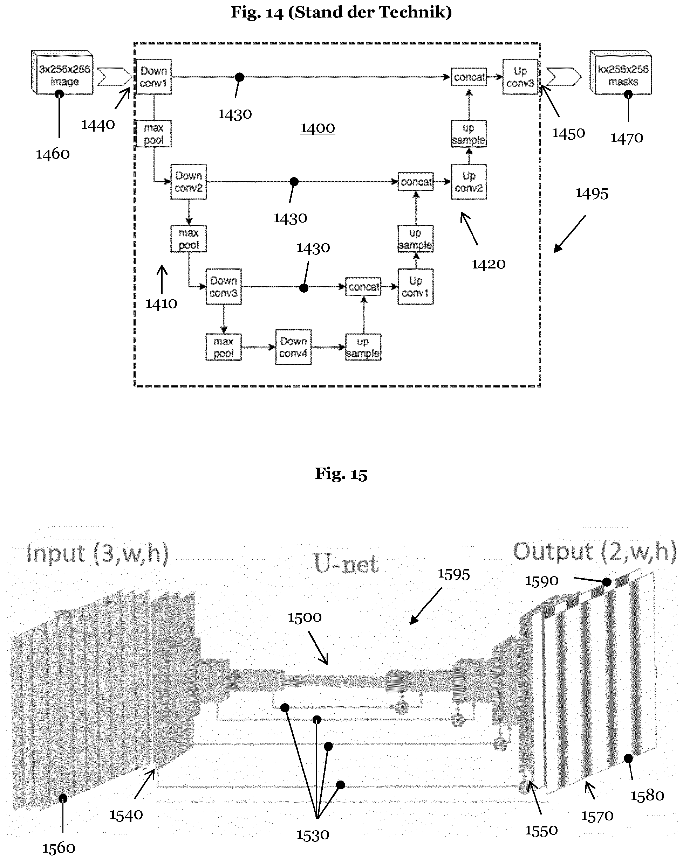

Eine bekannte Architektur, die gut für Denoising und Segmentierungsaufgaben geeignet ist, ist die in der Fig. 14 angegebene U-Net Architektur 1400. Auf der Encoder-Seite 1410 weist die U-Net Architektur 1400 abwechselnd Blöcke auf, die down conversion (Abwärtswandlung) und pooling (Bündelung ausführen. Auf der Decoder-Seite 1420 führen die entsprechenden Blöcke up conversion (Aufwärtswandlung) und upsampling anstelle von depooling (Entbündelung) Operationen aus. Die Ausgaben der down conversion Blöcke der Encoder-Seite 1410 werden neben dem nachfolgenden pooling Block zusätzlich den entsprechenden up conversion Blöcken auf der Decoder-Seite 1420 als Eingabedaten zur Verfügung gestellt. Auf der Encoder-Seite 1410 weist die U-Net Architektur 1400 eine Eingabeschicht 1440 und auf der Decoder Seite 1420 eine Ausgabeschicht 1450 auf.

In der beispielhalten U-Net Architektur 1400 des Diagramm 1495 der Fig. 14 werden über die Eingabeschicht 1440 als Eingabedaten 1460 drei Bilder mit einer Auflösung von $256 \times 256$ Punkten bereitgestellt. Für die in dieser Anmeldung beschriebenen Separierungsaufgaben sind die Eingabedaten 1460 in die U-Net Architektur 1400 die Signale $I_k$ der zumindest zwei 850 und 870 im allgemeinen Fall *k* Detektoren. Die Scanbereiche um die einzelnen Punkte *(i,j)* der Probe 890, 1000 können Rasterbereiche von $20 \times 20$ bis $400 \times 400$ Rasterpunkte umfassen. Wie oben beschrieben, wächst mit der Größe des Scanbereichs und insbesondere der Anzahl der darin enthaltenden Rasterpunkte die Genauigkeit, mit der nichtlokale Effekte korrigiert werden können. Andererseits steigt der Aufwand der Datenaufnahme quadratisch mit der Länge des Scanbereichs. An der Ausgabeschicht 1450 der Decoder-Seite 1420 stellt ein trainiertes U-Net die prädizierten Ausgabedaten 1470, im Beispiel der Fig. 14 als Bilddaten, bereit.

Das Diagramm 1595 der Fig. 15 gibt eine auf die Aufgabenstellung der vorliegenden Anmeldung angepasste U-Net Architektur 1500 an. Über deren Eingabeschicht 1540 werden der U-Net Architektur 1500 in dem Beispiel der Fig. 15 die von drei Detektoren aufgenommenen Signale 1560 bereitgestellt. Die trainierte U-Net Architektur 1500 prädiziert aus diesen Daten Ausgabedaten 1570 und stellt diese an der Ausgabeschicht 1550 bereit. In dem in der Fig. 15 dargestellten Beispiel sind dies ein Bild oder eine Abbildung 1590, die Materialkontrast der Proben 890, 1000 darstellt und ein Bild 1580, das Topographiekontrast aufweist. In dem in der Fig. 15 dargestellten Beispiel haben die Eingabedaten 1560 eine Dimension *(k, w, h)*, die in Ausgabedaten 1570 mit einer Dimension *(2, w, h)* transformiert werden, wobei k die Anzahl der Abbildungen angibt und w und h die Anzahl der Rasterpunkte bzw. Pixel in der Breite und Höhe bezeichnen.

Es ist auch möglich, die U-Net Architektur 1500 so zu trainieren, dass diese nur eines der beiden Bilder 1580 der 1590 an deren Ausgang 1550 bereitstellt. Ferner kann die U-Net Architektur 1500 trainiert werden, an deren Ausgang 1550 als Zahlenwerte nur die Inhalte an Materialkontrast bzw. Topographiekontrast einer oder beider der Abbildungen 1580 und 1590 auszugeben.

Zudem kann die U-Net Architektur 1500 trainiert werden, nur die Änderungen des Materialkontrasts und/oder des Topographiekontrasts an deren Ausgabeschicht 1550 bereitzustellen. Somit kann die U-Net Architektur 1500 angelernt werden, direkt ein Stoppsignal für einen Teilchenstrahl-induzierten Reparaturprozess einer Probe 890, 1000, etwa einer Fotomaske, auszugeben, nämlich dann, wenn der prädizierte Materialkontrast einer der vorgelegten, in einer Zeitreihe aufgenommenen Abbildungen sich über einen vorgegebenen Schwellenwert hinweg ändert.

Als vorteilhaft haben sich Bildgrößen *(w,h)* von 128x128, 64x64 oder 32x32 mit Pixel-Abmessungen im Bereich von 0,5 nm bis 1,5 nm herausgestellt. Dies resultiert in Bildgrößen von 16 nm × 16 nm bis 192 nm × 192 nm. Damit können mit vertretbarem Aufwand bei der Bildaufnahme nichtlokale Effekte für ein Entkopplungsmodell 700 sowohl in Form eines empirischen Modells als auch eines Transformationsmodells 1500 weitestgehend korrigiert werden.

Als Alternative zu der in den Figuren 14 und 15 vorgestellten U-Net Architekturen 1400, 1500 als Beispiele von DL-Modellen können ResNet (Resolution Network) Architekturen für das Separieren von Materialkontrast- und Topographiekontrastsignalen in Probenabbildungen eingesetzt werden. Bei ResNet Architekturen werden die Ausgaben einer Schicht nicht nur der nachfolgenden Schicht, sondern zusätzlich einer übernächsten oder mehreren der nachfolgenden Schichten der Encoder- und Decoder-Seite als Eingabedaten zur Verfügung gestellt.

Entscheidend für die Genauigkeit mit der Transformationsmodelle, ML- bzw. DL-Modelle 1400, 1500 Daten prädizieren können, ist die Qualität und Quantität der Daten auf deren Basis diese Modelle 1400, 1500 trainiert werden können. Zum Trainieren eines Transformationsmodells bzw. der U-Net Architektur 1400, 1500 der Figuren 14 und 15 werden Bilder von Trainingsproben oder Testproben von den zumindest zwei Detektoren 850, 870, bzw. allgemein von k Detektoren, aufgenommen, die unter zumindest teilweise unterschiedlichen Raumwinkeln auf die Testproben blicken. Es ist aber möglich, dass über den Ansatz von Testproben bzw. von kalibrierten Testproben nicht ausreichend vielfältige Daten zum Trainieren des U-Net Netzwerks 1400, 1500 aufgenommen werden können und/oder dass der Aufwand zum Generieren einer ausreichenden Quantität an Trainingsdaten durch Aufnehmen einer entsprechenden Anzahl von Abbildungen für Trainingszwecke übermäßig groß ist. In diesen Fällen kann ein erster Teil der Trainingsdaten, wie oben beschreiben, durch Messung und ein zweiter Teil durch Simulation generiert werden.

Wie bereits oben ausgeführt, kann mit einer Monte Carlo Simulation die Wechselwirkung zwischen den Elektronen eines Primärstrahls und den Atomkernen einer Probe 890, 1000 bzw. einer Testprobe auf statistischer Basis bestimmt werden. Simulationswerkzeuge, die Monte Carlo Simulationen ausführen können, sind bekannt, z.B. Nebula (nebula-simulator.github.io). Dadurch können weitere Bilder bzw. Abbildungen von Teststrukturen einer oder mehrerer Testproben erzeugt werden, die die gemessenen Abbildungen der Testproben ergänzen. Die Simulationsparameter des Tools werden so angepasst, dass die simulierten Bilder der Testprobe(n) die experimentell ermittelten Bilder bestmöglich reproduzieren können.

Nach dem Festlegen der Parameter des Simulations-Tools zum Reproduzieren der Testprobe(n) können in der Simulation die Testprobe(n) zufälligen Schwankungen unterworfen werden und/oder systematischen Änderungen unterzogen werden, so dass das Spektrum der simulierten Testbilder bzw. der durch Simulation generierten Trainingsdaten zufällige und/oder systematische Änderungen aufweisen. Insbesondere können auf Basis von Simulationen erzeugte Trainingsdaten alle möglichen Defekte einer Probe bzw. einer Testprobe enthalten.

Die durch Simulation erzeugten Trainingsdaten weisen einen weiteren Vorteil auf. Da die simulierten Testprobe(n) typischerweise auf deren Design-Files und/oder den Spezifikationen der Probe, etwa einer Fotomaske, basieren, sind die Materialkontrast- und Topographiekontrastanteile bzw. Materialkontrast-Informationen und Topographiekontrast-Informationen für simulierte Bilder der Testprobe(n) in der Regel bekannt und die simulierten Trainingsdaten können beim Einhalten der Spezifikation(en) direkt zum Anlernen oder Trainieren des Transformationsmodells, etwa der U-Net Architektur 1400, 1500, eingesetzt werden. Im Falle einer Fotomaske können die Spezifikationen beispielsweise den Seitenwandwinkel und die Höhe absorbierender Pattern-Elemente umfassen (vgl. Figuren 18 bis 22). Das Einhalten der Spezifikationen kann z.B. durch Abtasten der Probe(n) bzw. Testprobe(n) mit der Messspitze eines Rasterkraftmikroskops (AFM) bestimmt werden.

Für experimentell bestimmte Testbilder müssen deren Materialkontrast- und Topographiekontrastanteil in der Regel ex situ bestimmt werden, bevor diese Testbilder als Trainingsdaten zum Anlernen oder Trainieren des U-Net Modells 1400, 1500 eingesetzt werden können.

Einmal angelernt oder trainiert, können kleinere Variationen der Probe, im Falle von Fotomasken z.B. eine geringfügig andere Materialzusammensetzung der absorbierenden Pattern-Elemente, mit Hilfe von wenigen zusätzlichen Trainingsdaten angelernt werden, dafür kann beispielsweise eine weitere Schicht im Encoder-Zweig 1410, 1510 des DL-Modells 1400, 1500 verwendet werden, so dass nicht das gesamte Netzwerk 1400, 1500 neu trainiert werden muss. In einer alternativen Ausführungsform kann dem DL-Modell 1400, 1500 an dessen Eingabeschicht 1440, 1540 ein Hyperparameter bereitstellt werden, der aus einem trainierten generischen Fotomaskenmodell ein trainiertes Modell für einen spezifischen Maskentyp auswählt.

Durch das Bereitstellen eines zusätzlichen Parameters an der Eingabeschicht 1440, 1540 des DL-Modells 1400, 1500 kann ein trainiertes DL-Modell 1400, 1500 an eine spezifische Reparaturvorrichtung angepasst werden, um kleinere Variationen in der Abbildung der Detektoren 850, 870 und deren spezifische Eigenschaften dem trainierten DL-Modell 1400, 1500 bereitzustellen.

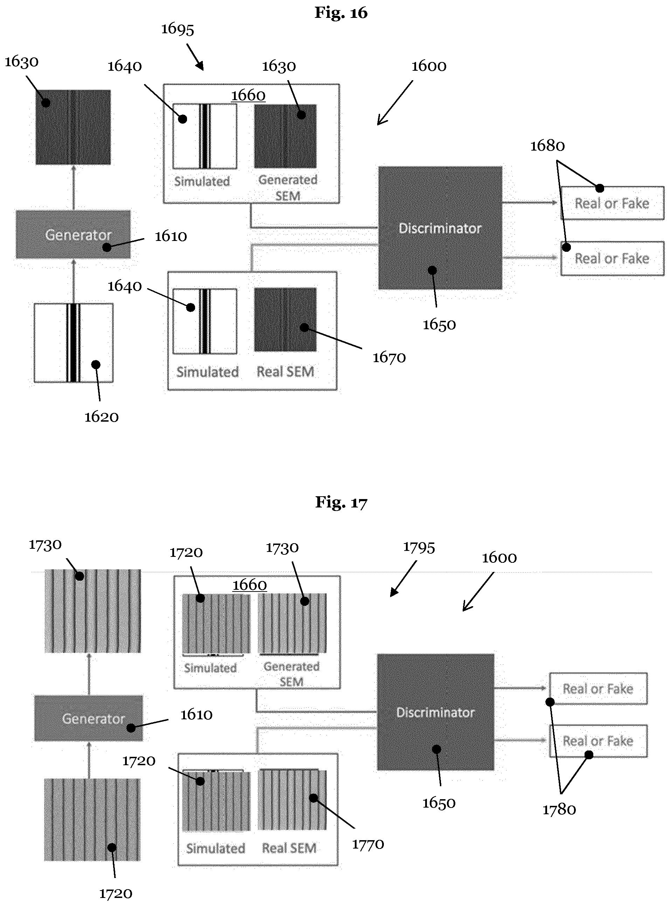

Zudem können mittels generativer AI- (Artificial Intelligence) Verfahren SEM-Bilder aus Design-Files erzeugt werden (vgl.: Making digital twins using the Deep Learning Kit (DLK), spiedigitallibrary.org), bzw. mask_defect_detecti on_with_hybrid_deep_learning_network_041205_ 1.pdf (zeiss.com)). Das Diagramm 1695 der Fig. 16 präsentiert schematisch ein GAN (Generative Adversarial Network) 1600. GANs umfassen typischerweise zwei künstliche neuronale Netzwerke (ANN, Artificial Neural Networks), die ein Nullsummenspiel ausführen. Ein erstes ANN 1610 wird als Generator 1610 bezeichnet und erstellt Kandidaten. Im Beispiel der Fig. 16 erzeugt der Generator 1610 aus Design-Daten 1620 einer Fotomaske ein simuliertes Bild 1630, das wie ein mittels eines SEM aufgenommenes Bild aussieht. Das Ziel des Generators 1610 ist es, simulierte SEM-Bilder 1630 zu generieren, die sich nicht von Bildern unterscheiden lassen, die mit Hilfe einer anderen Art Simulation, etwa durch Ausführen einer Monte Carlo Simulation 1640 erzeugt wurden. Der Vergleich des von dem Generator 1610 erzeugten Bildes 1630 und des simulierten Bildes 1640 ist in der Fig. 16 durch die Box 1660 veranschaulicht.

Das zweite ANN 1650 des GAN 1600 wird Diskriminator 1650 genannt und bewertet die Kandidaten. Im Beispiel der Fig. 16 sind dies die simulierten Bilder 1640 und die vom Generator 1610 generierten Bilder 1630. Hierfür weist Diskriminator 1650 ebenfalls die durch Ausführen einer Monte Carlo Simulation hergestellten Bilder 1640 sowie mit dem SEM 800 gemessene Bilder 1670 auf. Das ANN des Diskriminator 1650 ist darauf trainiert, die vom Generator 1610 gelieferten Ergebnisse, d.h. die erzeugten SEM-Bilder 1630 von echten gemessenen SEM-Bildern 1670 zu unterscheiden. Am Ausgang 1680 stellt das GAN 1600 die Entscheidung bereit, ob es das vorgelegte, von dem Generator 1610 erzeugte SEM-Bild 1630 im Lichte der gemessenen SEM-Bilder 1670 für echt hält oder nicht.

Dies bedeutet, durch den Einsatz von AI-Verfahren, etwa dem GAN 1600, können Trainingsdaten direkt aus Design-Daten 1620 generiert werden, wobei jeweils für jede Teststruktur einer Testprobe eines Design-Files 1620 ein SEM-Bild 1670 für jeden Detektor 850, 870 erzeugt wird. Voraussetzung für diese Art der Generierung von Trainingsdaten ist jedoch, dass in den ursprünglichen, d.h. den experimentellen 1670 und/oder den simulierten Trainingsdaten 1640, ausreichend Informationen über den Wechselwirkungsprozess des primären Elektronenstrahls mit den Atomkernen der Probe enthalten ist, so dass das GAN 1600 die zu Grunde liegenden Strukturen erkennen kann.

Bei Monte Carlo Simulationen tritt oftmals die Schwierigkeit auf, dass die Parameter nicht so festlegt werden können, dass die simulierten Bilder 1640 perfekt mit den von einem SEM 800 gemessenen Bildern zur Deckung bringen lassen. Hier können mit einem hybriden Ansatz bessere Ergebnisse erzielt werden. Das Diagramm 1795 der Fig. 17 zeigt schematisch nochmals das GAN 1600 der Fig. 16. Mit Hilfe von Monte Carlo Simulationen erzeugte Bilder von Teststrukturen 1720 werden dem Generator 1610 des GAN 1600 als Eingabedaten zur Verfügung gestellt. Der Generator 1610 synthetisiert hieraus Bilder 1730, die aussehen, als wären sie von einem SEM 800 aufgenommen worden. Der Diskriminator 1650 des GAN 1600 vergleicht oder bewertet die von dem Generator 1610 erzeugten Bilder 1730 und die gemessenen SEM-Bilder 1770 und entscheidet am Ausgang 1780, ob er das synthetisierte Bild als echt erachtet. Dadurch können die simulierten Bilder 1720 optimiert werden, so dass sich die vom Generator 1610 synthetisierten Bilder 1730 nicht mehr von gemessenen Bildern 1770 unterscheiden lassen. Wie im Kontext der Fig. 16 erläutert, können dann die synthetisierten Bilder 1730 als Eingabedaten zum Trainieren des GAN 1600 verwendet werden. Da in den Monte Carlo Simulationen die Physik des Wechselwirkungsprozesses zwischen dem primären Elektronenstrahl und der Probe 850, 870 enthalten ist, kann das GAN 1600 Neues über die zugrunde liegende Physik lernen.

Teststrukturen von Testproben auf deren Basis Bilder bzw. Abbildungen erzeugt werden, die zum Trainieren eines DL-Modells 1400, 1500 eingesetzt werden, müssen eine möglichst große Anzahl verschiedener relevanter Merkmale oder Features enthalten. Falls die Probe eine Fotomaske umfasst, sind Beispiele relevanter Features: verschiedene Kanten des Übergangs absorbierender Pattern-Elemente zum Maskensubstrat, LS- (Lines and Spaces) Strukturen mit verschiedenen Linienbreiten und Pitches, Vorsprünge (extrusions) und Eindellungen (intrusions), Kontaktlöcher (contact holes), usw. Die Abbildungen oder Bilder, die zum Trainieren eines DL-Modells 1400, 1500, allgemein eines Transformationsmodells, eingesetzt werden, müssen nicht notwendigerweise ganze oder großflächige SEM-Bilder umfassen. Vielmehr sind hierfür Bildausschnitte ausreichend. Wie oben erläutert, sollten die Bildausschnitte lineare Abmessungen der Probe 890, 1000 im Bereich von 200 nm umfassen, so dass die Korrektur nichtlokaler Effekte in den Bildern bzw. Bildausschnitten mit großer Genauigkeit möglich ist.

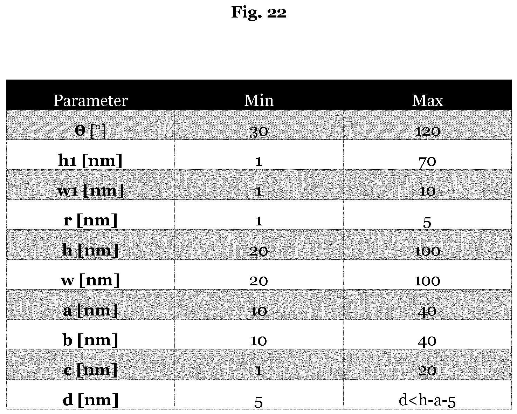

Die Figuren 18 bis 21 zeigen schematisch beispielhaft einige Strukturelemente oder Features deren Abbildungen zum Trainieren des ML-Modells 1500 eingesetzt werden können. Mögliche Variationsbereiche der Strukturelemente der Figuren 18 bis 21 sind in der Tabelle der Fig. 22 zusammengefasst.

Die Fig. 18 stellt im oberen Teilbild 1805 und im unteren Teilbild 1895 jeweils einen schematischen Schnitt durch eine Fotomaske 1800 dar, die ein Maskensubstrat 1810 aus einem ersten Material M1 und im oberen Teilbild 1805 ein absorbierendes und/oder phasenschiebendes Pattern-Element 1820 und im unteren Teilbild 1895 ein absorbierendes und/oder phasenschiebendes Pattern-Element 1830 aus einem zweiten Material M2 aufweist. Beide Pattern-Elemente 1820 und 1830 weisen eine Höhe h bzw. h1 auf. Ferner weisen beide Pattern-Elemente 1820 und 1830 einen Seitenwandwinkel $\Theta$ 1840 auf, der deutlich kleiner als beispielsweise ein von der Spezifikation vorgegebener Seitenwandwinkel $\Theta = 90°$ ist. Das Pattern-Element 1830 des unteren Teilbildes 1895 weist zudem eine Zwischenstufe 1850 mit einer Breite w1 und einer Höhe h2 auf. Der Seitenwandwinkel 1840 der beispielhaften Maske 1800 weist nach der Zwischenstufe 1850 den gleichen Zahlenwert wie vor der Zwischenstufe 1850 auf. Es ist aber auch möglich, dass diese beiden Winkel nicht gleich groß sind.

Die Fig. 19 präsentiert eine LS- (lines and spaces) Struktur 1900 mit einem Substrat 1910 aus einem ersten Material M1 und darauf angeordneten Streifen 1920 aus einem zweiten Material M2. Die beiden Streifen 1920 weisen eine Breite w auf. Ferner weist der linke Streifen 1920 eine Eindellung 1930 fehlenden Materials M2 in Form eines Trapezes 1930 auf. In dem Beispiel der Fig. 19 weist das Trapez die Seitenlängen a und b sowie die Höhe c auf. Der rechte Streifen 1920 der Fig. 19 weist eine trapezförmige Ausbuchtung überschüssigen Materials M2 auf. In der Fig. 19 weisen die Trapeze 1930 und 1940 die gleiche Form und die gleiche Größe auf. Selbstredend ist es möglich, dass die Eindellung 1930 und die Ausbuchtung 1940 unterschiedliche geometrische Formen und Flächen aufweisen.

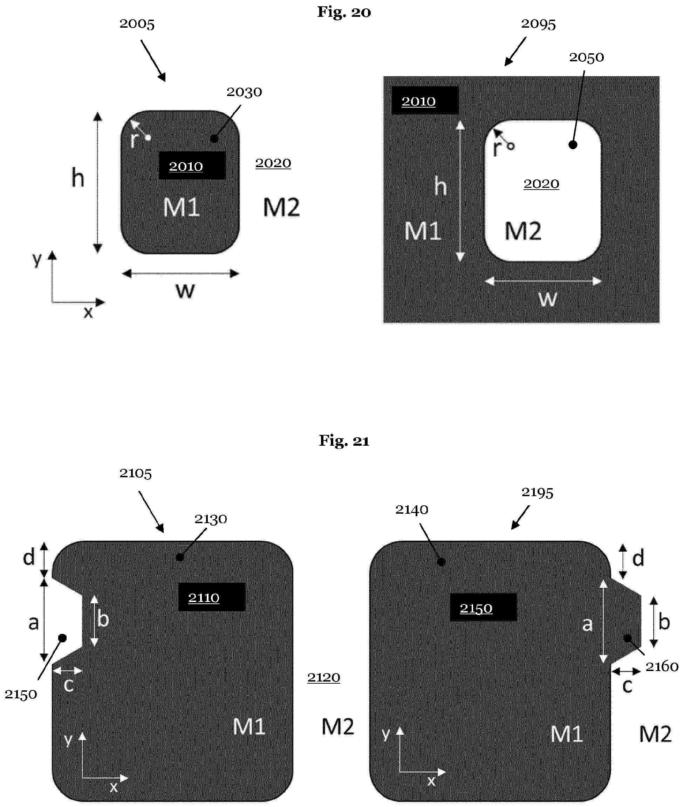

Die Fig 20 weist Teststrukturen für Monte Carlo Simulationen im linken Teilbild 2005 in Form eines Kontaktloches 2030 und im rechten Teilbild 2095 in Form eines rechteckigen Pattern-Elements 2050 auf. Das rechteckförmige Kontaktloch 2030 kann in ein Pattern-Element 2050 aus dem Material M2 bis auf das Substrat 2010 aus Material M1 geätzt werden. Das Kontaktloch 2030 weist eine Breite w und eine Höhe h sowie einen Krümmungsradius r an den Ecken des Kontaktloches 2030 auf. Die gleichen Abmessungen sowie der gleiche Krümmungsradius gelten für das Pattern-Element 2050 des rechten Teilbildes 2095.

Die Fig. 21 gibt sowohl im linken Teilbild 2105 als auch im rechten Teilbild 2195 eine Teststruktur in Form des Kontaktloches des linken Teilbildes 2005 der Fig. 20 wieder. Im linken Teilbild 2105 weist das Kontaktloch 2130 jedoch eine Eindellung 2140 überschüssigen Materials M2 auf. Die Eindellung 2140 weist wiederum eine trapezförmige Form auf und beginnt in einem Abstand d von der oberen Kante des Kontaktloches 2130. Das Kontaktloch 2150 des rechten Teilbildes 2195 weist eine Ausbeulung 2160 in Form eines definierten "Defekts" 2160 fehlenden Materials M2 auf. Dieser weist die gleichen Abmessungen wie der Defekt 2140 des linken Teilbildes 2105 in Form einer Eindellung 2140 auf und ist spiegelsymmetrisch zur definierten Eindellung 2140 angeordnet.

Die Tabelle 2200 der Fig. 22 gibt die Variationsbereiche der Parameter der Figuren 18 bis 21 an, innerhalb derer systematisch Defekte 1930, 1940, 2140, 2160 erzeugt werden können, so dass die auf Basis dieser Strukturelemente 1820, 1830, 1930, 1940, 2130, 2160 erzeugten Trainingsdaten ausreichend vielfältig sind. Die erzeugten Strukturelemente einschließlich deren Variationen werden in Polygone zerlegt und als Input oder Eingabedaten für Monte Carlo Simulationen verwendet.

Im Folgenden wird ein zweites Ausführungsbeispiel zum Bestimmen des Topographiekontrast- und des Materialkontrast-Beitrags von zwei gleichzeitig unter verschiedenen Raumwinkeln aufgenommenen Abbildungen erläutert. Das zweite beispielhafte Ausführungsbeispiel verwendet als Entkopplungsmodell 700 ein Modell maschinellen Lernens 1500.

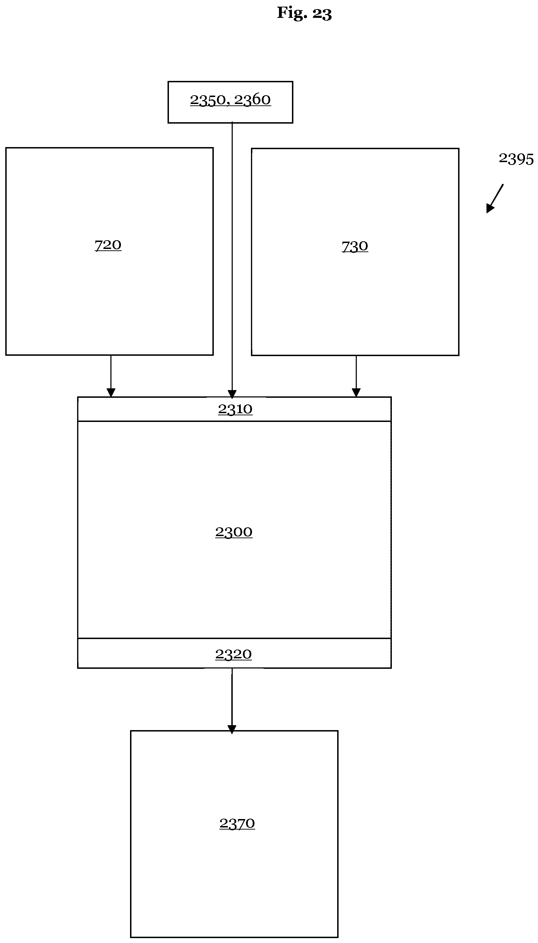

Das Diagramm 2395 der Fig. 23 veranschaulicht schematisch das Ausführen eines trainierten ML-Modells 2300, das eine erste gemessene Abbildung 720 und eine zweite gemessene Abbildung 730 in eine transformierte Abbildung 2370 umwandelt, die ein vorgegebenes Topographiekontrast- und Materialkontrastverhältnis aufweist. Das ML-Modell 2300 kann ein Deep Learning Modell umfassen, beispielsweise die U-Net-Architektur 1500.

Gemäß der speziellen Zielsetzung der vorliegenden Anmeldung basiert die transformierte Abbildung 2370 auf einer Intensitätsverteilung, die ausschließlich durch die Materialzusammensetzung der Probe 890, 1000, im vorliegenden Beispiel die Fotomaske 890, 1000, hervorgerufen wird. Neben den Abbildungen 720, 730 wird dem trainierten Modell maschinellen Lernens 2300 über dessen Eingabeschicht 2310 zusätzlich zumindest ein Parameter 2350 und/oder zumindest ein Hyperparameter 2360 bereitgestellt. Zusätzliche Parameter 2350 und Hyperparameter 2360 sind im dritten Teil dieser Beschreibung diskutiert. Mittels eines Hyperparameters 2360 kann beispielsweise eine Probe 890, 1000, die in Form einer Fotomaske 890, 1000 vorliegt, als eine binäre Maske klassifiziert werden.

Die Abbildungen 720, 730 sind zweidimensionale Pixelmatrizen in einer Grauwertdarstellung. Die Pixelmatrizen können derzeit Größen im Bereich $2^0 \cdot 2^0$ bis $2^{16} \cdot 2^{16}$ aufweisen. Ein Pixel kann mit einer Tiefe von $2^4$ bis $2^{10}$ Bits kodiert werden. Die Matrizengröße und die Pixeltiefe können für beide Abbildungen 720, 730 gleich sein. Das ML-Modell 2300 kann jedoch auch darauf trainiert worden sein, Abbildungen mit verschiedenen Matrizengrößen und/oder Pixeltiefen zu verarbeiten. Ferner kann ein ML-Modell 2300 darauf trainiert werden, drei oder mehr der Eingabeschicht 2310 vorgelegte Abbildungen 720, 730 zu einer einzigen transformierten Abbildung 2370 zu verarbeiten (in der Fig. 23 nicht dargestellt).

Das trainierte ML-Modell 2300 stellt die transformierte Abbildung 2370 an deren Ausgabeschicht 2320 bereit. Die transformierte Abbildung 2370 kann die gleiche Matrixgröße und die gleiche Pixeltiefe wie eine der beiden am Eingang 2310 vorgelegten Abbildungen 720, 730 aufweisen. Es ist aber auch möglich, dass die transformierte Abbildung 2370 eine andere Matrixgröße und/oder Pixeltiefe als eine der beiden Abbildungen 720, 730 aufweist.

Das ML-Modell 2300 kann eines der im dritten Abschnitt beschriebenen Modelle umfassen. Es ist vorteilhaft, aus einer Vielzahl vorhandener generischer ML-Modelle ein Modell auszuwählen, das dem zu lösenden Problem angepasst ist. Ferner ist es günstig, ein ausgewähltes generisches ML-Modell 2300 an das zu lösende Problem und die geforderte Vorhersagegenauigkeit anzupassen. Für das zu lösende Problem haben sich U-Net Architekturen 1500 und/oder ResNet Architekturen als vorteilhaft erwiesen. Das Anpassen des ML-Modells 2300 kann beispielsweise durch ein Anpassen der Komplexität der Kernfunktion eines ML-Modells 2300 erfolgen. Bei einem ML-Modell 2300 mit einer Encoder-Decoder-Architektur kann dies zum Beispiel durch eine entsprechende Wahl der Schichtenanzahl des ML- bzw. des DL-Modells 2300 ausgeführt werden. Für ein ML-Modell 2300, das beispielsweise in Form einer oben beschriebenen Mischform realisiert ist, kann etwa die Anzahl der Blätter in einem RDT oder die Anzahl der Bäume in einem RDF an das zu lösende Problem adaptiert werden.

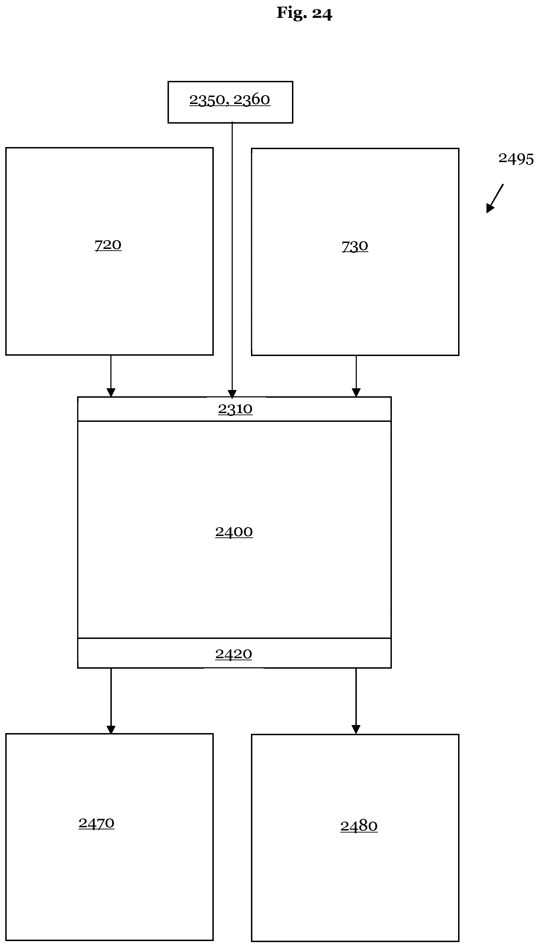

Das Diagramm 2495 der Fig. 24 präsentiert ein ML-Modell 2400, das eine Abwandlung des ML-Modells 2300 der Fig. 23 dargestellt. Anders als das ML-Modell 2300 ist das ML-Modell 2400 darauf trainiert worden, aus den beiden am Eingang 2310 vorgelegten Abbildungen 720, 730 zwei transformierte Abbildungen 2470, 2480 zu generieren. Die beiden transformierten Abbildungen 2470, 2480 können die gleichen Matrixgrößen und Pixeltiefen aufweisen oder diese Größen der beiden transformierten Abbildungen 2470, 2480 können verschieden sein. Die beiden transformierten Abbildungen 2470, 2480 können verschiedene Verhältnisse von Topographiekontrast und Materialkontrast der Abbildungen 720, 730 wiedergeben. Insbesondere kann das ML-Modell 2400 beispielsweise dafür angelernt werden, dass die transformierte Abbildung 2470 lediglich Topographiekontrast und die transformierte Abbildung 2480 ausschließlich Materialkontrast wiedergibt. Aus der transformierten Abbildung 2480 kann mit großer Genauigkeit ein Stoppsignal für einen lokalen chemischen Probenreparaturprozess abgeleitet werden.

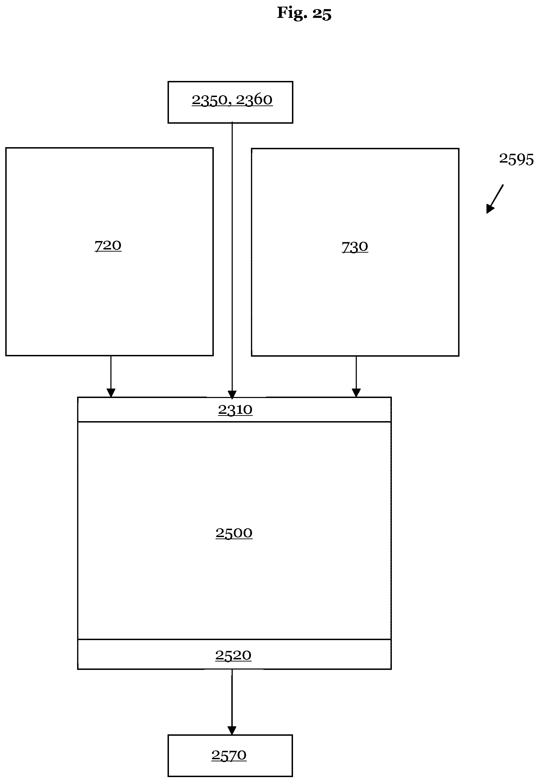

Das Diagramm 2595 der Fig. 25 veranschaulicht eine weitere mögliche Variation des ML-Modells 2300. Das trainierte Modell maschinellen Lernens 2500 ist darauf trainiert worden, an deren Ausgabeschicht 2520 den Topographiekontrast- und den Materialkontrastbeitrag einer oder der beiden Abbildungen 720, 730 bereitzustellen. Es ist selbstredend auch möglich, das ML-Modell 2500 darauf zu trainieren, lediglich den Materialkontrastanteil der Abbildung 730, an der Ausgabeschicht 2520 zur Verfügung zu stellen.

Ferner kann das ML-Modell 2500 direkt darauf trainiert werden, ein Stoppsignal für einen lokalen chemischen Reparaturprozess zu generieren. Hierfür wird das ML-Modell 2500 darauf trainiert, eine Änderung des Materialkontrastbeitrags eines ersten Satzes von Abbildungen 720, 730 und eines zweiten Satzes von Abbildungen 720, 730, der zu einem späteren Zeitpunkt aufgenommen wurde, zu erkennen. Falls diese Änderung einen vorgegebenen Schwellenwert überschreitet, stellt das trainierte ML-Modell 2500 an dessen Ausgabeschicht 2520 ein entsprechendes Signal zu Verfügung. Solange der zeitliche Verlauf einer Materialkontraständerung eines Satzes von Abbildungen 720, 730 unterhalb des vorgegebenen Schwellenwerts bleibt, erfolgt hingegen keine Datenausgabe durch das entsprechend trainierte ML-Modell 2500.

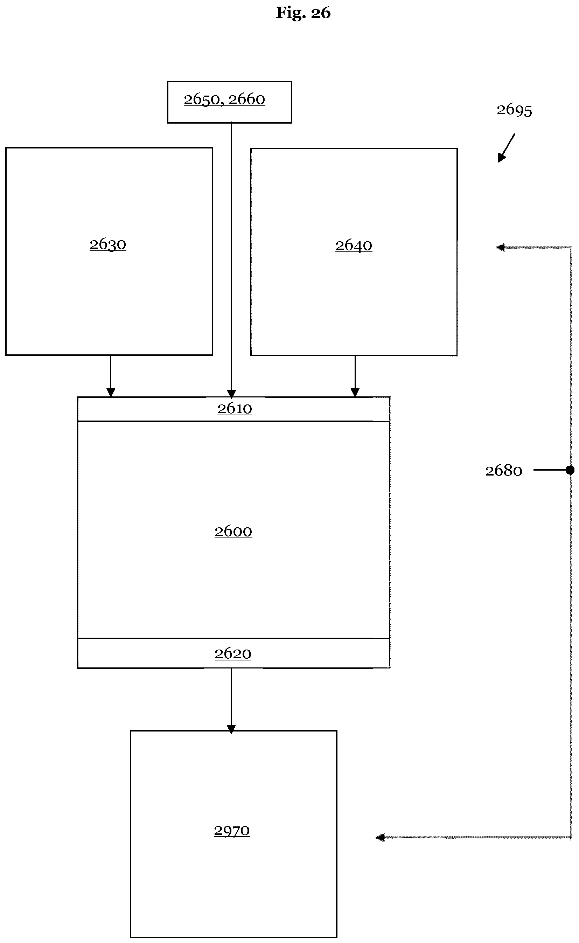

Bevor eines der Modelle maschinellen Lernens 1500, 2300, 2400, 2500 zum Erfüllen der zugedachten Aufgabe eingesetzt werden kann, müssen diese für den vorgesehenen Einsatzzweck trainiert bzw. angelernt werden. Das Diagramm 2695 der Fig. 26 zeigt schematisch das Trainieren eines Modells maschinellen Lernens 2300, 2400, 2500 oder eines ML-Modells 2300, 2400, 2500. Bevor das ML-Modell 2300 eine transformierte Abbildung 2370 aus den vorgelegten Abbildungen 720, 730 prädizieren kann, muss das ML-Modell 2300 mit einem umfangreichen Datensatz oder Trainingsdatensatz für diese Aufgabe angelernt oder trainiert werden. Dies gilt selbstredend auch für die ML-Modelle 2400 und 2500.

Zur Erzeugung der Trainingsdaten werden lange, gleichartige Messreihen aus Abbildungs-Tupeln von zum Training verwendeten Proben mit einer Messvorrichtung etwa dem SEM 800 durchgeführt. In dem diskutierten Beispiel ist die Probe 890, 1000 ein Ausschnitt aus einer Fotomaske 300. Alternative Proben können Wafer, Templates für die Nanoprägelithographie, MEMS, NEMS oder PICs sein. Im vorliegenden Anwendungsbeispiel umfassen die Abbildungs-Tupel Paare zweier Abbildungen, die von verschiedenen Vertretern einer Probenklasse unter zumindest teilweise verschiedenen Raumwinkeln aufgenommen werden. Im in Rede stehenden Beispiel werden N verschiedene binäre Fotomasken mit verschiedenen Absorber-Pattern, die zudem das gesamte Spektrum bekannter Defekte abdecken, mit einer Messvorrichtung etwa dem SEM 800, mit einer Detektorkonfiguration mit zwei Detektoren 850, 870 gleichartig vermessen, wobei N so groß gewählt werden muss, dass sich die relevanten charakterisierenden Parameter der Abbildungs-Tupel, nämlich der Topographiekontrastbeitrag und der Materialkontrastbeitrag der Abbildungs-Tupel, während des Messprozesses des Trainingsdatensatzes signifikant ändern. Ferner ist es möglich, während der Aufnahme von Trainingsdaten die Messumgebung und damit die charakterisierenden Parameter systematisch zu variieren, um für Trainingszwecke eine möglichst repräsentative Datenbasis zu erzeugen. Hierfür kann der Probensatz, d.h. der Satz binärer Masken neben fehlerfreien, fehlerhaften auch reparierte binäre Masken 300,890, 1000 und insbesondere Masken 300, 890, 1000 in jeder Stufe eines Reparaturprozesses beinhalten.

Unter einem zweiten Zahlenwert eines Hyperparameters 2360 kann ein generisches Modell für einen zweiten Maskentyp trainiert werden, etwa für phasenschiebende Masken.

Der Trainingsdatensatz umfasst die zum Training verwendeten charakterisierenden Abbildungs-Tupel 2630 und 2640 samt zumindest einem zusätzlichen Parameter 2650, der die Messvorrichtung zum Messen der Abbildungs-Tupel 2630, 2640 charakterisiert und/oder zumindest einem Hyperparameter 2660. Die Trainingsdaten werden dem trainierenden ML-Modell 2300 an einer Eingabeschicht 2610 bereitgestellt. Der Hyperparameter 2660 gibt eine Klassifizierung der zum Training verwendeten charakterisierenden Abbildungs-Tupel 2630 und 2640 an. Während der Trainingsphase generiert das trainierende oder lernende ML-Modell 2600 aus den trainierenden charakterisierenden Paaren von Abbildungen 2630 und 2640 und dem zugehörigen zusätzlichen Parameter 2650, 2660 eine transformierte Abbildung 2670. Die prädizierte transformierte Abbildung 2670 wird mit einer Abbildung 2630 oder 2640 des zugeordneten Abbildungs-Tupel 2630, 2640 verglichen. Dies ist in der Fig. 26 durch den Doppelpfeil 2680 veranschaulicht. Die vorhergesagte transformierte Abbildung 2670 stellt das trainierende ML-Modell 2600 an seiner Ausgabeschicht 2620 bereit. Es ist natürlich auch möglich, das ML-Modell 2600 so zu trainieren, dass dieses an seiner Ausgabeschicht 2620 zwei transformierte Abbildungen bereitstellt, wobei eine erste Materialkontrast und eine zweite Topographiekontrast der Probe wiedergibt (in der Fig. 26 nicht wiedergegeben).

Abhängig vom gewählten ML-Modell 2300, 2400, 2500 existieren verschiedene Verfahren zum Anpassen der Parameter des ML-Modells 2300, 2400, 2500 in der Trainingsphase. Beispielsweise hat sich für ein DNN (Deep Neuron Network), das typischerweise eine Vielzahl von Parametern aufweist, die iterative Technik "Stochastic Gradient Descent" etabliert. Dabei werden die Trainingsdaten dem lernenden ML-Modell 2600 immer wieder "vorgelegt", d.h. dieses berechnet aus den zum Training verwendeten charakterisierenden Abbildungs-Tupel 2630, 2640 mit seinem aktuellen Parametersatz eine Vorhersage für die transformierte Abbildung 2670. Anschließend wird der oben angesprochene Vergleich ausgeführt. Ergeben sich Abweichungen zwischen der transformierten Abbildung 2670 und einer der Abbildungen 2630 oder 2640 des Abbildungs-Tupels 2630, 2640 und dem tatsächlichen Wert des Topographiekontrasts und/oder des Materialkontrasts der gewählten Abbildung 2630 oder 2640, werden die Parameter des lernenden ML-Modells 2600 angepasst. Die Trainingsphase endet, wenn ein lokales Optimum erreicht ist, d.h. die Abweichungen des vorhergesagten Topographiekontrasts und/oder des vorhergesagten Materialkontrasts und dem tatsächlichen Topographiekontrast und/oder Materialkontrast der Abbildung 2630 oder 2640 nicht mehr variieren, oder aber ein vorgegebenes Zeitbudget für den Trainingszyklus des lernenden oder trainierenden ML-Modells 2600 aufgebraucht ist.

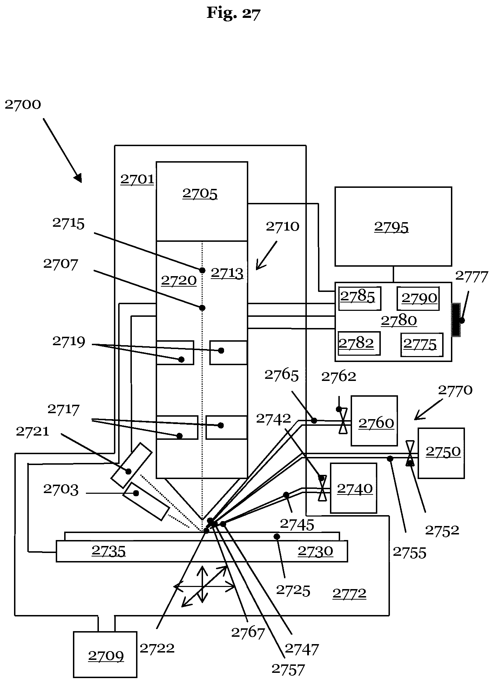

Die zum Training verwendeten charakterisierenden Abbildungs-Tupel 2630, 2640 können von einer Partikelstrahl-basierten Messvorrichtung stammen, beispielsweise dem SEM 800 der Fig. 8 und/oder der im Kontext der Fig. 27 zu diskutierenden Reparaturvorrichtung 2700. Es ist aber auch möglich, das in dieser Anmeldung beschriebene Verfahren für beliebige Messvorrichtungen einzusetzen, die allgemein einen Partikelstrahl zum Abbilden eines Elements eines Fotolithographieprozesses einsetzen. Insbesondere kann das hier erläuterte Verfahren für ein Rasterelektronenmikroskop und/oder eine Messvorrichtung eingesetzt werden, die einen Ionenstrahl zum Abbilden einer Fotomaske oder eines Wafers einsetzt.

Die Fig. 27 zeigt einen schematischen Schnitt durch einige wichtige Komponenten einer Vorrichtung 2700, die dafür ausgelegt ist, gleichzeitig zwei Abbildungen einer Probe mit zwei Detektoren aufzunehmen, deren Raumwinkel höchstens zum Teil überlappen. In der beispielhaften Vorrichtung 2700 der Fig. 27 unterscheiden sich die beiden gleichzeitig mit zwei Detektoren aufgenommenen Abbildungen in deren Polarwinkelanteilen. Ferner kann die Vorrichtung 2700 ein Entkopplungsmodell 700 anwenden, um einen Topographiekontrastanteil und/oder einen Materialkontrastanteil zumindest einer der zumindest zwei Abbildungen 720, 730 zu bestimmen. Zudem ist die Vorrichtung 2700 dafür eingerichtet, ein Transformationsmodell und/oder ein Modell maschinellen Lernens 1500, 2300, 2400, 2500 - als Beispiele eines Entkopplungsmodells 700 in Form eines Transformationsmodells - zu trainieren. Überdies ist die Vorrichtung 2700 dafür ausgelegt, einen Probendefekt durch Ausführen eines Partikelstrahl-induzierten lokalen chemischen Prozesses zu reparieren. Die beispielhafte Vorrichtung 2700 der Fig. 27 umfasst ein modifiziertes Rasterteilchenmikroskop 2710 in Form eines Rasterelektronenmikroskops (SEM, Scanning Electron Microscope) 2710 in Kombination mit einem Gasbereitstellungssystem 2770.

Die Vorrichtung 2700 weist eine Teilchenstrahlquelle 2705 in Form einer Elektronenstrahlquelle 2705 auf, die einen Elektronenstrahl 2715 als Teilchenstrahl 2715 erzeugt. Ein Elektronenstrahl 2715 hat - verglichen mit einem Ionenstrahl - den Vorteil, dass die auf die Probe 2725 bzw. die lithographische Maske 300, 890, 1000 auftreffenden Elektronen 2707 die Probe 2725 bzw. die Maske 300, 890, 1000 im Wesentlichen nicht schädigen können. Es ist jedoch auch möglich, in der Vorrichtung 2700 einen Ionenstrahl, einen Atomstrahl, einen Molekülstrahl oder einen hochenergetischen Photonenstrahl, beispielsweise Elektronen aus dem extrem ultravioletten (EUV) Wellenlängenbereich zur Bearbeitung der Probe 2725 einzusetzen (in der Fig. 27 nicht dargestellt).

Das Rasterteilchenmikroskop 2710 setzt sich aus einer Elektronenstrahlquelle 2705 und einer elektronenoptischen Säule 2720 zusammen, in der die Strahloptik 2713 etwa in Form einer Elektronenoptik des SEM 2710 angeordnet ist. In dem SEM 2710 der Fig. 27 erzeugt die Elektronenstrahlquelle 2705 einen Elektronenstrahl 2715, der von den in der Säule 2720 angeordneten Abbildungselementen, die in der Fig. 27 nicht dargestellt sind, als fokussierter Elektronenstrahl 2715 an der Stelle 2722 auf die Probe 2725, die beispielsweise die fotolithographische Maske 300, 890, 1000 umfassen kann, gerichtet wird. Damit bildet die Strahloptik 2713 das abbildende System 2713 der Elektronenstrahlquelle 2705 des SEM 2710.

Die Abbildungselemente der Säule 2720 des SEM 2710 können ferner den Elektronenstrahl 2715 über die Probe 2725 rastern oder scannen. Mit Hilfe des Elektronenstrahls 2715 des SEM 2710 kann die Probe 2725 untersucht werden, d.h. analysiert und prozessiert werden. In der elektronenoptischen Säule 2720 des SEM 2710 können eine Blende oder ein Blendensystem mit mehreren Blenden (in der Fig. 27 nicht dargestellt) vorzugsweise hinter einer Kondensorlinse des SEM 2710 eingebaut sein. Die Blende bzw. das Blendensystem können von einer Einstelleinheit 2790 des Computersystems 2780 der Vorrichtung 2700 eingestellt werden.

Die von dem Elektronenstrahl 2715 als primärer Partikel- bzw. Elektronenstrahl 2715 im Wechselwirkungsbereich der Probe 2725 erzeugten sekundären Partikel, nämlich die rückgestreuten Elektronen (BSE) und die sekundären Elektronen (SE), werden von einer Kombination aus zwei Detektoren 2717 und 2719 registriert. In der beispielhaften Konfiguration der Fig. 27 werden beide Detektoren 2717 und 2719 als "in lens detectors" bezeichnet. Da der Detektor 2717 in großer Nähe zur Probe 2725 ringförmig um den primären Partikelstrahl 2715 angebracht ist, sam- melt er sekundäre Partikel über einen großen Raumwinkelbereich. Letzterer ist symmetrisch um den Polarwinkel, der auf die Strahlachse des Elektronenstrahls 2715 bezogen ist. Zudem weist der Detektor 2717 nur eine Öffnung mit einem kleinen Durchmesser zum Durchtritt des primären Partikelstrahls 2715 auf und detektiert deshalb auch sekundäre Partikel, insbesondere BSE, die unter einem kleinen Winkel (Polarwinkel) bezogen auf die Strahlachse des primären Partikelstrahls 2715 von der Probe 2725 reflektiert werden.

Der Detektor 2719, der oberhalb des Detektors 2717 in der Säule 2720 eingebaut ist, bildet vorwiegend BSE ab, die unter einem sehr kleinen Winkel bezogen auf die Achse des primären Partikelstrahls 2715 bzw. des Elektronenstrahls 2715, d.h. unter einem sehr kleinen Polarwinkel, von der Probe 2725 emittiert werden. Die Raumwinkel, unter denen die beiden Detektoren 2717 und 2719 auf die Probe 2725 blicken, sind zumindest in Teilen unterschiedlich, da der Detektor 2717 den Detektor 2719 teilweise abschattet. In der in Fig. 27 wiedergegebenen beispielhaften Detektorkonfiguration unterscheiden sich die Raumwinkelanteile der beiden Detektoren 2717 und 2719 in deren Polarwinkeln. Beide Detektoren 2717 und 2719 können in verschiedenen Ausführungsformen und an verschiedenen Positionen in der Säule 2720 installiert werden. Beide Detektoren 2717 und 2719 setzen die von dem Elektronenstrahl 2715 an dem Messpunkt 2722 erzeugten SE und/oder die von der Probe 2725 rückgestreuten BSE in ein elektrisches Messsignal um und leiten dieses an eine Auswerteeinheit 2785 eines Computersystems 2780 der Vorrichtung 2700 weiter. Der Detektor 2719 kann einen Filter oder ein Filtersystem enthalten, um die SE und/oder BSE in der Energie zu diskriminieren (in der Fig. 27 nicht wiedergegeben). Die Detektoren 2717 und 2719 werden von einer Einstelleinheit 2790 der Vorrichtung 2700 gesteuert.

Ferner kann die beispielhafte Vorrichtung 2700 kann einen dritten Detektor 2721 beinhalten. Der dritte Detektor 2721 kann dafür ausgelegt sein, elektromagnetische Strahlung, insbesondere im Röntgenbereich, zu detektieren. Dadurch ermöglicht der Detektor 2721 das Analysieren einer Materialzusammensetzung 450, 460 der von der Probe 2725 erzeugten Strahlung während einer Untersuchung der Probe 2725. Der Detektor 2721 wird ebenfalls von der Einstelleinheit 2790 kontrolliert.

Ferner kann die Vorrichtung 2700 einen vierten Detektor umfassen (in der Fig. 27 nicht dargestellt). Der vierte Detektor ist häufig in Form eines Everhart-Thornley-Detektors ausgeführt und typischerweise außerhalb der Säule 2720 angeordnet. Er wird in der Regel zum Detektieren von SE eingesetzt.

Die Vorrichtung 2700 umfasst eine Flutkanone 2703 (flood gun). Diese kann Ionen mit niedriger kinetischer Energie im Bereich der Probe 2725 bereitstellen. Ferner kann die Flutkanone 2703 eingerichtet sein, Elektronen 2707 mit einstellbarer Landeenergie $E_o$ im zu bearbeitenden und/oder zu analysierenden Bereich der Probe 2725 bereitzustellen. Die Ionen mit geringer kinetischer Energie und/oder die Elektronen 2707 mit einstellbarer Landeenergie $E_o$ können eine elektrostatische Aufladung der Probe 2725 kompensieren.

Darüber hinaus kann die Vorrichtung 2700 ein Gitternetz oder ein Abschirmgitter am Ausgang der Säule 2720 des modifizierten SEM 2710 aufweisen (in der Fig.27 nicht gezeigt). Durch Anlegen einer elektrischen Spannung zwischen dem Gitternetz bzw. dem Abschirmgitter und einer im Bereich der Objektivlinse der Säule 2720 angebrachten Metallröhre (liner tube), die in der Fig. 27 ebenfalls unterdrückt ist, kann ein einstellbares Potential für die Elektronen 2707 des Elektronenstrahls 2715 erzeugt werden, sodass deren Landenergie $E_o$ um einen gewünschten Wert geändert werden kann. Zudem kann das Gitternetz ebenfalls zum Kompensieren einer elektrostatischen Aufladung einer Probe 2725 eingesetzt werden. Ferner ist es möglich, das Abschirmgitternetz zu erden.

Neben der Elektronenstrahlquelle 2705 kann die Vorrichtung 2700 eine zweite Strahlungsquelle umfassen (in der Fig. 27 nicht gezeigt). Die zweite Strahlungsquelle kann eine zweite Elektronenstrahlquelle oder eine Strahlungsquelle für eine andere Art von Partikeln sein, etwa für Ionen, Atome, Moleküle oder hochenergetische Photonen.

Die Probe 2725 wird zum Untersuchen auf einen Probentisch 2730 oder eine Probenhalterung 2730 angeordnet. Ein Probentisch 2730 ist im Fachgebiet auch unter dem Ausdruck "Stage" bekannt. Wie in der Fig. 27 durch die Pfeile symbolisiert, kann der Probentisch 2730, beispielsweise durch Mikromanipulatoren, die in der Fig. 27 nicht dargestellt sind, in drei Raumrichtungen relativ zu der Säule 2720 des SEM 2710 bewegt werden.

Neben den translatorischen Bewegungen kann der Probentisch 2730 zumindest um eine Achse gedreht werden, die parallel zur Strahlrichtung der Partikelstrahlquelle 2705 orientiert ist. Es ist ferner möglich, dass der Probentisch 2730 um eine oder zwei weitere Achsen drehbar ausgeführt ist, wobei diese Achse(n) in der Ebene des Probentisches 2730 angeordnet sind. Vorzugsweise bilden die zwei oder drei Drehachsen ein rechtwinkliges Koordinatensystem. Wie der Fig. 27 zu entnehmen ist, ist das Drehen des Probentisches 2730 um eine Drehachse, die in der Ebene des Probentisches 2730 angeordnet ist, aufgrund des geringen Abstandes des Säulenendes und der Probe 2725 häufig nur in eingeschränkten Umfang möglich.

Die zu untersuchende Probe 2725 kann jede beliebige mikrostrukturierte Komponente oder Bauteil sein, das einer Analyse, d.h. einer Probenabbildung, und ggf. einer anschließenden Prozessierung bedarf, beispielsweise die Reparatur eines lokalen Defekts einer lithographischen Maske 300, 890, 1000. So kann die Probe 2725 beispielsweise eine transmissive oder eine reflektive Fotomaske 300, 890, 1000 und/oder ein Template für die Nanoprägetechnik oder Nanoprägelithographie umfassen. Eine transmissive und die reflektive Fotomaske 300, 890, 1000 können alle Arten von Fotomasken umfassen, wie etwa binäre Masken, phasenschiebende Masken, OMOG-Masken, oder Masken für eine Doppel- oder Mehrfachbelichtung.

Die Vorrichtung 2700 der Fig. 27 kann ferner ein oder mehrere Rastersondenmikroskope, beispielsweise in Form eines Rasterkraftmikroskops (AFM, Atomic Force Microscope) aufweisen (in der Fig. 27 nicht gezeigt), das zum Analysieren und/oder Bearbeiten der Probe 2725 eingesetzt werden kann.

Das in der Fig. 27 beispielhaft dargestellte Rasterelektronenmikroskop 2710 wird in einer Vakuumkammer 2701 betrieben. Zum Erzeugen und Aufrechterhalten eines in der Vakuumkammer 2701 geforderten Unterdrucks weist das SEM 2710 der Fig. 27 ein Pumpensystem 2709 auf.

Ferner beinhaltet die Vorrichtung 2700 ein Computersystem 2780. Dieses umfasst eine Einstelleinheit 2790, die dafür eingerichtet ist, die Landenergie $E_o$ der Elektronen 2707 des Elektronenstrahls 2715 auf einen vorgegebenen Wert einzustellen. Dazu kann die Einstelleinheit 2790 die Beschleunigungsspannung der Elektronen 2707 des Elektronenstrahls 2715 sowie deren Bremsspannung einstellen. Ferner kann die Einstelleinheit 2790 das Potential des Energiefilters des Detektors 2719 einstellen.

Darüber hinaus kann das Computersystem 2780 eine Schnittstelle 2777 aufweisen, über die das Computersystem 2780 Informationen über die Probe 2725 empfängt, etwa deren Materialzusammensetzung und/oder deren Oberflächenkontur. Zudem kann das Computersystem 2780 Informationen über einen Defekt der Probe 2725 erhalten. Zudem kann das Computersystem 2780 über die Schnittstelle 2777 Abbildungen 720, 730 der Probe 2725 erhalten und/oder Abbildungen 720, 730 der Probe 2725 über die Schnittstelle 2777 versenden.

Das Computersystem 2780 kann auch eine Scan-Einheit 2782 umfassen, die den Elektronenstrahl 2715 über die Probe 2725 scannt. Ferner kann die Einstelleinheit 2790 eingerichtet sein, die verschiedenen Parameter des modifizierten Rasterteilchenmikroskops 2710 der Vorrichtung 2700 einzustellen. Darüber hinaus kann die Einstelleinheit 2790, die Mikromanipulatoren und ein Drehen des Probentisches 2730 steuern.

Überdies kann die Auswerteeinheit 2785 des Computersystems 2780 die Messsignale der Detektoren 2717 und 2719 analysieren und daraus ein Bild oder eine Abbildung 720, 730 der Probe 2725 erzeugen, das von einem Display 2795 angezeigt werden kann. Insbesondere kann die Auswerteeinheit 2785 dafür ausgelegt sein, aus den Messdaten der Detektoren 2717 und 2719 die Lage und eine Kontur eines Defekts fehlenden Materials und/oder einen Defekt überschüssigen Materials einer Probe 2725, etwa der lithographischen Maske 300, 890, 1000 zu bestimmen.

Ferner kann das Computersystem 2780 dafür eingerichtet sein, ein Entkopplungsmodell 700 auf die von den Detektoren 2717 und 2719 erzeugten Abbildungen 720, 730 anzuwenden, um deren Topographiekontrast- und Materialkontrastbeiträge zu bestimmen. Hierfür kann das Computersystem 2780 einen oder mehrere Algorithmen enthalten, die es ermöglichen, aus zwei Abbildungen 720, 730 der Probe 2725 die Parameter eines empirischen Modells zu ermitteln. Die Algorithmen des Computersystems 2780 können in Hardware, Software oder einer Kombination hiervon implementiert werden. Insbesondere kann der oder die Algorithmen in Form eines ASIC (Application Specific Integrated Circuits), eines PLD (Programmable Logic Device und/oder eines FPGA (Field Programmable Gate Array) realisiert werden.

Das Computersystem 2780 und/oder die Auswerteeinheit 2785 können einen Speicher, vorzugsweise einen nicht-flüchtigen Speicher beinhalten (in der Fig. 27 nicht dargestellt), der ein Transformationsmodell und/oder ein Modell maschinellen Lernens 1500, 2300, 2400, 2500 in generischer und/oder in trainierter Form speichern. Ferner kann der nicht-flüchtige Speicher des Computersystems 2780 einen Trainingsdatensatz für ein Transformationsmodell und/oder ein ML-Modell 2300, 2400, 2500 speichern. Die Auswerteeinheit 2785 kann dafür ausgelegt werden, aus den Abbildungen 720, 730 der Probe 2725 den Topographiekontrastanteil und/oder den Materialkontrastanteil der Abbildungen 720, 730 zu bestimmen. Ferner kann das Computersystem 2780 eine Schnittstelle 2777 zum Austauschen von Daten mit dem Internet, einem Intranet und/oder einer anderen Vorrichtung aufweisen. Die Schnittstelle 2777 kann eine drahtlose oder eine drahtgebundene Schnittstelle umfassen. Die Auswerteeinheit 2785 kann der Einstelleinheit 2790 Daten bereitstellen, die es der Einstelleinheit 2790 ermöglichen, einen lokalen chemischen Reparaturprozess der Probe 2725 zu stoppen.

Die Auswerteeinheit 2785 und/oder die Einstelleinheit 2790 können, wie in der Fig. 27 angegeben, in das Computersystem 2780 integriert sein. Es ist aber auch möglich, die Auswerteeinheit 2785 und/oder die Einstelleinheit 2790 als eigenständige Einheit(en) innerhalb oder außerhalb der Vorrichtung 2700 auszuführen. Insbesondere können die Auswerteeinheit 2785 und/oder die Einstelleinheit 2790 dafür ausgelegt werden, einen Teil ihrer Aufgaben mittels einer dedizierten Hardware-Implementierung auszuführen.

Ferner kann das Computersystem 2780 in die Vorrichtung 2700 integriert sein oder kann als ein eigenständiges Gerät ausgebildet sein (in der Fig. 27 nicht gezeigt). Das Computersystem 2780 kann in Hardware, Software, Firmware oder einer Kombination ausgeführt werden.

Im Folgenden wird auf das Gasbereitstellungssystem 2770 eingegangen, das die Vorrichtung 2700 realisiert. Wie bereits oben ausgeführt, ist die Probe 2725 auf einem Probentisch 2730 angeordnet. Die Abbildungselemente 2713 der Säule 2720 des SEM 2710 können den Elektronenstrahl 2715 fokussieren und über die Probe 2725 rastern oder scannen. Mit dem Elektronenstrahl 2715 des SEM 2710 kann ein Partikelstrahl-induzierter Abscheideprozess (EBID, Electron Beam Induced Deposition) und/oder ein Partikelstrahl-induzierter Ätzprozess (EBIE, Electron Beam Induced Etching) induziert werden. Zum Ausführen dieser Prozesse weist die beispielhafte Vorrichtung 2700 der Fig. 27 drei verschiedene Vorratsbehälter 2740, 2750 und 2760 zum Speichern verschiedener Präkursor-Gase auf.

Der erste Vorratsbehälter 2740 speichert ein Präkursor-Gas, beispielsweise ein Metallcarbonyl, wie etwa Chromhexacarbonyl ($Cr(CO)_6$) oder Molybdänhexacarbonyl ($Mo(CO)_6$). Mit Hilfe des im ersten Vorratsbehälter 2740 gespeicherten Präkursor-Gases kann in einer lokalen chemischen Abscheidereaktion beispielsweise fehlendes Material der lithographischen Maske 300, 890, 1000 auf diese abgeschieden werden. Ferner kann mit dem im ersten Vorratsbehälter 2740 gespeicherten Präkursor-Gas eine Schutzschicht oder eine Opferschicht auf die Maske 300, 890, 1000 deponiert werden. Zudem können mit dem im ersten Vorratsbehälter 2740 gespeicherten Präkursor-Gas Drift-Markierungen auf die Maske 300, 890, 1000 oder die Opferschicht abgeschieden werden.

Der Elektronenstrahl 2715 des SEM 2710 fungiert als Energielieferant, um das im ersten Vorratsbehälter 2740 bevorratete Präkursor-Gas an der Stelle zu spalten, an der Material auf der Probe 2725 abgeschieden werden soll. Dies bedeutet, durch das kombinierte Bereitstellen eines Elektronenstrahls 2715 und eines Präkursor-Gases wird ein EBID-Prozess zum lokalen Abscheiden fehlenden Materials, beispielsweise fehlenden Materials der Maske 300, 890, 1000 ausgeführt.

Ein Elektronenstrahl 2715 kann auf einen Fleckdurchmesser im Bereich einiger Nanometer fokussiert werden. Der Wechselwirkungsbereich oder die Streubirne, in der ein Elektronenstrahl 2715 SE erzeugt, hängt zum einen von der Energie des Elektronenstrahls 2715 und zum anderen von der Materialzusammensetzung ab, auf die der Elektronenstrahl 2715 trifft. Die Durchmesser von Wechselwirkungsbereichen reichen in den niedrigen einstelligen Nanometerbereich. Damit limitiert der Durchmesser einer Streubirne eines Elektronenstrahls 2715 die erreichbare Auflösungsgrenze beim Ausführen einer lokalen Partikelstrahl-induzierten Reaktion. Diese Auflösungsgrenze liegt derzeit im einstelligen Nanometerbereich.

In der in der Fig. 27 dargestellten Vorrichtung 2700 speichert der zweite Vorratsbehälter 2750 ein Ätzgas, das das Ausführen eines lokalen Elektronenstrahl-induzierten Ätzprozesses (EBIE) möglich macht. Mit Hilfe eines Elektronenstrahl-induzierten Ätzprozesses kann überschüssiges Material von der Probe 2725, etwa das überschüssige Material der Eindellung 1940 des rechten Streifens 1920 und/oder des Kontaktloches 2130, entfernt werden. Ein Ätzgas kann beispielsweise Xenondifluorid ($XeF_2$), ein Halogen oder Nitrosylchlorid (NOCl) umfassen.

In dem dritten Vorratsbehälter 2760 kann ein additives oder ein zusätzliches Gas gespeichert werden, das dem im zweiten Vorratsbehälter 2750 bereitgehaltenen Ätzgas oder dem im ersten Vorratsbehälter 2740 gespeicherten Präkursor-Gas bei Bedarf hinzugegeben werden kann. Alternativ kann der dritte Vorratsbehälter 2760 ein zweites Präkursor-Gas oder ein zweites Ätzgas speichern.

Jeder der Vorratsbehälter 2740, 2750 und 2760 des Gasbereitstellungssystems 2770 hat in der in der Fig. 27 dargestellten Vorrichtung 2700 sein eigenes Steuerventil 2742, 2752 und 2762, um den pro Zeiteinheit bereitgestellten Betrag des entsprechenden Gases, d.h. den Gasmengenstrom an der Stelle 2722 des Auftreffens des Elektronenstrahls 2715 auf die Probe 2725 zu kontrollieren bzw. zu steuern. Die Steuerventile 2742, 2752 und 2762 können durch die Einstelleinheit 2790 des Computersystems 2780 gesteuert bzw. kontrolliert werden. Damit lassen sich die Partialdruckverhältnisse des bzw. der am Bearbeitungsort zum Ausführen eines EBID- und/oder eines EBIE-Prozesses bereitgestellten Gase in einem weiten Bereich einstellen.

Ferner hat in der beispielhaften Vorrichtung 2700 der Fig. 27 jeder Vorratsbehälter 2740, 2750 und 2760 sein eigenes Gaszuleitungssystem 2745, 2755 und 2765, das mit einer Düse 2747, 2757 und 2767 in der Nähe des Auftreffpunkts 2722 des Elektronenstrahls 2715 auf die Probe 2725 endet.

Die Vorratsbehälter 2740, 2750 und 2760 können ihr eigenes Temperatureinstellelement und/oder Kontrollelement haben, das sowohl ein Kühlen wie auch ein Heizen der entsprechenden Vorratsbehälter 2740, 2750 und 2760 erlaubt. Dies ermöglicht das Speichern und insbesondere das Bereitstellen des Präkursor-Gases bei der jeweils optimalen Temperatur (in der Fig. 27 nicht gezeigt). Die Einstelleinheit 2790 kann die Temperatureinstellelemente und die Temperaturkontrollelemente der Vorratsbehälter 2740, 2750, 2760 steuern. Während der EBID- und der EBIE-Bearbeitungsvorgänge können die Temperatureinstellelemente der Vorratsbehälter 2740, 2750 und 2760 ferner eingesetzt werden, um durch die Wahl einer entsprechenden Temperatur den Dampfdruck der darin gespeicherten Präkursor-Gase einzustellen.

Die Vorrichtung 2700 kann mehr als einen Vorratsbehälter 2740 umfassen, um zwei oder mehr Präkursor-Gase zu bevorraten. Ferner kann die Vorrichtung 2700 mehr als einen Vorratsbehälter 2750 zum Speichern von zwei oder mehr Ätzgasen aufweisen (in der Fig. 27 nicht gezeigt).

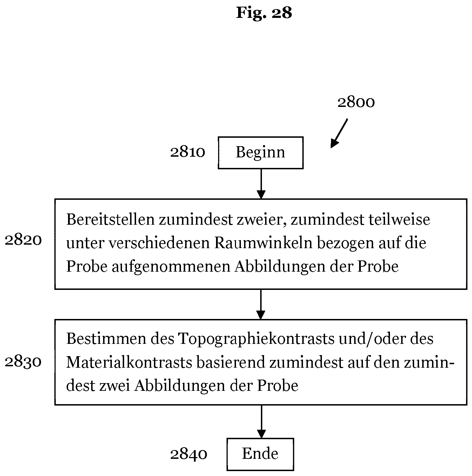

Schließlich repräsentiert das Flussdiagramm 2800 der Fig. 28 wesentliche Schritte eines Verfahrens zum Bestimmen eines Topographiekontrastanteils und/oder eines Materialkontrastanteils einer Abbildung 720, 730 einer Probe 890, 1000, 2725. Das Verfahren beginnt bei Schritt 2810.

Bei Schritt 2820 werden zumindest zwei zumindest teilweise unter verschiedenen Raumwinkeln bezogen auf die Probe aufgenommene Abbildungen 720, 730 der Probe 890, 1000, 2725 bereitgestellt. Das Bereitstellen kann ein Laden der zumindest zwei Abbildungen 720, 730 aus einem nichtflüchtigen Speicher, ein Übertragen über ein Netzwerk und/oder ein Aufnehmen der zumindest zwei Abbildungen 720, 730 beispielsweise mit den Detektoren 2717 und 2719 umfassen.

Bei Schritt 2830 wird der Topographiekontrast und/oder der Materialkontrast der Probe zumindest teilweise basierend auf den zumindest zwei Abbildungen 720, 730 der Probe 890, 1000, 2725 bestimmt. Hierfür kann ein Entkopplungsmodell 700 eingesetzt werden. Ein Entkopplungsmodell 700 kann ein parametrisiertes empirisches Modell und/oder ein trainiertes Transformationsmodell, etwa ein Deep Learning Modell 1500, 2300, 2400, 2500 umfassen, das auf die zumindest zwei Abbildungen 720, 730 der Probe 890, 1000, 2725 angewendet wird, Ein Computersystem 2780, das für diesen Einsatzzweck eingerichtet ist, beispielsweise durch eine spezifische Graphikprozessoreinheit und/oder eine der oben angegebenen Hardware-Komponenten, kann das Entkopplungsmodell 700 ausführen durch Anwenden auf die zumindest zwei Abbildungen 720 und 730.

Das Verfahren endet bei Schritt 2840.

Nachfolgend werden weitere bevorzugte Ausführungsbeispiele aufgeführt:

1. Verfahren (2800) zum Bestimmen eines Topographiekontrasts (585) und/oder eines Materialkontrasts (550, 560) einer Probe (300, 890, 1000), aufweisend:

   a. Bereitstellen (2820) zumindest zweier, zumindest teilweise unter verschiedenen Raumwinkeln bezogen auf die Probe (300, 890. 1000) aufgenommenen Abbildungen (720, 730) der Probe (300, 890, 1000); und

   b. Bestimmen (2830) des Topographiekontrasts (585) und/oder des Materialkontrasts (550, 560) der Probe (300, 890, 1000) zumindest teilweise basierend auf den zumindest zwei Abbildungen (720, 730) der Probe (300, 890, 1000).

2. Verfahren (2800) nach Beispiel 1, wobei das Bestimmen umfasst: Anwenden eines Entkopplungsmodells (700) auf die zumindest zwei Abbildungen (720, 730).

3. Verfahren (2800) nach dem vorhergehenden Beispiel, wobei das Entkopplungsmodell (700) zumindest ein Element aus der Gruppe umfasst: ein empirisches Modell und ein Transformationsmodell (1500, 2300, 2400, 2500).

4. Verfahren (2800) nach dem vorhergehenden Beispiel, ferner den Schritt aufweisend:
Anpassen des empirischen Modells an die Probe (300, 890, 1000).

5. Verfahren (2800) nach dem vorhergehenden Beispiel, ferner aufweisend: Bestimmen der Parameter des empirischen Modells.

6. Verfahren (2800) nach dem vorhergehenden Beispiel, wobei das Bestimmen der Parameter des empirischen Modells zumindest ein Element aus der Gruppe umfasst: Aufnehmen von zumindest zwei Abbildungen (720, 730) zumindest einer kalibrierten Teststruktur unter zumindest teilweise verschiedenen Raumwinkeln, Simulieren von zumindest zwei Abbildungen (720, 730) der zumindest einen kalibrierten Teststruktur unter zumindest teilweise verschiedenen Raumwinkeln, und Aufnehmen von zumindest zwei Abbildungen (720, 730) der zumindest einen kalibrierten Teststruktur unter zumindest teilweise verschiedenen Raumwinkeln, wobei zumindest ein Detektor (870, 2719) ein aktiviertes Abschirmgitter aufweist.

7. Verfahren (2800) nach Beispiel 3, wobei das Transformationsmodell (1500, 2300, 2400, 2500) zumindest ein Transformationsmodell mit zumindest zwei Transformationsblöcken, die zumindest jeweils eine generisch lernbare Funktion umfassen, vorzugsweise ein Modell maschinellen Lernens und/oder ein generatives Modell (1500, 2300, 2400, 2500).

8. Verfahren (2800) nach Beispiel 3 oder 7, wobei das Transformationsmodell (1500, 2300, 2,400, 2500) ein Modell maschinellen Lernens umfasst (2300, 2400, 2500), insbesondere ein Deep Learning Modell (1500).

9. Verfahren (2800) nach Beispiel 7 oder 8, wobei das Modell maschinellen Lernens (2300, 2400, 2500) zumindest einen zusätzlichen Parameter (2350) umfasst, der dem Modell maschinellen Lernens (2300, 2400, 2500) an dessen Eingang (1540, 2310) bereitgestellt wird.

10. Verfahren (2800) nach dem vorhergehenden Beispiel, wobei der zumindest eine zusätzliche Parameter (2350) einen Systemparameter einer Reparaturvorrichtung (2700) umfasst.

11. Verfahren (2800) nach einem der Beispiele 7-10, wobei das Modell maschinellen Lernens (2300, 2400, 2500) einen Hyperparameter (2360) umfasst, der die Probe (300, 890, 1000) charakterisiert.

12. Verfahren (2800) nach einem der Beispiele 3 oder 7-11, ferner den Schritt aufweisend:
Trainieren des Transformationsmodells (1500, 2300, 2300, 2500) mit einem Trainingsdatensatz.

13. Verfahren (2800) nach dem vorhergehenden Beispiel, wobei der Trainingsdatensatz für das Transformationsmodell (1500, 2300, 2400, 2500) zumindest ein Element aus der Gruppe umfasst: eine Vielzahl von Tupeln zumindest zweier aufgenommener Abbildungen (720, 730) zumindest einer zum Training verwendeten Probe (300, 890, 1000), eine Vielzahl von Tupeln zumindest zweier aufgenommener Abbildungen (720, 730) zumindest einer zum Training verwendeten Teststruktur, eine Vielzahl von Tupeln zumindest zweier simulierter Abbildungen (720, 730) zumindest einer zum Training verwendeten Probe (300, 890, 1000), eine Vielzahl von Tupeln zumindest zweier aufgenommener Abbildungen (720, 730) zumindest einer zum Training verwendeten Teststruktur, wobei die Tupel jeweils zumindest zwei Abbildungen (720, 730) aufweisen, die unter zumindest teilweise verschiedenen Raumwinkeln bezogen auf die zum Training verwendete zumindest eine Probe (300, 890, 1000) und/oder Teststruktur aufgenommen bzw. simuliert wurden.

14. Verfahren (2800) nach Beispiel 12 oder 13, ferner den Schritt aufweisend: Aufnehmen des Trainingsdatensatzes für das Transformationsmodell (1500, 2300, 2400, 2500).

15. Verfahren (2800) nach einem der vorhergehenden Beispiele, wobei das Bestimmen des Topographiekontrasts (585) und/oder des Materialkontrasts (550, 560) umfasst: Bestimmen einer Abbildung (510), die im Wesentlichen keinen Topographiekontrastanteil aufweist.

16. Computerprogramm mit Anweisungen zum Durchführen der Verfahrensschritte eines der Beispiele 1 bis 15, wenn das Computerprogramm ausgeführt wird.

17. Vorrichtung (800, 2700) zum Bestimmen eines Topographiekontrasts (585) und/oder eines Materialkontrasts (550, 560) einer Probe (300, 890, 1000), aufweisend:

    a. Mittel zum Bereitstellen (850, 870, 2717, 2719) zumindest zweier, zumindest teilweise unter verschiedenen Raumwinkeln bezogen auf die Probe (300, 890, 1000) aufgenommenen Abbildungen (720, 730) der Probe (300, 890, 1000); und

    b. Mittel zum Bestimmen (2780) des Topographiekontrasts (585) und/oder des Materialkontrasts (550, 560) der Probe (300, 890, 1000) zumindest teilweise basierend auf den zumindest zwei Abbildungen (720, 730) der Probe (300, 890, 1000).

18. Vorrichtung (800, 2700) nach Beispiel 17, wobei das Mittel zum Bestimmen (2780) eingerichtet ist zum Anwenden eines Entkopplungsmodells (700) auf die zumindest zwei Abbildungen (720, 730) zum Bestimmen des Topographiekontrasts (585) und/oder des Materialkontrasts (550, 560) der Probe (300, 890, 1000).

19. Vorrichtung (800, 2700) nach Beispiel 17 oder 18, wobei die Vorrichtung (800, 2700) zumindest einen ersten Detektor (850, 2717) und zumindest einen zweiten Detektor (870, 2719) zum Bereitstellen der zumindest zwei Abbildungen (720, 730) der Probe (300, 890, 1000) aufweist, wobei der zumindest eine erste (850, 2717) und der zumindest eine zweite Detektor (870, 2719) vorzugsweise jeweils sekundäre (SE) und rückgestreute Elektronen (BSE) detektieren und wobei ein SE/BSE Verhältnis des zumindest einen ersten Detektors (850, 2717) und das SE/BSE Verhältnis des zumindest einen zweiten Detektors (850, 2719) vorzugsweise voneinander verschieden sind.

20. Vorrichtung (800, 2700) nach dem vorhergehenden Beispiel, wobei der erste Detektor (850, 2717) in einer elektronenoptischen Säule der Vorrichtung (800, 2700) angeordnet ist, und/oder wobei der zweite Detektor (870, 2719) in der elektronenoptischen Säule der Vorrichtung (800, 1700) angeordnet ist.

**Patentansprüche**

1. Verfahren (2800) zum Bestimmen eines Topographiekontrasts (585) und/oder eines Materialkontrasts (550, 560) einer Probe (300, 890, 1000), aufweisend:

a. Bereitstellen (2820) zumindest zweier, zumindest teilweise unter verschiedenen Raumwinkeln bezogen auf die Probe (300, 890. 1000) aufgenommenen Abbildungen (720, 730) der Probe (300, 890, 1000); und

b. Bestimmen (2830) des Topographiekontrasts (585) und/oder des Materialkontrasts (550, 560) der Probe (300, 890, 1000) zumindest teilweise basierend auf den zumindest zwei Abbildungen (720, 730) der Probe (300, 890, 1000).

2. Verfahren (2800) nach Anspruch 1, wobei das Bestimmen umfasst: Anwenden eines Entkopplungsmodells (700) auf die zumindest zwei Abbildungen (720, 730).

3. Verfahren (2800) nach dem vorhergehenden Anspruch, wobei das Entkopplungsmodell (700) zumindest ein Element aus der Gruppe umfasst: ein empirisches Modell und ein Transformationsmodell (1500, 2300, 2400, 2500).

4. Verfahren (2800) nach dem vorhergehenden Anspruch, ferner die Schritte aufweisend:
Anpassen des empirischen Modells an die Probe (300, 890, 1000); und/oder Bestimmen der Parameter des empirischen Modells.

5. Verfahren (2800) nach dem vorhergehenden Anspruch, wobei das Bestimmen der Parameter des empirischen Modells zumindest ein Element aus der Gruppe umfasst: Aufnehmen von zumindest zwei Abbildungen (720, 730) zumindest einer kalibrierten Teststruktur unter zumindest teilweise verschiedenen Raumwinkeln, Simulieren von zumindest zwei Abbildungen (720, 730) der zumindest einen kalibrierten Teststruktur unter zumindest teilweise verschiedenen Raumwinkeln, und Aufnehmen von zumindest zwei Abbildungen (720, 730) der zumindest einen kalibrierten Teststruktur unter zumindest teilweise verschiedenen Raumwinkeln, wobei zumindest ein Detektor (870, 2719) ein aktiviertes Abschirmgitter aufweist.

6. Verfahren (2800) nach Anspruch 3, wobei das Transformationsmodell (1500, 2300, 2400, 2500) aufweist:

zumindest ein Transformationsmodell mit zumindest zwei Transformationsblöcken, die zumindest jeweils eine generisch lernbare Funktion umfassen, vorzugsweise ein Modell maschinellen Lernens und/oder ein generatives Modell (1500, 2300, 2400, 2500);
und/oder
ein Modell maschinellen Lernens, insbesondere ein Deep Learning Modell (1500).

7. Verfahren (2800) nach dem vorhergehenden Anspruch, wobei das Modell maschinellen Lernens (2300, 2400, 2500) zumindest einen zusätzlichen Parameter (2350) umfasst, der dem Modell maschinellen Lernens (2300, 2400, 2500) an dessen Eingang (1540, 2310) bereitgestellt wird, wobei der zumindest eine zusätzliche Parameter (2350) vorzugsweise einen Systemparameter einer Reparaturvorrichtung (2700) umfasst.

8. Verfahren (2800) nach einem der Ansprüche 6 oder 7, wobei das Modell maschinellen Lernens (2300, 2400, 2500) einen Hyperparameter (2360) umfasst, der die Probe (300, 890, 1000) charakterisiert.

9. Verfahren (2800) nach einem der Ansprüche 3 oder 6-8, ferner aufweisend: Trainieren des Transformationsmodells (1500, 2300, 2300, 2500) mit einem Trainingsdatensatz, wobei der Trainingsdatensatz für das Transformationsmodell (1500, 2300, 2400, 2500) zumindest ein Element aus der Gruppe umfasst: eine Vielzahl von Tupeln zumindest zweier aufgenommener Abbildungen (720, 730) zumindest einer zum Training verwendeten Probe (300, 890, 1000), eine Vielzahl von Tupeln zumindest zweier aufgenommener Abbildungen (720, 730) zumindest einer zum Training verwendeten Teststruktur, eine Vielzahl von Tupeln zumindest zweier simulierter Abbildungen (720, 730) zumindest einer zum Training verwendeten Probe (300, 890, 1000), eine Vielzahl von Tupeln zumindest zweier aufgenommener Abbildungen (720, 730) zumindest einer zum Training verwendeten Teststruktur, wobei die Tupel jeweils zumindest zwei Abbildungen (720, 730) aufweisen, die unter zumindest teilweise verschiedenen Raumwinkeln bezogen auf die zum Training verwendete zumindest eine Probe (300, 890, 1000) und/oder Teststruktur aufgenommen bzw. simuliert wurden; und
vorzugsweise Aufnehmen des Trainingsdatensatzes für das Transformationsmodell (1500, 2300, 2400, 2500).

10. Verfahren (2800) nach einem der vorhergehenden Ansprüche, wobei das Bestimmen des Topographiekontrasts (585) und/oder des Materialkontrasts (550, 560) umfasst: Bestimmen einer Abbildung (510), die im Wesentlichen keinen Topographiekontrastanteil aufweist.

11. Computerprogramm mit Anweisungen zum Durchführen der Verfahrensschritte eines der Ansprüche 1 bis 10, wenn das Computerprogramm ausgeführt wird.

12. Vorrichtung (800, 2700) zum Bestimmen eines Topographiekontrasts (585) und/oder eines Materialkontrasts (550, 560) einer Probe (300, 890, 1000), aufweisend:

   a. Mittel zum Bereitstellen (850, 870, 2717, 2719) zumindest zweier, zumindest teilweise unter verschiedenen Raumwinkeln bezogen auf die Probe (300, 890, 1000) aufgenommenen Abbildungen (720, 730) der Probe (300, 890, 1000); und
   b. Mittel zum Bestimmen (2780) des Topographiekontrasts (585) und/oder des Materialkontrasts (550, 560) der Probe (300, 890, 1000) zumindest teilweise basierend auf den zumindest zwei Abbildungen (720, 730) der Probe (300, 890, 1000).

13. Vorrichtung (800, 2700) nach Anspruch 12, wobei das Mittel zum Bestimmen (2780) eingerichtet ist zum Anwenden eines Entkopplungsmodells (700) auf die zumindest zwei Abbildungen (720, 730) zum Bestimmen des Topographiekontrasts (585) und/oder des Materialkontrasts (550, 560) der Probe (300, 890, 1000).

14. Vorrichtung (800, 2700) nach Anspruch 12 oder 13, wobei die Vorrichtung (800, 2700) zumindest einen ersten Detektor (850, 2717) und zumindest einen zweiten Detektor (870, 2719) zum Bereitstellen der zumindest zwei Abbildungen (720, 730) der Probe (300, 890, 1000) aufweist, wobei der zumindest eine erste (850, 2717) und der zumindest eine zweite Detektor (870, 2719) vorzugsweise jeweils sekundäre (SE) und rückgestreute Elektronen (BSE) detektieren und wobei ein SE/BSE Verhältnis des zumindest einen ersten Detektors (850, 2717) und das SE/BSE Verhältnis des zumindest einen zweiten Detektors (850, 2719) vorzugsweise voneinander verschieden sind.

15. Vorrichtung (800, 2700) nach dem vorhergehenden Anspruch, wobei der erste Detektor (850, 2717) in einer elektronenoptischen Säule der Vorrichtung (800, 2700) angeordnet ist, und/oder wobei der zweite Detektor (870, 2719) in der elektronenoptischen Säule der Vorrichtung (800, 1700) angeordnet ist.

Fig. 1 (Stand der Technik)

**Fig.2 (Stand der Technik)**

## Fig. 3

## Fig. 4

**EP 4 600 637 A1**

**Fig. 5**

Materialkontrastanteil

Topographiekontrastanteil

42

**Fig. 6**

Fig. 7

Fig. 8

**Fig. 9**

995

930

910

920

850

870

870

960

950

860

880

990

**Fig. 10**

1020 1030 1005

1000 1095

1010

1050

1070 1055

Signal

1075

1080

1

0

1085

1035

Position

**Fig. 11**

**Fig. 12**

**Fig. 13**

1300

Beginn | 1310

Bestimmen der Intensitäten $I_k$ einer kalibrierten Testprobe, die von zumindest zwei Detektoren unter zumindest teilweise verschiedenen Raumwinkeln aufgenommen werden, wobei die Materialkontrast-Information $M(i,j)$ und/oder die Topographiekontrast-Information $T(i,j)$ der kalibrierten Testprobe bekannt ist | 1320

Bestimmen einer rekonstruierten Materialkontrast- $S_R(i,j)$ und/oder einer rekonstruierten Topographiekontrast-Signalfunktion $H_R(i,j)$ mittels der aufgestellten Materialkontrast- $S(i,j)$ und/oder Topographiekontrast-Signalfunktion T$(i,j)$ der kalibrierten Testprobe | 1330

Reduzieren der absoluten Differenz zwischen der rekonstruierten Materialkontrast-Signalfunktion $S_R(i,j)$ und der bekannten Materialkontrast-Information $M(i,j)$ durch Variieren der Parameter der Materialkontrast-Signalfunktion $S_R(i,j)$ und/oder zwischen der rekonstruierten Topographiekontrast-Signalfunktion $H_R(i,j)$ und der bekannten Topographiekontrast-Information $T(i,j)$ durch Variieren der Parameter der Topographiekontrast-Signalfunktion $H_R(i,j)$ | 1340

1350

Nein

Differenz < Schwelle?

Ja

Materialkontrast-Signalfunktion $S_R(i,j)$ und/oder Topographiekontrast-Signalfunktion $H_R(i,j)$ für Probentyp rekonstruiert bzw. optimiert | 1360

Ende | 1370

**Fig. 14 (Stand der Technik)**

**Fig. 15**

**Fig. 16**

**Fig. 17**

EP 4 600 637 A1

Fig. 18

Fig. 19

50

Fig. 20

2005

2030

2050

2095

2010

r

2010

M1    M2

h

w

2020

r

2020

M1    M2

h

w

y

x

Fig. 21

2105

2130

2110

2140

2195

2150

d

a

b

c

2150

2120

M1    M2

y

x

d

a

b

c

2160

M1    M2

y

x

Fig. 22

| Parameter | Min | Max |
|---|---|---|
| Θ [°] | 30 | 120 |
| h1 [nm] | 1 | 70 |
| w1 [nm] | 1 | 10 |
| r [nm] | 1 | 5 |
| h [nm] | 20 | 100 |
| w [nm] | 20 | 100 |
| a [nm] | 10 | 40 |
| b [nm] | 10 | 40 |
| c [nm] | 1 | 20 |
| d [nm] | 5 | d<h-a-5 |

**Fig. 23**

2350, 2360

720

730

2395

2310

2300

2320

2370

**Fig. 24**

2350, 2360

720

730

2495

2310

2400

2420

2470

2480

**Fig. 25**

**Fig. 26**

**Fig. 27**

**Fig. 28**

2800

2810 | Beginn

Bereitstellen zumindest zweier, zumindest teilweise
2820 unter verschiedenen Raumwinkeln bezogen auf die
Probe aufgenommenen Abbildungen der Probe

Bestimmen des Topographiekontrasts und/oder des
2830 Materialkontrasts basierend zumindest auf den zumindest zwei Abbildungen der Probe

2840 | Ende

EUROPÄISCHER RECHERCHENBERICHT

Nummer der Anmeldung

EP 25 15 6589

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | NIEMIETZ A ET AL: "Digital image processing of multiple detector signals in scanning electron microscopy", ULTRAMICROSCOPY, ELSEVIER, AMSTERDAM, NL, Bd. 16, Nr. 2, Januar 1985 (1985-01), Seiten 161-173, XP024502890, ISSN: 0304-3991, DOI: 10.1016/0304-3991(85)90071-3 [gefunden am 1985-01-01] * das ganze Dokument * | 1-3,5-15 | INV. G01N23/2206 G03F1/68 G03F1/72 G03F1/74 G03F1/86 G06N20/00 H01J37/28 ADD. G01B15/04 H01L21/66 |
| A | US 2022/415024 A1 (TOYODA YASUTAKA [JP] ET AL) 29. Dezember 2022 (2022-12-29) * Absätze [0074], [0096], [0097] * | 6-9 | |
| A | WO 2023/072919 A2 (ZEISS CARL SMT GMBH [DE]) 4. Mai 2023 (2023-05-04) * Schritt S2; Seite 25 * | 1-15 | |

RECHERCHIERTE SACHGEBIETE (IPC)

G01N
G01B
H01L

Der vorliegende Recherchenbericht wurde für alle Patentansprüche erstellt

| Recherchenort | Abschlußdatum der Recherche | Prüfer |
|---|---|---|
| Den Haag | 17. Juni 2025 | Steinmetz, Johannes |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                EP 25 15 6589

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-06-2025

| Im Recherchenbericht angeführtes Patentdokument | Datum der Veröffentlichung | Mitglied(er) der Patentfamilie | | Datum der Veröffentlichung |
|---|---|---|---|---|
| US 2022415024 A1 | 29-12-2022 | CN | 114761990 A | 15-07-2022 |
| | | EP | 4089624 A1 | 16-11-2022 |
| | | JP | 7398480 B2 | 14-12-2023 |
| | | JP | 7527461 B2 | 02-08-2024 |
| | | JP | 7660753 B2 | 11-04-2025 |
| | | JP | 2024026256 A | 28-02-2024 |
| | | JP | 2024150622 A | 23-10-2024 |
| | | JP | WO2021140620 A1 | 15-07-2021 |
| | | KR | 20220088923 A | 28-06-2022 |
| | | TW | 202127374 A | 16-07-2021 |
| | | TW | 202324298 A | 16-06-2023 |
| | | US | 2022415024 A1 | 29-12-2022 |
| | | WO | 2021140620 A1 | 15-07-2021 |
| WO 2023072919 A2 | 04-05-2023 | CN | 118176560 A | 11-06-2024 |
| | | EP | 4423791 A2 | 04-09-2024 |
| | | JP | 2024541956 A | 13-11-2024 |
| | | KR | 20240069803 A | 20-05-2024 |
| | | TW | 202335022 A | 01-09-2023 |
| | | TW | 202439366 A | 01-10-2024 |
| | | US | 2024272099 A1 | 15-08-2024 |
| | | WO | 2023072919 A2 | 04-05-2023 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102024103589